(19) Europäisches Patentamt
European Patent Office
Office européen des brevets

(11) EP 3 162 556 A1

(12) **EUROPEAN PATENT APPLICATION**
published in accordance with Art. 153(4) EPC

(43) Date of publication:
**03.05.2017 Bulletin 2017/18**

(21) Application number: **15811967.7**

(22) Date of filing: **28.05.2015**

(51) Int Cl.:
***B32B 7/02*** *(2006.01)* ***B05D 5/06*** *(2006.01)*
***B05D 7/24*** *(2006.01)* ***G02B 5/20*** *(2006.01)*
***G02B 5/22*** *(2006.01)* ***G02B 5/28*** *(2006.01)*
***H01L 51/50*** *(2006.01)* ***H05B 33/12*** *(2006.01)*

(86) International application number:
**PCT/JP2015/065364**

(87) International publication number:
**WO 2015/198784 (30.12.2015 Gazette 2015/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **25.06.2014 JP 2014130805**
**19.02.2015 JP 2015030291**

(71) Applicant: **Fujifilm Corporation**
**Minato-ku**
**Tokyo 106-8620 (JP)**

(72) Inventors:
- **TAKISHITA Hirotaka**
  **Haibara-gun**
  **Shizuoka 421-0396 (JP)**
- **YAMAMOTO Keiji**
  **Haibara-gun**
  **Shizuoka 421-0396 (JP)**
- **TAKAKUWA Hideki**
  **Haibara-gun**
  **Shizuoka 421-0396 (JP)**
- **ARIMURA Keisuke**
  **Haibara-gun**
  **Shizuoka 421-0396 (JP)**
- **SHIMADA Kazuto**
  **Haibara-gun**
  **Shizuoka 421-0396 (JP)**

(74) Representative: **Hoffmann Eitle**
**Patent- und Rechtsanwälte PartmbB**
**Arabellastraße 30**
**81925 München (DE)**

(54) **LAMINATE, INFRARED ABSORPTION FILTER, BAND PASS FILTER, METHOD FOR MANUFACTURING LAMINATE, KIT FOR FORMING BAND PASS FILTER, AND IMAGE DISPLAY DEVICE**

(57) A laminate includes a first area formed by applying a first composition and a second area formed by applying a second composition on a surface of the first area, and a difference between refractive indexes of the first area and the second area is 0.5 or greater, and the first areas and the second areas are alternately laminated.

FIG. 1

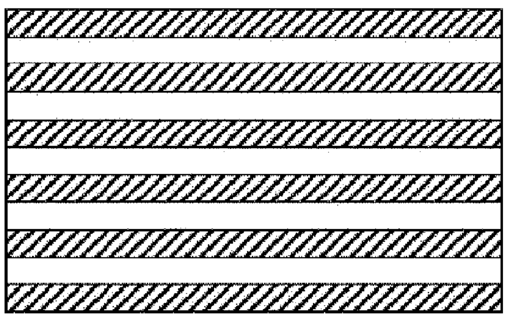

EP 3 162 556 A1

**Description**

**BACKGROUND OF THE INVENTION**

1. Field of the Invention

The present invention relates to a laminate and a method for manufacturing a laminate. The present invention also relates to an infrared ray absorption filter and a bandpass filter that include the laminate, a kit for forming a bandpass filter, and an image display device.

2. Description of the Related Art

In the related art, a bandpass filter that selectively transmits or blocks specific light is used in an optical member. A laminate (multilayer film) in which high refractive layers and low refractive layers are alternately laminated is formed as an example of this bandpass filter, so as to use intervention of light in the laminate (see JP2012-225993A, JP2008-015234A, and JP2004-354705A) has been studied.

**SUMMARY OF THE INVENTION**

All of the laminates disclosed in the patent documents described above are formed by performing vapor deposition on high refractive layers and low refractive layers, time and labor are required for manufacturing, and thus costs thereof are high. The invention is for solving the objects described above and providing a laminate that can be manufactured easily with a low cost and have high refractive layers and low refractive layers. The invention is also for providing an infrared ray absorption filter, a bandpass filter, a method for manufacturing a laminate, a kit for forming a bandpass filter, and an image display device.

In view of the circumstances above, the inventors diligently conducted research, and as a result have found the aforementioned object can be solved, since formation by coating becomes possible by formulating a resin on at least one of a high refractive area or a low refractive area. Specifically, the aforementioned object has been solved by means described below.

<1> A laminate comprising: a first area formed by applying a first composition; and a second area formed by applying a second composition on a surface of the first area, in which a difference between refractive indexes of the first area and the second area is 0.5 or greater, and the first areas and the second areas are alternately laminated.

<2> The laminate according to <1>, in which an absolute value of a difference between an SP value that is a solubility parameter of a solvent included in the first composition and an SP value that is a solubility parameter of a solvent included in the second composition is 0.5 $(cal/cm^3)^{1/2}$ or greater.

<3> The laminate according to <1> or <2>, in which one of the first composition and the second composition includes water, and the other of the first composition and the second composition includes an organic solvent.

<4> The laminate according to any one of <1> to <3>, in which, when observation with an optical microscope is performed in a direction in which the first area and the second area are laminated, the number of defects having a long diameter of 1 $\mu$m or greater is less than 50 defects/$mm^2$.

<5> The laminate according to any one of <1> to <4>, in which two or more of the first areas and two or more of the second areas are included, a variation of thicknesses of the respective first areas is within 3%, and a variation of thicknesses of the respective second areas is within 3%.

<6> The laminate according to any one of <1> to <5>, in which at least one of the first area or the second area includes a resin.

<7> The laminate according to any one of <1> to <6>, in which both of the first area and the second area include a resin.

<8> The laminate according to any one of <1> to <7>, in which a total number of the first area and the second area is 5 or more areas.

<9> The laminate according to any one of <1> to <8>, in which absorbance at a wavelength of 800 nm/absorbance at a wavelength of 700 nm, which is a ratio between absorbance at a wavelength of 700 nm and absorbance at a wavelength of 800 nm, is 5 or greater.

<10> The laminate according to any one of <1> to <9>, in which absorbance at a wavelength of 950 nm/absorbance at a wavelength of 850 nm, which is a ratio between absorbance at a wavelength of 850 nm and absorbance at a wavelength of 950 nm, is 5 or greater.

<11> The laminate according to any one of <1> to <10>, in which absorbance at a wavelength of 1,040 nm/absorbance at a wavelength of 940 nm, which is a ratio between absorbance at a wavelength of 940 nm and absorbance at a wavelength of 1,040 nm, is 5 or greater.

<12> The laminate according to any one of <1> to <11>, in which a refractive index of the first area is 1.5 to 3.0, and a refractive index of the second area is 1.0 to 1.3.
<13> The laminate according to any one of <1> to <12>, in which the first area includes a resin including a group selected from an acid group, a group having a basic nitrogen atom, a urea group, a urethane group, a group having a coordinating oxygen atom, a phenol group, an alkyl group, an aryl group, a group having an alkyleneoxy chain, an imide group, a heterocyclic group, an alkyloxycarbonyl group, an alkylaminocarbonyl group, a carboxylic acid salt group, a sulfonamide group, an alkoxysilyl group, an epoxy group, an isocyanate group, and a hydroxyl group; and metal oxide particles.
<14> The laminate according to any one of <1> to <13>, in which the second area includes at least one of a siloxane resin or a fluorine-containing resin.
<15> The laminate according to any one of <1> to <14>, in which the second area includes a moniliform silica.
<16> A laminate comprising: a first area; and a second area, in which the first areas and the second areas are alternately laminated, a difference between refractive indexes of the first area and the second area is 0.5 or greater, and at least one of the first area or the second area includes a resin.
<17> The laminate according to <16>, in which, when observation with an optical microscope is performed in a direction in which the first area and the second area are laminated, the number of defects having a long diameter of 1 $\mu$m or greater is less than 50 defects/mm$^2$.
<18> The laminate according to <16> or <17>, in which two or more of the first areas and two or more of the second areas are included, a variation of thicknesses of the respective first areas is within 3%, and a variation of thicknesses of the respective second areas is within 3%.
<19> The laminate according to any one of <1> to <18> that is used for forming a bandpass filter.
<20> An infrared ray absorption filter comprising: the laminate according to any one of <1> to <19>.
<21> A bandpass filter comprising: the laminate according to any one of <1> to <19>.
<22> The bandpass filter according to <21>, further comprising: an infrared ray transmission film.
<23> A method for manufacturing a laminate, comprising: forming a first area by applying a first composition including particles, a resin, and a solvent; and forming a second area by applying a second composition including particles, a resin, and a solvent on a surface of the first area, in which a difference between refractive indexes of the first area and the second area is 0.5 or greater.
<24> A method for manufacturing a laminate, comprising: forming a first area by applying a first composition including particles, a resin, and a solvent; and forming a second area by applying a second composition including particles, a resin, and a solvent on a surface of the first area, in which a difference between refractive indexes of the first area and the second area is 0.5 or greater, and one of the first composition and the second composition includes water, and the other of the first composition and the second composition includes an organic solvent.
<25> The method for manufacturing a laminate according to <23>, in which the laminate is the laminate according to any one of <1> to <19>.
<26> A kit for forming a bandpass filter, comprising: a first composition including particles, a resin, and a solvent; and a second composition including particles, a resin, and a solvent, in which a difference between a refractive index of a layer obtained with the first composition and a refractive index of a layer obtained with the second composition is 0.5 or greater.
<27> The kit for forming the bandpass filter according to <26>, in which the first composition includes metal oxide particles; a resin including a group selected from an acid group, a group having a basic nitrogen atom, a urea group, a urethane group, a group having a coordinating oxygen atom, a phenol group, an alkyl group, an aryl group, a group having an alkyleneoxy chain, an imide group, a heterocyclic group, an alkyloxycarbonyl group, an alkylaminocarbonyl group, a carboxylic acid salt group, a sulfonamide group, an alkoxysilyl group, an epoxy group, an isocyanate group, and a hydroxyl group; and a solvent, and the second composition includes metal oxide particles, at least one of a siloxane resin or a fluorine-containing resin, and a solvent.
<28> An image display device comprising: a color filter, in which at least a portion of the color filter includes the laminate according to any one of <1> to <19>.
<29> The image display device according to <28>, in which the image display device is a liquid crystal display device or an organic electroluminescence display device.

According to the invention, it is possible to provide a laminate that can be manufactured easily with a low cost and have high refractive areas and low refractive areas. It is possible to provide an infrared ray absorption filter, a bandpass filter, a method for manufacturing a laminate, a kit for forming a bandpass filter, and an image display device.

## BRIEF DESCRIPTION OF THE DRAWINGS

Fig. 1 is a cross-sectional view schematically illustrating an example of a configuration of a laminate according to the invention.
Fig. 2 is a cross-sectional view schematically illustrating another example of a configuration of the laminate according to the invention.
Figs. 3A and 3B are conceptual diagrams illustrating examples of relationships between wavelengths and transmittance of the laminate according to the invention.
Fig. 4 is a conceptual diagram illustrating an example of a relationship between a wavelength and transmittance, when the laminate according to the invention and another film are combined with each other.
Fig. 5 is a functional block diagram illustrating an image pick-up device in which an infrared ray sensor using the laminate according to the invention is applied.
Fig. 6 is a diagram illustrating a relationship between a wavelength and transmittance of a laminate 1 manufactured in this example, and characteristics of an infrared ray absorption filter.
Fig. 7 is a diagram illustrating a relationship between a wavelength and transmittance of an infrared ray transmission film A1 manufactured in this example.
Fig. 8 is a diagram illustrating a relationship between a wavelength and transmittance of a bandpass filter A obtained by combining the laminate 1 manufactured in this example and an infrared ray transmission film A.
Fig. 9 is a diagram illustrating a relationship between a wavelength and transmittance of a laminate 2 manufactured in this example and illustrating characteristics of the infrared ray absorption filter.
Fig. 10 is a diagram illustrating a relationship between a wavelength and transmittance of an infrared ray transmission film B manufactured in this example.
Fig. 11 is a diagram illustrating a relationship between a wavelength and transmittance of a bandpass filter B obtained by combining a laminate 2 manufactured in this example and the infrared ray transmission film B.
Fig. 12 is a diagram illustrating a relationship between a wavelength and transmittance of a laminate 3 manufactured in this example and characteristics of the infrared ray absorption filter.
Fig. 13 is a diagram illustrating a relationship between a wavelength and transmittance of an infrared ray transmission film C manufactured in this example.
Fig. 14 is a relationship between a wavelength and transmittance of the bandpass filter C obtained by combining the laminate 3 manufactured in this example and infrared ray transmission film C.
Fig. 15 is a diagram illustrating a relationship of a wavelength and transmittance of a laminate 4 manufactured in this example.
Fig. 16 is a diagram illustrating a relationship of a wavelength and transmittance of a laminate 5 manufactured in this example.
Fig. 17 is a diagram illustrating a relationship between a wavelength and transmittance of a laminate 6 manufactured in this example.

## DESCRIPTION OF THE PREFERRED EMBODIMENTS

Hereinafter, a laminate according to the invention, an infrared ray absorption filter, a bandpass filter, a method for manufacturing a laminate, and a kit for forming a bandpass filter are described in detail.
Configurational elements according to the invention are described based on representative embodiments of the invention, but the invention is not limited to the embodiments.
In the description of a group (atomic group) in this specification, a denotation without substitution and non-substitution includes a group (atomic group) with a substituent, together with a group (atomic group) without a substituent. For example, an "alkyl group" includes not only an alkyl group (non-substituted alkyl group) without a substituent but also an alkyl group (substituted alkyl group) with a substituent.
In this specification, a numerical range using the expression "to" means a range including numerical values indicated before and after the expression "to" as a lower limit and an upper limit.
In this specification, a total solid content refers to total mass of a content excluding a solvent from the entire content of a composition.
A concentration of solid contents in this specification refers to a concentration of a solid content at 25°C.
The monomer in this specification is differentiated from an oligomer and a polymer, and refers to a compound having a weight-average molecular weight of 2,000 or less. In this specification, a polymerizable compound may be a compound having a polymerizable functional group. A polymerizable compound may be a monomer or may be a polymer. The polymerizable functional group refers to a group participating in polymerization reaction.
In this specification, 1 cal is converted to 4.1868 J, and 1 inch is converted to 2.54 cm.
In this specification, the term "step" is not limited to an independent step, and in a case where a step cannot be differentiated from the other steps even if the step achieves an expected effect, the case is included in this term.
In this specification, a weight-average molecular weight is defined as a value in terms of polystyrene by GPC

measurement. In this specification, a weight-average molecular weight (Mw) can be obtained, for example, with HLC-8220 (manufactured by Tosoh Corporation), using TSK gel Super AWM-H (manufactured by Tosoh Corporation, 6.0 mm ID×15.0 cm) as a column and using 10 mmol/L lithium bromide NMP (N-methylpyrrolidinone) solution as an eluant.

In this specification, absorbance Aλ at a wavelength λ is defined by Expression (1) below.

$$A\lambda=-\log(T\lambda) \quad \cdots (1)$$

Aλ represents absorbance at a wavelength λ, and Tλ represents a transmittance at a wavelength λ.

Absorbance can be calculated by a well-known spectrophotometer in the related art. The measurement condition of the absorbance is not particularly limited. In a case where absorbance is measured in a liquid state, examples thereof include a method of adjusting an optical path length of a sample cell. In a case where absorbance is measured in a film state, examples thereof include a method of adjusting a film thickness.

Laminate

A laminate according to a first embodiment of the invention has a first area and a second area, the first areas and the second areas are alternately laminated, a difference between refractive indexes of the first area and the second area is 0.5 or greater, and at least one of the first area or the second area includes a resin. It is preferable that both of the first area and the second area include a resin.

A laminate according to a second embodiment of the invention has a first area formed by applying a first composition and a second area formed by applying a second composition on a surface of the first area, a difference between refractive indexes of the first area and the second area is 0.5 or greater, and the first areas and the second areas are alternately laminated. It is preferable that the first composition and the second composition each independently include a resin. A high refractive composition described below is exemplified as the first composition, and a low refractive composition described below is exemplified as a second composition.

If the invention has such a configuration, it is possible to form a layer by coating, and thus it is possible to manufacture a laminate easily with a low cost. That is, in the related art, a laminate of a high refractive layer and a low refractive layer is manufactured by vapor deposition. However, according to the invention, it is succeeded to manufacture a layer by coating.

Hereinafter, the laminate according to the invention is described in detail.

<Configuration of laminate>

A laminate according to the invention has a first area (hereinafter, also referred to as a "high refractive area") and a second area (hereinafter, also referred to as a "low refractive area") and has the high refractive area and the low refractive area alternately laminated.

Fig. 1 is a diagram schematically illustrating an example of a configuration of the laminate according to the invention, and high refractive areas (layers shown by a white color) and low refractive areas (layers shown by diagonal lines) alternately laminated. Optical paths of light are adjusted by adjusting thicknesses of the high refractive area and the low refractive area, such that transmittance of light at a desired wavelength can be controlled. In Fig. 1, thicknesses of the high refractive area and the low refractive area are caused to be substantially the same but may be different from each other. The high refractive area and the low refractive area may be each independently represent one high refractive layer or one low refractive layer or may be formed with two or more high refractive layers or two or more low refractive layers.

Fig. 2 is a cross-sectional view schematically illustrating another example of a configuration of the laminate according to the invention and shows a configuration in which high refractive areas (layers shown by a white color) are continuously formed, such that thicknesses of the respective high refractive areas are different from each other. In this manner, it becomes possible to transmit only light in a specific wavelength by providing areas having different thicknesses in plural high refractive areas. In a case where the high refractive area consists of two or more high refractive layers, the upper limit of the number of high refractive layers that form one high refractive area is, for example, 8 layers or less and further 6 layers or less. The thickness of the high refractive area can be adjusted by adjusting the thickness of the coated film. Fig. 2 illustrates a configuration in which thicknesses of the respective high refractive areas are different, but it is obvious that a configuration in which the thicknesses of the respective low refractive areas are different from each other in the same manner is possible. In this case, details of the low refractive area may be the same as the details of the high refractive area. Both of the high refractive area and the low refractive area may have different configurations from each other.

The alternate lamination according to the invention refers to a configuration in which low refractive areas and

high refractive areas are laminated on the film by turns, but the lamination does not have to be a laminate only with the low refractive areas and the high refractive areas. For example, a third area having a refractive index different from the first area and the second area such as a medium refractive area may be provided between the low refractive areas and the high refractive areas.

The laminate according to the invention is generally formed by applying, and thus the laminate is provided on a substrate to be coated with a low refractive area and a high refractive area. As the substrate, a glass substrate and a plastic substrate are exemplified.

The total number of the high refractive areas and the low refractive areas in one laminate is preferably 5 or more areas, more preferably 8 or more areas, or can be 10 or more areas. An upper limit value is, for example, 30 or fewer areas, can be 25 or fewer areas, and also can be 20 or fewer areas. In a case where there is a third area, it is preferable that a total number of these is in the range described above.

According to the invention, a difference between refractive indexes of the high refractive area and the low refractive area is 0.5 or greater, preferably 0.55 or greater, can be 0.6 or greater, and also can be 0.65 or greater. For example, an upper limit value of the difference between the refractive indexes of the high refractive area and the low refractive area can be 0.8 or less and also can be 0.75 or less. The refractive index refers to a refractive index at a wavelength of 635 nm. Numerical values of the refractive indexes of the high refractive area and the low refractive area refer to refractive indexes at a wavelength of 635 nm.

<Characteristics of laminate>

The laminate according to the invention can cause only transmittance at a specific wavelength range to be high or cause only transmittance at a specific wavelength range to be low by appropriately and each independently adjusting film thicknesses of the high refractive area and the low refractive area or the number of the respective areas. Figs. 3A and 3B are conceptual diagrams illustrating examples of relationships between wavelengths and transmittance of the laminate according to the invention. A diagram illustrated in Fig. 3A is a conceptual diagram in which transmittance at a specific wavelength range is caused to be low, and a diagram illustrated in Fig. 3B is a conceptual diagram in which transmittance at a specific wavelength range is caused to be high. A vertical axis T% represents transmittance, and a lateral axis Wavelength represents a wavelength.

Specifically, it is possible to form, for example, a laminate as below.

(1) Absorbance at a wavelength of 800 nm/absorbance at a wavelength of 700 nm which is a ratio between absorbance at a wavelength of 700 nm and absorbance at a wavelength of 800 nm is 5 or greater, and preferably 10 or greater. The upper limit value is not particularly limited, but the upper limit value can be, for example, 1,500 or less.
(2) Absorbance at a wavelength of 950 nm/absorbance at a wavelength of 850 nm, that is a ratio between absorbance at a wavelength of 850 nm and absorbance at a wavelength of 950 nm is 5 or greater and preferably 10 or greater. The upper limit value is not particularly limited, but the upper limit value can be, for example, 1,500 or less.
(3) Absorbance at a wavelength of 1,040 nm/absorbance at a wavelength of 940 nm, that is a ratio between absorbance at a wavelength of 940 nm and absorbance at a wavelength of 1,040 nm is 5 or greater and preferably 10 or greater. The upper limit value is not particularly limited, but the upper limit value can be, for example, 1,500 or less.

<First area (high refractive area)>

A refractive index of the first area according to the invention is preferably higher than that of a second area described below, by 0.5 or greater. The refractive index of the high refractive area is preferably 1.5 to 3.0 and more preferably 1.7 to 2.3.

The first area is preferably a layer including a resin. The layer including a resin may be a layer including a so-called high refractive resin and may be formed by applying the composition (hereinafter, also referred to as a "high refractive composition") including a resin, particles, and a solvent. The resin used for forming the first area is preferably a polymer chain consisting of a repeating unit derived from a polymerizable monomer or a compound having a polymer chain consisting of a repeating unit derived from a polymerizable monomer as a partial structure. Preferably, the resin is a layer formed by applying a high refractive composition.

Hereinafter, details of the high refractive composition are described.

«High refractive composition»

<<<Resin>>>

Examples of a resin included in the high refractive composition include a resin in which particles described below can be dispersed. Specifically, embodiments below are exemplified.

(First embodiment)

The resin included in the high refractive composition according to the first embodiment is a resin including a group selected from an acid group, a group having a basic nitrogen atom, a urea group, a urethane group, a group having a coordinating oxygen atom, a phenol group, an alkyl group, an aryl group, a group having an alkyleneoxy chain, an imide group, a heterocyclic group, an alkyloxycarbonyl group, an alkylaminocarbonyl group, a carboxylic acid salt group, a sulfonamide group, an alkoxysilyl group, an epoxy group, an isocyanate group, and a hydroxyl group.
The resin is more preferably a resin represented by Formula (1).

Formula (1)

$$\left(A^1-R^2\right)_n R^1 \left(P^1\right)_m$$

In Formula (1), $R^1$ represents a (m+n)-valent linking group, and $R^2$ represents a single bond or a divalent linking group. $A^1$ represents a monovalent substituent having at least one group selected from an acid group, a urea group, a urethane group, a group having a coordinating oxygen atom, a group having a basic nitrogen atom, a phenol group, an alkyl group, an aryl group, a group having an alkyleneoxy chain, an imide group, a heterocyclic group, an alkyloxycarbonyl group, an alkylaminocarbonyl group, a carboxylic acid salt group, a sulfonamide group, an alkoxysilyl group, an epoxy group, an isocyanate group, and a hydroxyl group. n of $A^1$ and $R^2$ may respectively identical to or different from each other. m represents a positive number of 8 or less, n represents 1 to 9, and m+n satisfies 3 to 10. $P^1$ represents a polymer chain. m of $P^1$ may be identical to or different from each other.
Hereinafter, respective groups in Formula (1) are described in detail.
$A^1$ represents a monovalent substituent having at least one of a functional group having adsorbing properties to particles described below (preferably, metal oxide particles) such as an acid group, a group having a basic nitrogen atom, a urea group, a urethane group, a group having a coordinating oxygen atom, an alkyl group, a group having an alkyleneoxy chain, an imide group, an alkyloxycarbonyl group, an alkylaminocarbonyl group, a carboxylic acid salt group, a sulfonamide group, an alkoxysilyl group, an epoxy group, an isocyanate group, and a hydroxyl group, or a structure that have adsorbing properties to particles (preferably, metal oxide particles) described below, such as a heterocyclic structure (a phenol group, an aryl group, and the like).
Hereinafter, sites (the functional groups and the structures described above) having adsorbing properties to these particles (preferably, metal oxide particles) are collectively called "adsorbing sites" appropriately.
At least one of the adsorbing sites may be included in one $A^1$, or two or more types thereof may be included in one $A^1$.
According to the invention, a "monovalent substituent having at least one adsorbing site" refers to a monovalent substituent in which an adsorbing site is bonded to a linking group which may contain 1 to 200 carbon atoms, 0 to 20 nitrogen atoms, 0 to 100 oxygen atoms, 1 to 400 hydrogen atoms, or 0 to 40 sulfur atoms. In a case where an adsorbing site itself forms a monovalent substituent, the adsorbing site itself may be a monovalent substituent represented by $A^1$.
First, the adsorbing site that forms $A^1$ is described below.
Examples of the "acid group" preferably include a carboxylic acid group, a sulfonic acid group, a monosulfuric acid ester group, a phosphoric acid group, a monophosphoric acid ester group, and a boric acid group, more preferably include a carboxylic acid group, a sulfonic acid group, a monosulfuric acid ester group, a phosphoric acid group, and a monophosphoric acid ester group, even more preferably include a carboxylic acid group, a sulfonic acid group, and a phosphoric acid group, and particularly preferably include a carboxylic acid group.
The acid value is preferably 20 to 300 mg KOH/g, more preferably 50 to 250 mg KOH/g, and even more preferably 50 to 210 mg KOH/g.
Examples of an "urea group" preferably include $-NR^{15}CONR^{16}R^{17}$ (here, $R^{15}$, $R^{16}$, and $R^{17}$ each independently represent a hydrogen atom, an alkyl group having 1 to 20 carbon atoms, an aryl group having 6 or more carbon atoms, or an aralkyl group having 7 or more carbon atoms), more preferably $-NR^{15}CONHR^{17}$ (here, $R^{15}$ and $R^{17}$ each inde-

pendently represent a hydrogen atom, an alkyl group having 1 to 10 carbon atoms, an aryl group having 6 or more carbon atoms, and an aralkyl group having 7 or more carbon atoms), and particularly preferably $-NHCONHR^{17}$ (here, $R^{17}$ represents a hydrogen atom, an alkyl group having 1 to 10 carbon atoms, an aryl group having 6 or more carbon atoms, and an aralkyl group having 7 or more carbon atoms).

Examples of the "urethane group" preferably include $-NHCOOR^{18}$, $-NR^{19}COOR^{20}$, $-OCONHR^{21}$, and $-OCONR^{22}R^{23}$ (here, $R^{18}$, $R^{19}$, $R^{20}$, $R^{21}$, $R^{22}$, and $R^{23}$ each independently represent an alkyl group having 1 to 20 carbon atoms, an aryl group having 6 or more carbon atoms, and an aralkyl group having 7 or more carbon atoms), more preferably $-NHCOOR^{18}$ and $-OCONHR^{21}$ (here, $R^{18}$ and $R^{21}$ each independently represent an alkyl group having 1 to 20 carbon atoms, an aryl group having 6 or more carbon atoms, or an aralkyl group having 7 or more carbon atoms), and particularly preferably $-NHCOOR^{18}$ or $-OCONHR^{21}$ (here, $R^{18}$ and $R^{21}$ each independently represent an alkyl group having 1 to 10 carbon atoms, an aryl group having 6 or more carbon atoms, and an aralkyl group having 7 or more carbon atoms).

Examples of the "group having a coordinating oxygen atom" include an acetylacetonate group and a crown ether group.

Examples of the "group having a basic nitrogen atom" preferably include an amino group ($-NH_2$), a substituted imino group (for example, $-NHR^8$ and $-NR^9R^{10}$, where $R^8$, $R^9$, and $R^{10}$ each independently represent an alkyl group having 1 to 20 carbon atoms, an aryl group having 6 or more carbon atoms, and an aralkyl group having 7 or more carbon atoms), a guanidyl group represented by Formula (a1) below, and an amidinyl group represented by Formula (a2) below.

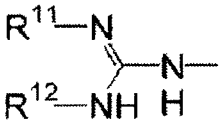 (a1)

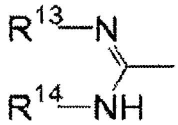 (a2)

In Formula (a1), $R^{11}$ and $R^{12}$ each independently represent an alkyl group having 1 to 20 carbon atoms, an aryl group having 6 or more carbon atoms, and an aralkyl group having 7 or more carbon atoms.

In Formula (a2), $R^{13}$ and $R^{14}$ each independently represent an alkyl group having 1 to 20 carbon atoms, an aryl group having 6 or more carbon atoms, and an aralkyl group having 7 or more carbon atoms.

Among these, an amino group ($-NH_2$), a substituted imino group ($-NHR^8$ and $-NR^9R^{10}$, where $R^8$, $R^9$, and $R^{10}$ each independently represent an alkyl group having 1 to 10 carbon atoms, a phenyl group, or a benzyl group), a guanidyl group represented by Formula (a1) (in Formula (a1), $R^{11}$ and $R^{12}$ each independently represent an alkyl group having 1 to 10 carbon atoms, a phenyl group, and a benzyl group), an amidinyl group represented by Formula (a2) (in Formula (a2), $R^{13}$ and $R^{14}$ each independently represent an alkyl group having 1 to 10 carbon atoms, a phenyl group, and a benzyl group), and the like are more preferable.

An amino group ($-NH_2$), a substituted imino group ($-NHR^8$ and $-NR^9R^{10}$, where $R^8$, $R^9$, and $R^{10}$ each independently represent an alkyl group having 1 to 5 carbon atoms, a phenyl group, or a benzyl group), a guanidyl group represented by Formula (a1) (in Formula (a1), $R^{11}$ and $R^{12}$ each independently represent an alkyl group having 1 to 5 carbon atoms, a phenyl group, or a benzyl group), an amidinyl group represented by Formula (a2) (in Formula (a2), $R^{13}$ and $R^{14}$ each independently represent an alkyl group having 1 to 5 carbon atoms, a phenyl group, or a benzyl group), and the like are particularly preferably used.

The "alkyl group" may have a linear shape or may have a branched shape, preferably an alkyl group having 1 to 40 carbon atoms, more preferably an alkyl group having 4 to 30 carbon atoms, and even more preferably an alkyl group having 10 to 18 carbon atoms.

The "aryl group" is preferably an aryl group having 6 to 10 carbon atoms.

As the "group having an alkyleneoxy chain", a terminal preferably forms an alkyloxy group or a hydroxyl group and more preferably forms an alkyloxy group having 1 to 20 carbon atoms. An alkyleneoxy chain is not particularly limited, as long as the alkyleneoxy chain has at least one alkyleneoxy group, but it is preferable that the alkyleneoxy chain consists of an alkyleneoxy group having 1 to 6 carbon atoms. Examples of the alkyleneoxy group include $-CH_2CH_2O-$ and $-CH_2CH_2CH_2O-$.

As an alkyl group part in the "alkyloxycarbonyl group", an alkyl group having 1 to 20 carbon atoms is preferable, and examples thereof include a methyl group and an ethyl group.

As an alkyl group part in the "alkylaminocarbonyl group", an alkyl group having 1 to 20 carbon atoms is preferable, and examples thereof include a methyl group, an ethyl group, and a propyl group.

Examples of the "carboxylic acid salt group" include a group consisting of ammonium salt of carboxylic acid.

As the "sulfonamide group", a hydrogen atom bonded to a nitrogen atom may be substituted with an alkyl group (a methyl group, or the like), an acyl group (an acetyl group, a trifluoroacetyl group, or the like), or the like.

Preferable examples of the "heterocyclic group" include a thiophene group, a furan group, a xanthene group, a pyrrole group, a pyrroline group, a pyrrolidine group, a dioxolane group, a pyrazole group, a pyrazoline group, a pyrazolidine group, an imidazole group, an oxazole group, a thiazole group, an oxadiazole group, a triazole group, a thiadiazole group, a pyran group, a pyridine group, a piperidine group, a dioxane group, a morpholine group, a pyridazine group, a pyrimidine group, a piperazine group, a triazine group, a trithiane group, an isoindoline group, an isoindolinone group, a benzimidazolone group, a benzothiazole group, an imide group such as a succinimide group, a phthalimide group, or a naphthalimide group, a hydantoin group, an indole group, a quinoline group, a carbazole group, an acridine group, an acridone group, and an anthraquinone group.

Examples of the "imide group" include a group consisting of succinimide, phthalimide, and naphthalimide.

The "heterocyclic group" may further have a substituent, and examples of the substituent include an alkyl group having 1 to 20 carbon atoms such as a methyl group or an ethyl group, an aryl group having 6 to 16 carbon atoms such as a phenyl group and a naphthyl group, an acyloxy group having 1 to 6 carbon atoms such as a hydroxyl group, an amino group, a carboxyl group, a sulfonamide group, an N-sulfonyl amide group, or an acetoxy group, an alkoxy group having 1 to 20 carbon atoms such as a methoxy group or an ethoxy group, a halogen atom such as a chlorine atom or a bromine atom, an alkoxycarbonyl group having 2 to 7 carbon atoms such as a methoxycarbonyl group, an ethoxycarbonyl group, or a cyclohexyloxycarbonyl group, or a carbonic acid ester group such as a cyano group or a t-butyl carbonate group. Here, such a substituent may be bonded to a heterocyclic group via a linking group formed by being combined with a structural unit below or the structural unit above.

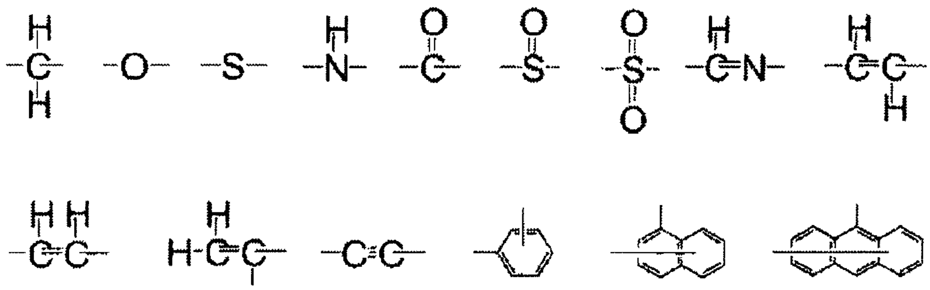

The "alkoxysilyl group" may be any one of a monoalkoxysilyl group, a dialkoxysilyl group, or a trialkoxysilyl group, but a trialkoxysilyl group is preferable, and examples thereof include a trimethoxysilyl group or a triethoxysilyl group.

Examples of the "epoxy group" include a substituted or a non-substituted oxirane group (an ethylene oxide group). The epoxy group can be represented by Formula (a3) below.

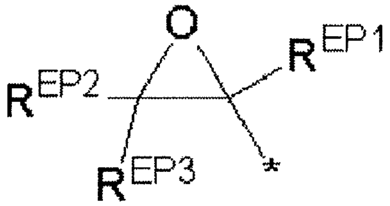

(a3)

In Formula (a3) above,

$R^{EP1}$ to $R^{EP3}$ each independently represent a hydrogen atom, a halogen atom, an alkyl group, or a cycloalkyl group. $R^{EP1}$ and $R^{EP2}$, or $R^{EP2}$ and $R^{EP3}$ may be bonded to each other to form a ring structure. * represents a linking hand.

As a linking group that is bonded to an adsorbing site, a single bond or a linking group which may contain 1 to 100 carbon atoms, 0 to 10 nitrogen atoms, 0 to 50 oxygen atoms, 1 to 200 hydrogen atoms, or 0 to 20 sulfur atoms is preferable, and this organic linking group may be non-substituted and may further have substituent.

Specific examples of this linking group include a group formed by being combined with a structural unit below or the structural unit above.

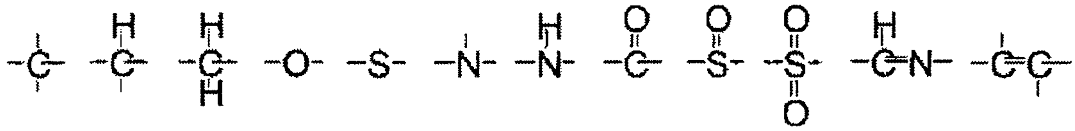

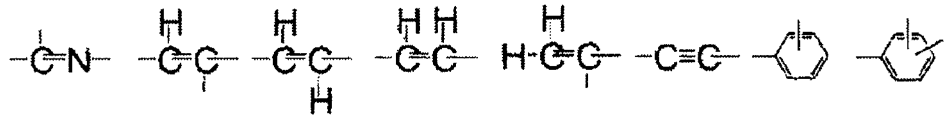

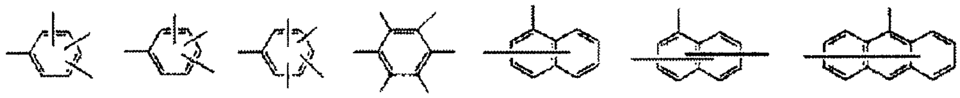

In a case where the linking group further has a substituent, examples of the substituent include an alkyl group having 1 to 20 carbon atoms such as a methyl group and an ethyl group, an aryl group having 6 to 16 carbon atoms such as a phenyl group or a naphthyl group, an acyloxy group having 1 to 6 carbon atoms such as a hydroxyl group, an amino group, a carboxyl group, a sulfonamide group, an N-sulfonyl amide group, or an acetoxy group, an alkoxy group having 1 to 6 carbon atoms such as a methoxy group or an ethoxy group, a halogen atom such as a chlorine atom or a bromine atom, an alkoxycarbonyl group having 2 to 7 carbon atoms such as a methoxycarbonyl group, an ethoxycarbonyl group, or a cyclohexyloxycarbonyl group, or a carbonic acid ester group such as a cyano group or a t-butyl carbonate group.

Among the above, as $A^1$, a monovalent substituent having at least one group selected from a group consisting of an acid group, a urea group, an urethane group, a sulfonamide group, an imide group, and a group having a coordinating oxygen atom are preferable.

Particularly, in view of increasing a refractive index and decreasing a viscosity of a composition by making an interaction with particles strong, $A^1$ is more preferably a monovalent substituent having at least one functional group having pKa of 5 to 14.

The term "pKa" refer to an acid dissociation constant having a definition disclosed in Chemical Manual (II) (Amendment 4th edition, 1993, Chemical Society of Japan, Maruzen Co., Ltd.).

Examples of the functional group having pKa of 5 to 14 include a urea group, a urethane group, a sulfonamide group, an imide group, or a group having a coordinating oxygen atom.

Specifically, examples thereof include a urea group (pKa of about 12 to 14), a urethane group (pKa of about 11 to 13), $-COCH_2CO-$ (pKa of about 8 to 10) as a coordinating oxygen atom, and a sulfonamide group (pKa of about 9 to 11).

$A^1$ is preferably represented as a monovalent substituent represented by Formula (4) below.

$$(B^1)_a-R^{24} \quad \text{Formula (4)}$$

In Formula (4), $B^1$ represents an adsorbing site, and $R^{24}$ represents a single bond or an (a+1)-valent linking group. a represents an integer of 1 to 10, and a of $B^1$ in Formula (4) may be identical to or different from each other.

An adsorbing site represented by $B^1$ may be the same as an adsorbing site that forms $A^1$ of Formula (1) described above, and preferable examples thereof are the same.

Among these, an acid group, a urea group, a urethane group, a sulfonamide group, an imide group, or a group having a coordinating oxygen atom is preferable. Since a functional group having pKa of 5 to 14 is more preferable, an urea group, an urethane group, a sulfonamide group, an imide group, or a group having a coordinating oxygen atom is more preferable.

$R^{24}$ represents a single bond or an (a+1)-valent linking group, and a represents 1 to 10. a is preferably 1 to 7, a is more preferably 1 to 5, and a is particularly preferably 1 to 3.

Examples of the (a+1)-valent linking group include a group which may contain 1 to 100 carbon atoms, 0 to 10 nitrogen atoms, 0 to 50 oxygen atoms, 1 to 200 hydrogen atoms, or 0 to 20 sulfur atoms, and the (a+1)-valent linking group may be non-substituted or may further have a substituent.

Specific examples of the (a+1)-valent linking group include a group formed by being combined with a structural unit below or the structural unit above (a ring structure may be formed).

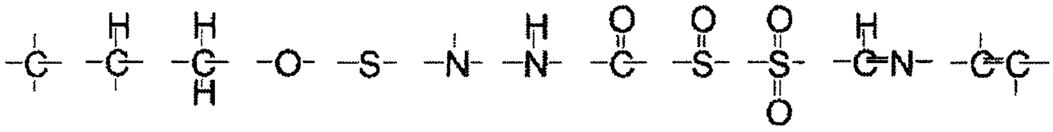

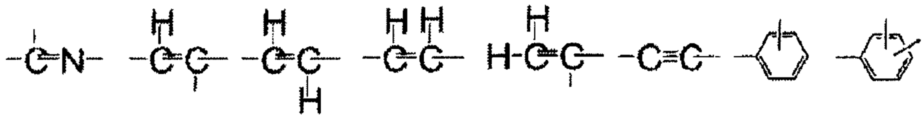

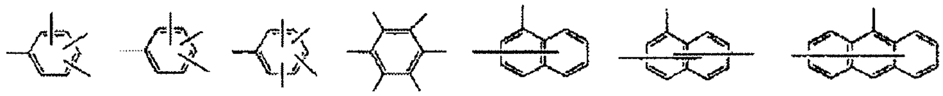

As $R^{24}$, a single bond or an (a+1)-valent linking group which may contain 1 to 50 carbon atoms, 0 to 8 nitrogen atoms, 0 to 25 oxygen atoms, 1 to 100 hydrogen atoms, or 0 to 10 sulfur atoms are preferable, a single bond or an (a+1)-valent linking group which may contain 1 to 30 carbon atoms, 0 to 6 nitrogen atoms, 0 to 15 oxygen atoms, 1 to 50 hydrogen atoms, or 0 to 7 sulfur atoms are more preferable, and a single bond or an (a+1)-valent linking group which may contain 1 to 10 carbon atoms, 0 to 5 nitrogen atoms, 0 to 10 oxygen atoms, 1 to 30 hydrogen atoms, or 0 to 5 sulfur atoms are particularly preferable.

Among the above, in a case where an (a+1)-valent linking group has a substituent, examples of the substituent include an alkyl group having 1 to 20 carbon atoms such as a methyl group or an ethyl group, an aryl group having 6 to 16 carbon atoms such as a phenyl group or a naphthyl group, an acyloxy group having 1 to 6 carbon atoms such as a hydroxyl group, an amino group, a carboxyl group, a sulfonamide group, an N-sulfonyl amide group, or an acetoxy group, an alkoxy group having 1 to 6 carbon atoms such as a methoxy group or an ethoxy group, a halogen atom such as a chlorine atom or a bromine atom, an alkoxycarbonyl group having 2 to 7 carbon atoms such as a methoxycarbonyl group, an ethoxycarbonyl group, or a cyclohexyloxycarbonyl group, or a carbonic acid ester group such as a cyano group or a t-butyl carbonate group.

In Formula (1), $R^2$ represents a single bond or a divalent linking group. n of $R^2$'s may be identical to or different from each other.

Examples of the divalent linking group include a group which may contain 1 to 100 carbon atoms, 0 to 10 nitrogen atoms, 0 to 50 oxygen atoms, 1 to 200 hydrogen atoms, or 0 to 20 sulfur atoms, and the divalent linking group may not be substituted or may further have a substituent.

Specific example of the divalent linking group include a group formed by being combined with a structural unit below or the structural unit above.

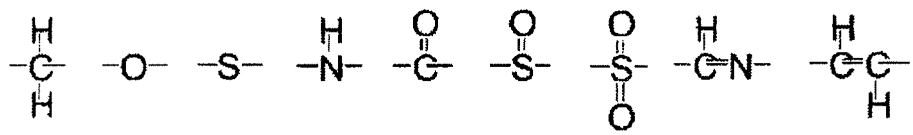

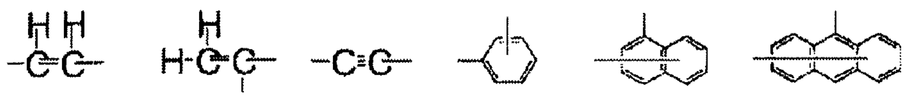

As $R^2$, a single bond or a divalent linking group which may contain 1 to 50 carbon atoms, 0 to 8 nitrogen atoms, 0 to 25 oxygen atoms, 1 to 100 hydrogen atoms, or 0 to 10 sulfur atoms are preferable, a single bond or a divalent linking group which may contain 1 to 30 carbon atoms, 0 to 6 nitrogen atoms, 0 to 15 oxygen atoms, 1 to 50 hydrogen atoms, or 0 to 7 sulfur atoms are more preferable, and a single bond or a divalent linking group which may contain 1 to 10 carbon atoms, 0 to 5 nitrogen atoms, 0 to 10 oxygen atoms, 1 to 30 hydrogen atoms, or 0 to 5 sulfur atoms are particularly preferable.

Among the above, in a case where the divalent linking group has a substituent, examples of the substituent include an alkyl group having 1 to 20 carbon atoms such as a methyl group or an ethyl group, an aryl group having 6 to 16 carbon atoms such as a phenyl group or a naphthyl group, an acyloxy group having 1 to 6 carbon atoms such as a hydroxyl group, an amino group, a carboxyl group, a sulfonamide group, an N-sulfonyl amide group, or an acetoxy group,

an alkoxy group having 1 to 6 carbon atoms such as a methoxy group or an ethoxy group, a halogen atom such as a chlorine atom or a bromine atom, an alkoxycarbonyl group having 2 to 7 carbon atoms such as a methoxycarbonyl group, an ethoxycarbonyl group, or a cyclohexyloxycarbonyl group, or a carbonic acid ester group such as a cyano group or a t-butyl carbonate group.

In Formula (1), $R^1$ represents a (m+n)-valent linking group. m+n satisfies 3 to 10.

Examples of an (m+n)-valent linking group represented by $R^1$ include a group which may contain 1 to 100 carbon atoms, 0 to 10 nitrogen atoms, 0 to 50 oxygen atoms, 1 to 200 hydrogen atoms, or 0 to 20 sulfur atoms, and the (m+n)-valent linking group may be non-substituted or may further have a substituent.

Specific examples of the (m+n)-valent linking group include a group formed by being combined with a structural unit below or the structural unit above (a ring structure may be formed).

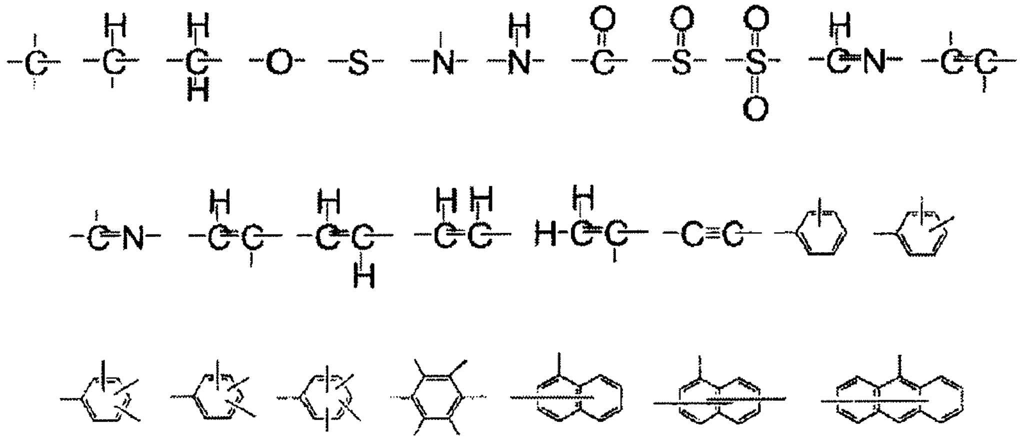

As the (m+n)-valent linking group, a group which may contain 1 to 60 carbon atoms, 0 to 10 nitrogen atoms, 0 to 40 oxygen atoms, 1 to 120 hydrogen atoms, or 0 to 10 sulfur atoms are preferable, a group which may contain 1 to 50 carbon atoms, 0 to 10 nitrogen atoms, 0 to 30 oxygen atoms, 1 to 100 hydrogen atoms, or 0 to 7 sulfur atoms are more preferable, and a group which may contain 1 to 40 carbon atoms, 0 to 8 nitrogen atoms, 0 to 20 oxygen atoms, 1 to 80 hydrogen atoms, or 0 to 5 sulfur atoms are particularly preferable.

Among the above, in a case where the (m+n)-valent linking group has a substituent, examples of the substituent include an alkyl group having 1 to 20 carbon atoms such as a methyl group or an ethyl group, an aryl group having 6 to 16 carbon atoms such as a phenyl group or a naphthyl group, an acyloxy group having 1 to 6 carbon atoms such as a hydroxyl group, an amino group, a carboxyl group, a sulfonamide group, an N-sulfonyl amide group, or an acetoxy group, an alkoxy group having 1 to 6 carbon atoms such as a methoxy group or an ethoxy group, a halogen atom such as a chlorine atom or a bromine atom, an alkoxycarbonyl group having 2 to 7 carbon atoms such as a methoxycarbonyl group, an ethoxycarbonyl group, or a cyclohexyloxycarbonyl group, or a carbonic acid ester group such as a cyano group or a t-butyl carbonate group.

Specific examples [Specific Examples (1) to (17)] of a (m+n)-valent linking group represented by $R^1$ are provided below. However, the invention is not limited thereto.

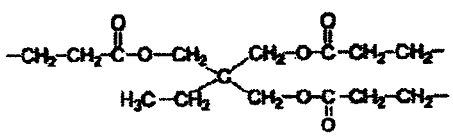 (1)

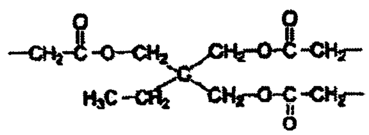 (2)

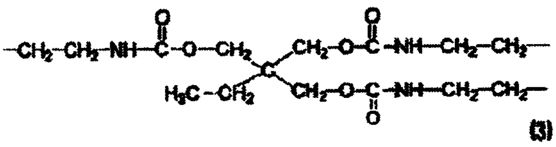
(3)

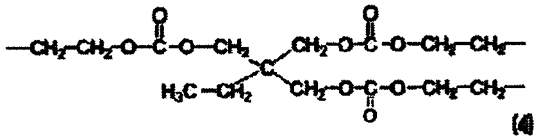
(4)

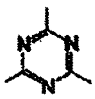
(5)

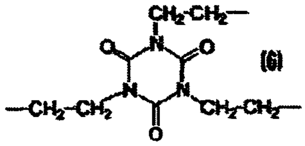
(6)

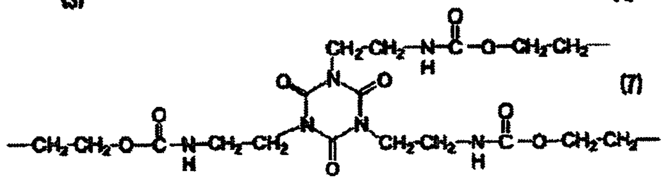
(7)

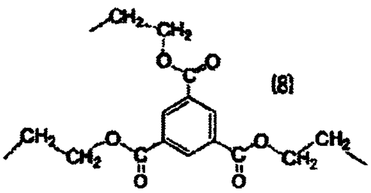
(8)

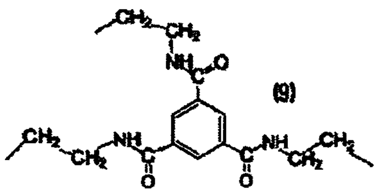
(9)

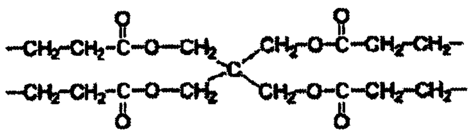
(10)

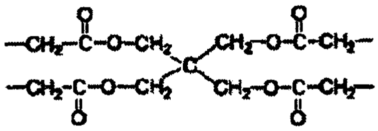
(11)

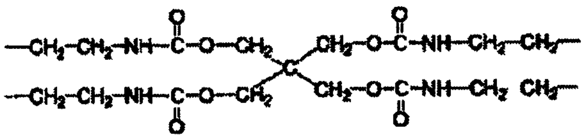
(12)

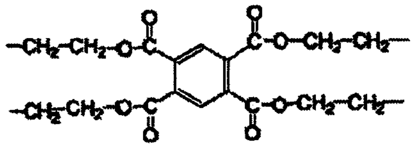
(13)

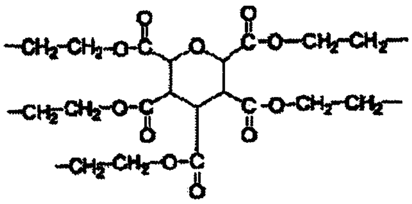
(14)

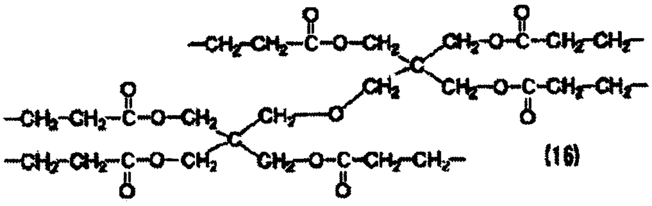
(16)

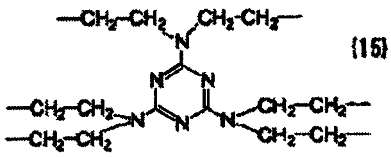
(15)

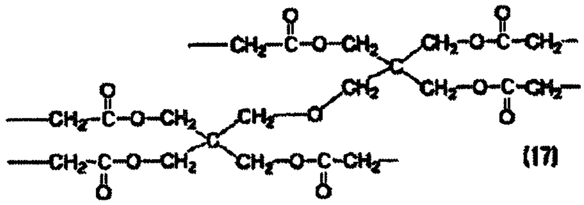
(17)

Among these specific examples, in view of availability of materials, easiness of synthesis, and solubility to various solvents, preferable examples of the (m+n)-valent linking group are (1), (2), (10), (11), (16), and (17).

In Formula (1), m represents a positive number of 8 or less. As m, 0.5 to 5 are preferable, 1 to 4 are more preferable, and 1 to 3 are particularly preferable.

In Formula (1), n represents 1 to 9. As n, 2 to 8 are preferable, 2 to 7 are more preferable, and 3 to 6 are particularly preferable.

In Formula (1), $P^1$ represents a polymer chain and can be selected from well-known polymers or the like, depending on the purposes. m of $P^1$'s may be identical to or different from each other.

Among the polymers, in order to form a polymer chain, at least one selected from a group consisting of a polymer or a copolymer of a vinyl monomer, an ester-based polymer, an ether-based polymer, an urethane-based

polymer, an amide-based polymer, an epoxy-based polymer, and a silicone-based polymer, and modified products thereof or copolymers thereof [examples thereof include a polyether/polyurethane copolymer or a copolymer of a polymer of a polyether/vinyl monomer (may be any one of a random copolymer, a block copolymer, and a graft copolymer)] are preferable, a polymer or a copolymer of a vinyl monomer, at least one selected from a group consisting of an ester-based polymer, an ether-based polymer, and an urethane-based polymer, and modified products thereof or copolymers thereof are more preferable, a polymer or a copolymer of a vinyl monomer is particularly preferable.

It is preferable that a polymer chain $P^1$ contains at least one repeating unit.

In the polymer chain $P^1$, in view of exhibiting three dimensional repulsion forces, increasing dispersibility, and achieving a high refractive index and low viscosity, the number of repetition k of at least one repeating units is preferably 3 or greater and more preferably 5 or greater.

In view of achieving low viscosity of a composition, further causing particles to densely exist in a cured film (transparent film), and achieving a high refractive index, the number of repeating k of at least one repeating units is preferably 50 or less, more preferably 40 or less, and even more preferably 30 or less.

The polymer is preferably soluble to an organic solvent.

The vinyl monomer is not particularly limited, and a vinyl monomer having (meth)acrylic acid esters, crotonic acid esters, vinyl esters, maleic acid diesters, fumaric acid diesters, itaconic acid diesters, (meth)acrylamides, styrenes, vinyl ethers, vinyl ketones, olefins, maleimides, (meth)acrylonitrile, an acid group, or the like is preferable.

These preferable examples of the vinyl monomer include vinyl monomers disclosed in paragraphs 0089 to 0094, 0096, and 0097 of JP2007-277514A (paragraphs 0105 to 0117, 0119, and 0120 of corresponding US2010/233595A), and the contents thereof are incorporated into this specification.

In addition to the compound above, for example, a vinyl monomer having a functional group such as an urethane group, an urea group, a sulfonamide group, a phenol group, or an imide group can be used. This monomer having a urethane group or a urea group can be appropriately synthesized by addition reaction of an isocyanate group and a hydroxyl group, or an isocyanate group and an amino group. Specifically, this monomer can be appropriately synthesized by addition reaction of an isocyanate group-containing monomer with a compound containing one hydroxyl group or a compound containing one primary or secondary amino group, or addition reaction of a hydroxyl group-containing monomer or a primary or secondary amino group-containing monomer with monoisocyanate.

Among the resin represented by Formula (1), a resin represented by Formula (2) below is preferable.

$$\left(A^2-R^4-S\right)_n R^3 \left(S-R^5-P^2\right)_m \qquad \text{Formula (2)}$$

In Formula (2), $A^2$ has the same meaning as $A^1$ in Formula (1), and preferable forms thereof are the same. n of $A^2$'s may be identical to or different from each other.

In Formula (2), $R^4$ and $R^5$ each independently represent a single bond or a divalent linking group. n of $R^4$'s may be identical to or different from each other. m of $R^5$'s may be identical to or different from each other.

As the divalent linking group represented by $R^4$ and $R^5$, the same groups that are exemplified as the divalent linking group represented by $R^2$ of Formula (1) are used, and preferable forms thereof are the same.

In Formula (2), $R^3$ represents an (m+n)-valent linking group. m+n satisfies 3 to 10.

Examples of a (m+n)-valent linking group represented by $R^3$ include a group which may contain 1 to 60 carbon atoms, 0 to 10 nitrogen atoms, 0 to 50 oxygen atoms, 1 to 100 hydrogen atoms, or 0 to 20 sulfur atoms, and the (m+n)-valent linking group may be non-substituted or may further have a substituent.

As a (m+n)-valent linking group represented by $R^3$, specifically, the same groups that are exemplified as the (m+n)-valent linking group represented by $R^1$ of Formula (1) are used, and preferable forms thereof are the same.

In Formula (2), m represents a positive number of 8 or less. m is preferably 0.5 to 5, more preferably 1 to 4, and particularly preferably 1 to 3.

In Formula (2), n represents 1 to 9. n is preferably 2 to 8, more preferably 2 to 7, and particularly preferably 3 to 6.

$P^2$ in Formula (2) represents a polymer chain, and can be selected from well-known polymers or the like, according to the purpose. m of $P^2$'s may be identical to or different from each other. Preferable forms of the polymer are the same as $P^1$ in Formula (1).

Among high molecular compounds represented by Formula (2), those in which all of $R^3$, $R^4$, $R^5$, $P^2$, m, and n described below are most preferable.

$R^3$: Specific Examples (1), (2), (10), (11), (16), or (17) of the (m+n)-valent linking group

$R^4$: A single bond or a group formed by being combined with a divalent linking group that is formed by being combined with a structural unit below or the structural unit above and that may contain "1 to 10 carbon atoms, 0 to 5 nitrogen

atoms, 0 to 10 oxygen atoms, 1 to 30 hydrogen atoms, or 0 to 5 sulfur atoms" (may have a substituent, and examples of the substituent include an alkyl group having 1 to 20 carbon atoms such as a methyl group or an ethyl group, an aryl group having 6 to 16 carbon atoms such as a phenyl group or a naphthyl group, an acyloxy group having 1 to 6 carbon atoms such as a hydroxyl group, an amino group, a carboxyl group, a sulfonamide group, an N-sulfonyl amide group, or an acetoxy group, an alkoxy group having 1 to 6 carbon atoms such as a methoxy group or an ethoxy group, a halogen atom such as a chlorine atom or a bromine atom, an alkoxycarbonyl group having 2 to 7 carbon atoms such as a methoxycarbonyl group, an ethoxycarbonyl group, or a cyclohexyloxycarbonyl group, or a carbonic acid ester group such as a cyano group or a t-butyl carbonate group.)

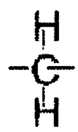 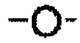 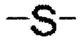 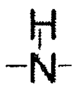 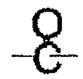 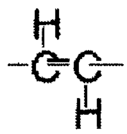 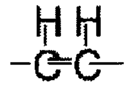

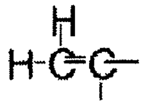 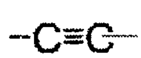 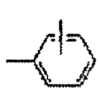 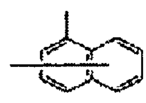 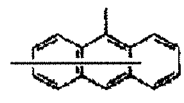

$R^5$: A single bond, an ethylene group, a propylene group, a group (a) below, or a group (b) below

In the groups below, $R^{12}$ represents a hydrogen atom or a methyl group, 1 represents 1 or 2.

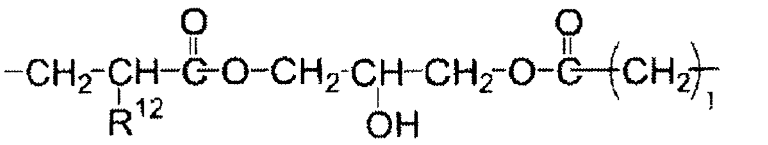 (a)

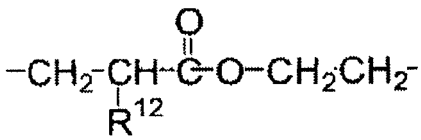 (b)

$P^2$: A polymer or a copolymer of a vinyl monomer, an ester-based polymer, an ether-based polymer, a urethane-based polymer, and modified products thereof

m: 1 to 3

n: 3 to 6

(Second embodiment)

In the second embodiment, a resin included in a high refractive composition is a resin including a graft copolymer.

The number of atoms of the graft copolymer except for hydrogen atoms for one graft chain is preferably 40 to 10,000, more preferably 100 to 500, and further preferably 150 to 260.

As a polymer structure of a graft chain is a poly(meth)acryl structure, a polyester structure, a polyurethane structure, a polyurea structure, a polyamide structure, a polyether structure, and the like can be used.

With respect to the resin including the graft copolymer, disclosure in paragraphs 0080 to 0126 disclosed in JP2014-063125A can be referred to, and the contents thereof are incorporated into this specification.

(Third embodiment)

In the third embodiment, a resin included in a high refractive composition is an oligoimine-based resin including a nitrogen atom in at least one of a main chain or a side chain. As an oligoimine-based resin, a resin that includes a repeating unit having a partial structure X having a functional group having pKa of 14 or less and a side chain Y having 40 to 10,000 atoms and having a basic nitrogen atom on a main chain or a side chain is preferable.

With respect to the oligoimine-based resin, for example, disclosure in paragraphs 0225 to 0267 of JP2014-063125A can be referred to, and the contents thereof are incorporated into this specification.

(Fourth embodiment)

In a fourth embodiment, the resin included in the high refractive composition is a siloxane resin obtained by hydrolyzing a silane compound including a silane compound represented by any one of Formulae (2) to (4) and performing condensation reaction on this hydrolysate.

$$R^0_{2-n}R^1_nSi(OR^9)_2 \qquad \text{Formula (2)}$$

In Formula (2), $R^0$ represents a hydrogen, an alkyl group, an alkenyl group, or a phenyl group. $R^1$ represents a monovalent condensed polycyclic aromatic group. $R^9$ represents a hydrogen, a methyl group, an ethyl group, a propyl group, or a butyl group and may be identical or different from each other. n represents 1 or 2. In a case where n is 2, plural $R^1$'s may be identical or different from each other.

$$R^2Si(OR^{10})_3 \qquad \text{Formula (3)}$$

In Formula (3), $R^2$ represents a monovalent condensed polycyclic aromatic group. $R^{10}$ represents a hydrogen, a methyl group, an ethyl group, a propyl group, or a butyl group, and may be identical to or different from each other.

$$(R^{11}O)_mR^4_{3-m}Si\text{-}R^3\text{-}Si(OR^{12})_1R^5_{3-1} \qquad \text{Formula (4)}$$

In Formula (4), $R^3$ represents a divalent condensed polycyclic aromatic group. $R^4$ and $R^5$ each independently represent a hydrogen, an alkyl group, an alkenyl group, and an aryl group, and may be identical to or different from each other. $R^{11}$ and $R^{12}$ each independently represent a hydrogen, a methyl group, an ethyl group, a propyl group, or a butyl group, and may be identical to or different from each other. m and 1 each independently represent an integer of 1 to 3.

With respect to the siloxane resins, for example, disclosure in paragraphs 0017 to 0044 of JP2010-007057A can be referred to, and the contents thereof are incorporated into this specification.

The high refractive composition preferably includes an epoxy resin.

Examples of commercially available products of the epoxy resin include JER827, JER828, JER834, JER1001, JER1002, JER1003, JER1055, JER1007, JER1009, and JER1010 (above, manufactured by Japan Epoxy Resins Co., Ltd.), EPICLON860, EPICLON1050, EPICLON1051, and EPICLON1055 (above, manufactured by DIC Corporation), as a bisphenol A-type epoxy resin, include JER806, JER807, JER4004, JER4005, JER4007, and JER4010 (above, manufactured by Japan Epoxy Resins Co., Ltd.), EPICLON830 and EPICLON835 (above, manufactured by DIC Corporation), LCE-21 and RE-602S (above, manufactured by Nippon Kayaku Co., Ltd.), as a bisphenol F-type epoxy resin, include JER152, JER154, JER157S70, and JER157S65 (above, manufactured by Japan Epoxy Resins Co., Ltd.), EPICLON N-740, EPICLON N-770, EPICLON N-775(above, manufactured by DIC Corporation), as a phenolic novolak-type epoxy resin, include EPICLON N-660, EPICLON N-665, EPICLON N-670, EPICLON N-673, EPICLON N-680, EPICLON N-690, and EPICLON N-695 (above, manufactured by DIC Corporation), and EOCN-1020 (above, manufactured by Nippon Kayaku Co., Ltd.) as a cresol novolak-type epoxy resin, and include ADEKA RESIN EP-4080S, ADEKA RESIN EP-4085S, ADEKA RESIN EP-4088S (above, manufactured by ADEKA Corporation), CELLOXIDE 2021P, CELLOXIDE 2081, CELLOXIDE 2083, CELLOXIDE 2085, EHPE3150, EPOLEAD PB 3600, and EPOLEAD PB 4700 (above, manufactured by Daicel Corporation), DENACOL EX-211L, EX-212L, EX-214L, EX-216L, EX-321L, and EX-850L (above, Nagase Chemtex Corporation) as an aliphatic epoxy resin. Examples thereof also include ADEKA RESIN EP-4000S, ADEKA RESIN EP-4003S, ADEKA RESIN EP-4010S, and ADEKA RESIN EP-4011S (above, manufactured by ADEKA Corporation), NC-2000, NC-3000, NC-7300, XD-1000, EPPN-501, and EPPN-502 (above, manufactured by ADEKA Corporation), and JER1031S (manufactured by Japan Epoxy Resins Co., Ltd.).

The molecular weight of the resin is preferably 2,000 to 200,000, more preferably 2,000 to 15,000, and further preferably 2,500 to 10,000 by a weight-average molecular weight.

The amount of the resin in the high refractive composition is preferably 0.5 mass% or greater, more preferably 1 mass% or greater, and further preferably 2 mass% or greater. The upper limit is preferably 30 mass% or less, more preferably 20 mass% or less, and further preferably 15 mass% or less.

The concentration of the solid content of the resin in the high refractive composition (the concentration of the resin with respect to a total solid content (mass%)) is preferably 5 mass% or greater, more preferably 8 mass% or greater, and further preferably 10 mass% or greater. The upper limit is preferably 40 mass% or less, more preferably 35 mass% or less, and further preferably 30 mass% or less.

Only one type of the resin may be included, and two or more types thereof may be included. In a case where two or more types thereof are included, it is preferable that a total amount is in the range described above.

<<<Particles>>>

The particles included in the high refractive composition preferably include metal oxide particles.

The metal oxide particles are preferably colorless, white, or transparent inorganic particles having a high refractive index, examples thereof include oxide particles of titanium (Ti), zirconium (Zr), aluminum (Al), silicon (Si), zinc (Zn), or magnesium (Mg), titanium dioxide ($TiO_2$) particles, zirconium dioxide ($ZrO_2$) particles are preferable, and titanium dioxide particles more preferable.

With respect to the metal oxide particles, a lower limit of a primary particle diameter is preferably 1 nm or longer, and an upper limit is preferably 100 nm or less, more preferably 80 nm or less, and further preferably 50 nm or less. As an index of the primary particle diameter, an average particle diameter can be used. The average particle diameter of the metal oxide particles refers to a value obtained by diluting mixture liquid or dispersion liquid including metal oxide particles to 80 times with propylene glycol monomethyl ether acetate and measuring the obtained diluent by a dynamic light scattering method. This measurement is performed as a number-average particle diameter obtained by MICROTRAC UPA-EX150 manufactured by Nikkiso Co., Ltd.

With respect to the metal oxide particles, disclosure in paragraphs 0023 to 0027 of JP2014-062221A is referred to, and the contents thereof are incorporated into this specification.

As the metal oxide particles, it is possible to use commercially available products such as HPW-10R, HPW-18R, HPW-18NR, HPW-25R, and HPW-30NRD manufactured by JGC Catalysts And Chemicals Ltd..

In addition to metal oxide particles, it is possible to use commercially available organic particles or a high refractive composition. Examples thereof include HYPERTECH series manufactured by Nissan Chemical Industries, Ltd., CS-series and VF & PV-series manufactured by Toray Industries, Inc., as commercially available products.

The amount of the particles in the high refractive composition is preferably 10 mass% or greater, more preferably 15 mass% or greater, and further preferably 20 mass% or greater. The upper limit is not particularly limited, but preferably 40 mass% or less and more preferably 30 mass% or less.

The concentration of the solid content of the particles in the high refractive composition (the concentration of the particles with respect to a total solid content (mass%)) is preferably 60 mass% or greater and more preferably 70 mass% or greater. The upper limit is not particularly limited, but preferably 99 mass% or less, more preferably 95 mass% or less, and further preferably 90 mass% or less.

Only one type of particles may be included, and two or more types thereof may be included. In a case where two or more types thereof are included, it is preferable that a total amount is in the range described above.

<<<Solvent>>>

Examples of the solvent included in a high refractive composition include water or an organic solvent, and an organic solvent is preferable.

Examples of an organic solvent suitably include esters such as ethyl acetate, n-butyl acetate, isobutyl acetate, amyl formate, isoamyl acetate, butyl propionate, isopropyl butyrate, ethyl butyrate, butyl butyrate, methyl lactate, ethyl lactate, alkyl oxyacetate (for examples: methyl oxyacetate, ethyl oxyacetate, butyl oxyacetate (for example, methyl methoxyacetate, ethyl methoxyacetate, butyl methoxyacetate, methyl ethoxyacetate, and ethyl ethoxyacetate)), 3-oxypropionic acid alkyl esters (for examples: methyl 3-oxypropionate and ethyl 3-oxypropionate (for example, methyl 3-methoxypropionate, ethyl 3-methoxypropionate, methyl 3-ethoxypropionate, and ethyl 3-ethoxypropionate)), 2-oxypropionic acid alkyl esters (for examples: methyl 2-oxypropionate, ethyl 2-oxypropionate, and propyl 2-oxypropionate (for example, methyl 2-methoxypropionate, ethyl 2-methoxypropionate, propyl 2-methoxypropionate, methyl 2-ethoxypropionate, and ethyl 2-ethoxypropionate)), methyl 2-oxy-2-methylpropionate and ethyl 2-oxy-2-methylpropionate (for example, methyl 2-methoxy-2-methylpropionate and ethyl 2-ethoxy-2-methylpropionate), methyl pyruvate, ethyl pyruvate, propyl pyruvate, methyl acetoacetate, ethyl acetoacetate, methyl 2-oxobutanoate, and ethyl 2-oxobutanoate; ethers such as diethylene glycol dimethyl ether, dipropylene glycol dimethyl ether, tetrahydrofuran, ethylene glycol monomethyl ether, ethylene glycol monoethyl ether, methylcellosolve acetate, ethylcellosolve acetate, diethylene glycol monomethyl ether, diethylene glycol monoethyl ether, diethylene glycol monobutyl ether, propylene glycol monomethyl ether (PGME), propylene glycol mono-n-butyl ether, propylene glycol monotert-butyl ether, propylene glycol monomethyl ether acetate (PGMEA), propylene glycol monoethyl ether acetate, and propylene glycol monopropyl ether acetate; ketones such as methyl ethyl ketone, cyclohexanone, 2-heptanone, and 3-heptanone; and aromatic hydrocarbons such as toluene and xylene.

Particularly preferable examples thereof include methyl 3-ethoxypropionate, ethyl 3-ethoxypropionate, ethylcellosolve acetate, ethyl lactate, diethylene glycol dimethyl ether, butyl acetate, methyl 3-methoxypropionate, 2-heptanone, cyclohexanone, ethylcarbitol acetate, butylcarbitol acetate, propylene glycol methyl ether, dipropylene glycol dimethyl ether, propylene glycol mono-n-butyl ether, propylene glycol monotert-butyl ether, and propylene glycol methyl ether acetate. As the solvent, a content of peroxide is preferably 0.8 mmol/L or less, and a solvent not substantially

including peroxide is preferably used.

With respect to other solvents included in the high refractive composition, for example, disclosure in paragraphs 0065 to 0067 of JP2014-063125A can be referred to, and the contents thereof are incorporated into this specification.

The amount of the solvent in the high refractive composition is preferably 50 mass% or greater and more preferably 60 mass% or greater in the total amount of the composition. In the total amount of the composition, the upper limit is preferably 99.9 mass% or less, more preferably 95 mass% or less, and further preferably 90 mass% or less.

Only one type of the solvent may be included, and two or more types thereof may be included. In a case where two or more types thereof are included, the total amount is in the range described above.

<<<Surfactant>>>

In view of improving coating properties, the high refractive composition may contain various surfactants. As the surfactant, various surfactants such as a fluorine-based surfactant, a nonionic surfactant, a cationic surfactant, an anionic surfactant, and a silicone-based surfactant can be used. A fluorine-based surfactant is preferable. In a case where a film is formed by using a coating liquid composed of a composition containing a fluorine-based surfactant, interfacial tension between the coated surface and the coating liquid is reduced such that wettability to the coated surface is improved, and thus the coating properties to the coated surface is improved. Therefore, a film that has small thickness unevenness and a homogeneous thickness can be more suitably formed.

With respect to the fluorine-based surfactant, a fluorine content is preferably 3 to 40 mass%, more preferably 5 to 30 mass%, and even more preferably 7 to 25 mass%. The fluorine-based surfactant having a fluorine content in this range is effective in view of evenness of thickness of a coated film or liquid saving properties and solubility in the composition is good.

Examples of the fluorine-based surfactant include MEGAFACE F-171, MEGAFACE F-172, MEGAFACE F-173, MEGAFACE F-176, MEGAFACE F-177, MEGAFACE F-141, MEGAFACE F-142, MEGAFACE F-143, MEGAFACE F-144, MEGAFACE R-30, MEGAFACE F-437, MEGAFACE F-475, MEGAFACE F-479, MEGAFACE F-482, MEGAFACE F-554, MEGAFACE F-780, and MEGAFACE F-781(above, manufactured by DIC Corporation), FLUORAD FC430, FLUORAD FC431, and FLUORAD FC171 (above, manufactured by Sumimoto 3M Limited), and SURFLON S-382, SURFLON SC-101, SURFLON SC-103, SURFLON SC-104, SURFLON SC-105, SURFLON SC-1068, SURFLON SC-381, SURFLON SC-383, SURFLON S-393, and SURFLON KH-40 (above, manufactured by Asahi Glass Co., Ltd.), PF636, PF656, PF6320, PF6520, and PF7002 (OMNOVA Solutions Inc.).

Compounds below are also exemplified as the fluorine-based surfactant used in the invention.

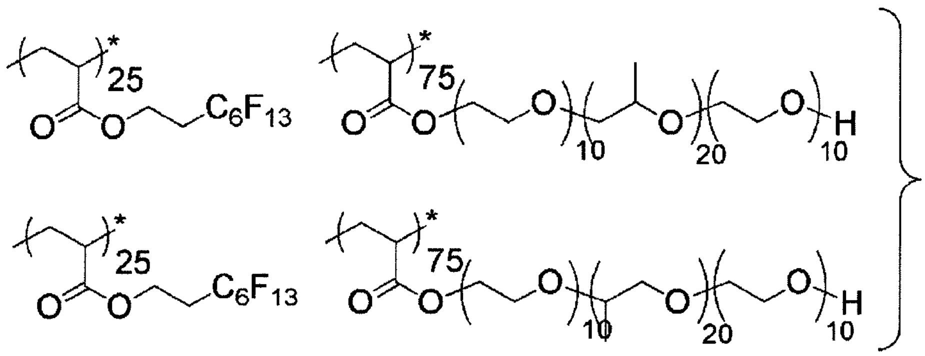

Mixture

The weight-average molecular weight is, for example, 14,000.

As the fluorine-based surfactant, a block polymer can be used, and specific examples thereof include compounds disclosed in JP2011-89090A.

Specific examples of the nonionic surfactant include glycerol, trimethylol propane, trimethylol ethane, and ethoxylates and propoxylates thereof (for example, glycerol propoxylate or glycerin ethoxylate), polyoxyethylene lauryl ether, polyoxyethylene stearyl ether, polyoxyethylene oleyl ether, polyoxyethylene octyl phenyl ether, polyoxyethylene nonyl phenyl ether, polyethylene glycol dilaurate, polyethylene glycol distearate, and sorbitan fatty acid esters (PLURONIC L10, L31, L61, L62, 10R5, 17R2, and 25R2, TETRONIC 304, 701, 704, 901, 904, and 150R1 manufactured by BASF SE, and SOLSPERSE 20000 (manufactured by Lubrizol Japan Limited)).

Specific examples of the cationic surfactant include a phthalocyanine derivative (product name: EFKA-745, manufactured by Morishita & Co., Ltd.), an organosiloxane polymer KP341 (manufactured by Shin-Etsu Chemical Co., Ltd.), a (meth)acrylic (co)polymer POLYFLOW No. 75, No. 90, and No. 95 (manufactured by Kyoeisha Chemical Co., Ltd.), and W001 (manufactured by Yusho Co., Ltd.).

Specific examples of the anionic surfactant include W004, W005, and W017 (manufactured by Yusho Co., Ltd.).
Examples of the silicone-based surfactant include TORAY SILICONE DC3PA, TORAY SILICONE SH7PA, TORAY SILICONE DC11PA, TORAY SILICONE SH21PA, TORAY SILICONE SH28PA, TORAY SILICONE SH29PA, TORAY SILICONE SH30PA, and TORAY SILICONE SH8400 (above, manufactured by Dow Corning Toray Co., Ltd.), TSF-4440, TSF-4300, TSF-4445, TSF-4460, and TSF-4452 (above, manufactured by Momentive Performance Materials Inc.), KP341, KF6001, manufactured by KF6002 (above, Shin-Etsu Chemical Co., Ltd.), BYK307, BYK323, and BYK330 (above, BYK Japan KK).
Only one type of the surfactant may be used, and two or more types thereof may be used in combination.
The content of the surfactant is preferably 0.001 to 2.0 mass% and more preferably 0.005 to 1.0 mass% with respect to the total mass of the composition.

«Polymerization inhibitor»

The high refractive composition may contain a polymerization inhibitor.
Examples of the polymerization inhibitor include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and N-nitrosophenylhydroxyamine cerous salt. Among these, p-methoxyphenol is preferable.
The addition amount of the polymerization inhibitor is preferably 0.001 to 5 mass% with respect to the total mass of the composition.

<<<Other additives>>>

The high refractive composition may include other additives. Specific examples thereof include a hardening agent, a polymerizable compound, a polymerization initiator, resins other than the resins described above (for example, an alkali-soluble resin or a binder), a plasticizer, an oil-sensitizing agent, or an ultraviolet absorbing agent.
As the alkali-soluble resin, for example, a benzyl (meth)acrylate/(meth)acrylic acid copolymer, a benzyl (meth)acrylate/(meth)acrylic acid/2-hydroxyethyl (meth)acrylate copolymer, a multi-component copolymer consisting of benzyl (meth)acrylate/(meth)acrylic acid /other monomers can be preferably used. A compound obtained by copolymerizing 2-hydroxyethyl (meth)acrylate, and a 2-hydroxypropyl (meth)acrylate/polystyrene macro monomer/benzyl methacrylate/methacrylic acid copolymer, a 2-hydroxy-3-phenoxypropyl acrylate/polymethyl methacrylate macro monomer/benzyl methacrylate/methacrylic acid copolymer, a 2-hydroxy ethyl methacrylate/polystyrene macro monomer/methyl methacrylate/methacrylic acid copolymer, and a 2-hydroxyethyl methacrylate/polystyrene macro monomer/benzyl methacrylate/methacrylic acid copolymer that are disclosed in JP1995-140654A (JP-H07-140654A) can be preferably used. An alkali-soluble resin described in an infrared ray transmission composition described below can be used.
As these additives, for example, disclosure of paragraphs 0133 to 0224 in JP2014-063125A is referred to, and the contents thereof are incorporated into this specification.
Metal elements may be included in the high refractive composition, depending on raw materials used. However, in view of defect generation suppression, a content of a second group element (calcium, magnesium, or the like) in the high refractive composition is preferably 50 ppm or less and is preferably suppressed to 0.01 to 10 ppm. A total amount of inorganic metal salt in the high refractive composition is preferably 100 ppm or less, and is more preferably suppressed to 0.5 to 50 ppm.

<<Specific examples of high refractive composition>>

Specific examples of the high refractive composition include dispersion compositions disclosed in claim 1 of JP2014-62221A; siloxane-based resin compositions disclosed in JP2010-007057A, JP2010-222431A, JP2009-263507A, JP2008-202033A, JP2012-087316A, and claim 1 of JP2007-246877A; and compositions disclosed in claims of WO2010/125949, WO2010/128661, WO2011/018990, WO2012/026451, WO2012/026452, WO2012/060286, and WO2012/111682 and these contents thereof are incorporated into this specification. Preferable ranges of these compositions are provided as examples of the preferable ranges of the high refractive composition according to the invention.
According to the invention, commercially available curable resins can be also suitably used. Product names (model numbers) thereof are provided below.

(1) Coating material with an ultra-high refractive index and high heat resistance: UR-108, UR-202, UR-501, and HR-102 (manufactured by Nissan Chemical Industries, Ltd.)
(2) Coating material with a high refractive index for a thick film: UR-108, UR-204, and HR-201 (manufactured by Nissan Chemical Industries, Ltd.)

(3) Thioepoxy resin LPH1101 (manufactured by Mitsubishi Gas Chemical Company, Inc.)
(4) Episulfide resin MR-174 (manufactured by Mitsui Chemicals, Inc.)
(5) Thiourethane resin MR-7 (manufactured by Mitsui Chemicals, Inc.)

<<Film thickness>>

The film thickness of the high refractive area is appropriately determined so as to achieve a desired optical path of light. For example, the film thickness is 80 nm or longer, can be 100 nm or longer, and can be 120 nm or longer. For example, the upper limit is 600 nm or less, can be 500 nm or less, and can be 300 nm or less.

<Second area (low refractive layer)>

The second area according to the invention is preferably an area having a lower refractive index by 0.5 or greater than the first area. The refractive index of the second area (low refractive area) is preferably 1.0 to 1.5, more preferably 1.0 to 1.3, and even more preferably 1.1 to 1.3.

A suitable form of the second area is a layer including a resin. The layer including a resin may be a layer consisting of a so-called low refractive resin, that is, a resin having a lower refractive index than the high refractive resin above and may be formed by applying a composition (hereinafter, also referred to as a "low refractive composition") including a resin, particles, and a solvent. The resin used for forming the second area is preferably a compound having a polymer chain consisting of a repeating unit derived from a polymerizable monomer or a polymer chain consisting of a repeating unit derived from a polymerizable monomer as a partial structure. Preferably, the second area is a layer formed by applying a low refractive composition.

Another suitable form of the second area is a layer including particles. The layer including particles may be formed by applying a composition including particles and a solvent. The layer including the particles may include a resin or may not include a resin.

Hereinafter, details of the low refractive composition are described.

<<Low refractive composition>>

<<<Resin>>>

As the resin used in the low refractive area, a resin including at least one of a siloxane resin or a fluorine-containing resin is exemplified.

<<<<Siloxane resin>>>>

The siloxane resin can be obtained by an alkoxysilane raw material via hydrolysis reaction and condensation reaction. Specifically, the siloxane resin is a resin in which a portion or all of alkoxy groups in alkyl trialkoxysilane is hydrolyzed and converted to silanol groups, and at least a portion of the generated silanol groups is condensed to form Si-O-Si bonds. The siloxane resin is preferably a resin having a silsesquioxane structure represented by Formula (5) below.

$$-(R^1SiO_{3/2})_n- \qquad \text{Formula (5)}$$

In Formula (5), $R^1$ represents an alkyl group having 1 to 3 carbon atoms. n represents an integer of 20 to 1,000.

<<<<Fluorine-containing resin>>>>

The fluorine-containing resin is a resin containing fluorine in a molecule, and specific examples thereof include polytetrafluoroethylene, polyhexafluoropropylene, a tetrafluoroethylene/hexafluoropropylene copolymer, a tetrafluoroethylene/perfluoroalkyl vinyl ether copolymer, a tetrafluoroethylene/ethylene copolymer, a hexafluoropropylene/propylene copolymer, polyvinylidene fluoride, and a vinylidene fluoride/ethylene copolymer.

For example, with respect to details of the siloxane resin and fluorine-containing resin, for example, disclosure in paragraphs 0014 to 0060 of JP2014-063125A can be referred to, and the contents thereof are incorporated into this specification.

According to the invention, with respect to the resins included in the low refractive composition, hydrolysates by predetermined silicon compounds disclosed in paragraph numbers 0016 to 0024 of JP2013-253145A and compounds disclosed in paragraph numbers 0030 to 0043 of JP2012-0214772A are referred to, and the contents thereof are incorporated into this specification.

The amount of the resin in the low refractive composition is preferably 0.5 mass% or greater, more preferably 1 mass% or greater, and further preferably 2 mass% or greater. The upper limit is preferably 30 mass% or less, more preferably 20 mass% or less, and further preferably 15 mass% or less.

The concentration of the solid content of the resin in the low refractive composition (the concentration of the resin with respect to a total solid content (mass%)) is preferably 5 mass% or greater, more preferably 8 mass% or greater, and further preferably 10 mass% or greater. The upper limit is preferably 40 mass% or less, more preferably 35 mass% or less, and further preferably 30 mass% or less.

Only one type of the resin may be included, or two or more types thereof may be included. In a case where two or more types thereof are included, it is preferable that a total amount is in the range described above.

<<<Particles>>>

Examples of the particles used in the low refractive area include hollow particles or non-hollow particles. As the hollow particles, particles in a hollow structure or porous fine particles may be used. The hollow particles are particles in a structure of having hollows inside, and refer to particles having surrounded hollows on outer shells, and the porous particles refer to porous particles having a large number of hollows. Hereinafter, the hollow particles or the porous particles are appropriately referred to as "specific particles". The specific particles may be organic particles or may be inorganic particles. The particles are preferably metal oxide particles and more preferably silica particles.

With respect to the particles used in the low refractive area, for example, disclosure in paragraphs 0047 to 0055 of JP2014-063125A is referred to, and the contents thereof are incorporated into this specification.

As the silica particles, commercially available products can be used, and examples thereof include OSCAL series manufactured by JGC Catalysts And Chemicals Ltd., QUARTRON series manufactured by Fuso Chemical Co., Ltd., SG-SO100 manufactured by KCM Corporation, REOLOSIL series manufactured by Tokuyama Corporation, THRULYA manufactured by JGC Catalysts And Chemicals Ltd., and SILINAX manufactured by Nittetsu Mining Co., Ltd.

A suitable form of the particles used in the low refractive area include a moniliform particles, and a moniliform silica (moniliform colloidal silica) is more preferable.

The moniliform particles refer to particles that have shapes of being linked and/or branched in a rosary shape. Specific examples thereof include particles having a chain shaped structure in which spherical particles (for example, colloidal silica) are linked to a rosary shape and particles in which linked colloidal silica is branched.

The moniliform particles cannot densely occupy spaces due to the steric hinderance and, as a result, it is possible to easily form an area having a higher void volume and thus the area can easily be caused to have a low refractive index.

As a silica particle liquid (sol) in which such moniliform silica particles are dispersed, for example, silica sol disclosed in JP4328935B can be used. It is possible to refer to disclosure of JP2013-253145A.

As a moniliform silica particle liquid, commercially available liquid sol can be used. Examples thereof include "SNOWTEX OUP", "SNOWTEX UP", "IPA-ST-UP", "SNOWTEX PS-M", "SNOWTEX PS-MO", "SNOWTEX PS-S", and "SNOWTEX PS-SO" manufactured by Nissan Chemical Industries, Ltd., "FINECATALOID F-120" manufactured by JGC Catalysts And Chemicals Ltd., HDK (Registered Trademark) V15, HDK (Registered Trademark) N20, HDK (Registered Trademark) T30, HDK (Registered Trademark) T40, hydrophobic HDK (Registered Trademark) H15, HDK (Registered Trademark) H18, HDK (Registered Trademark) H20, and HDK (Registered Trademark) H30 manufactured by Wacker Asahikasei Silicone Co., Ltd., and "QUARTRON PL" manufactured by Fuso Chemical Co., Ltd. It is preferable that these moniliform particles have a two dimensionally or three dimensionally curved structure due to a large number of primary particles consisting of silicon oxide are bonded to each other.

The amount of the particles in the low refractive composition is preferably 10 mass% or greater, more preferably 15 mass% or greater, and further preferably 20 mass% or greater. The upper limit is not particularly limited, but preferably 40 mass% or less and more preferably 30 mass% or less.

The concentration of the solid content of the particles in the low refractive composition (the concentration of the particles with respect to a total solid content (mass%)) is preferably 60 mass% or greater and more preferably 70 mass% or greater. The upper limit is not particularly limited, but preferably 99 mass% or less, more preferably 95 mass% or less, and further preferably 90 mass% or less.

Only one type of the particles may be included, and two or more types thereof may be included. In a case where two or more types thereof are included, it is preferable that a total amount is in the range described above.

<<<Solvent>>>

The solvent included in the low refractive composition is the same as the solvent (for example, water or an organic solvent) included in the high refractive composition, and preferable ranges and formulation amounts thereof are

also the same.

<<<Other additive>>>

The low refractive composition used in the invention may include other additives. Other additives are as described in the high refractive composition above and formulation amounts are also the same.

Metal elements may be included in the low refractive composition according to raw materials used. However, in view of defect generation suppression or the like, a content of second group elements (calcium, magnesium, or the like) in the low refractive composition is preferably 50 ppm or less and is preferably suppressed to 0.01 to 10 ppm. A total amount of inorganic metal salt in the low refractive composition is preferably 100 ppm or less, and is more preferably suppressed to 0.5 to 50 ppm.

<<Specific examples of low refractive composition>>

Specific examples of the low refractive composition include a curable composition for forming a low refractive film disclosed in claim 11 of JP2014-063125A, a siloxane-containing resin composition disclosed in claim 1 of JP2013-253145A, compositions for forming a low refractive index disclosed in WO2013/099948 (US2014/285695) and WO2013/099945 (US2014/284747), and the contents thereof are incorporated into this specification. Preferable ranges of these compositions are exemplified as preferable ranges of the high refractive composition according to the invention.

<<Film thickness>>

The film thickness of the low refractive area is appropriately determined so as to achieve a desired optical path of light, but for example, the film thickness is 80 nm or longer, can be 100 nm or longer, and can be 120 nm or longer. For example, the upper limit is 600 nm or less, can be 500 nm or less, and can be 300 nm or less.

<Method for manufacturing laminate>

The method for manufacturing the laminate according to the invention includes forming a first area by applying a first composition including particles, a resin, and a solvent and forming a second area by applying a second composition (or composition including particles and a solvent) including particles, a resin, and a solvent on a surface of the first area, and a difference between refractive indexes of the first area and the second area is 0.5 or greater. It is possible to preferably manufacture the laminate according to the invention by employing such a method. Particularly, the laminate according to the invention can be manufactured by application, and thus it is possible to improve productivity compared with the well-known laminates.

One of the first composition and the second composition is the high refractive composition described above, the other is the low refractive composition, and preferable ranges thereof are the same. Hereinafter, description is made by setting the first composition as the high refractive composition and the second composition as the low refractive composition. It is obvious that the first composition may set to be the low refractive composition, and the second composition may set to be the high refractive composition.

In a case where a high refractive area consists of one high refractive layer, a step of forming a high refractive area by applying a high refractive composition, the number of times of applying the high refractive composition is generally one time, but two or more high refractive layers may be formed by simultaneously or sequentially applying the high refractive composition. The coating method according to the invention is not particularly limited, but well-known coating methods can be appropriately applied. For example, a spraying method, a roll coating method, a rotation coating method (spin coating method), and a bar coating method can be applied. For example, in a case of spin coating coating, coating time for each high refractive layer can be 30 seconds to 3 minutes, and can be also 30 seconds to 2 minutes.

With respect to a coating amount, coating is preferably performed such that a film thickness after hardening becomes in a desired condition.

If necessary, a heating treatment or the like is preferably performed on the coated coated film, so as to remove a solvent included in the coated film. Specifically, it is preferable that post baking is performed after coating, so as to a portion or all of the solvent is volatilized. The post baking on the high refractive area is preferably performed at 100°C to 300°C for 30 seconds to 8 minutes, and more preferably performed at 150°C to 250°C for 1 to 5 minutes.

For the purpose of removing foreign substances or decreasing defects, the high refractive composition is preferably filtrated before coating. Anything that used for a filter in the related art can be used without limitation.

After the high refractive area is formed, a low refractive area is formed on the surface thereof by applying the low refractive composition. The low refractive area is formed in the same manner as the forming of the high refractive area, except for changing the high refractive composition to the low refractive composition, and the preferable range

thereof is also the same. However, the post baking of the low refractive area is preferably performed at 80°C to 240°C for 30 seconds to 8 minutes and more preferably performed at 80°C to 120°C for 1 to 5 minutes.

The laminate according to the invention can be obtained by alternately laminating the high refractive areas and the low refractive areas.

<Suitable forms of laminate>

A suitable form of the laminate has a first area formed by applying a first composition and a second area formed by applying a second composition on a surface of the first area, in which a difference between refractive indexes of the first area and the second area is 0.5 or greater, and the first areas and the second areas are alternately laminated, and an absolute value of a difference between an SP value (hereinafter, simply referred to as an "SP value") that is a solubility parameter of a solvent included in the first composition and an SP value that is a solubility parameter of a solvent included in the second composition is 2.0 or greater.

As described above, if an absolute value of a difference between an SP value of a solvent included in the first composition and an SP value of a solvent included in the second composition is a predetermined value or greater, when laminating is performed by alternately applying the first composition and the second composition, mixture between the first composition and the second composition is further suppressed in an interface formed between the first area and the second area, and variation of the thicknesses of respective formed areas is suppressed.

For example, in a case where an absolute value of a difference between the SP value of the solvent included in the first composition and the SP value of the solvent included in the second composition is less than a predetermined value, if the second composition is applied on the first area obtained by applying the first composition, a portion of components included in the first area that becomes an underlayer is dissolved in the second composition applied on the first area, due to influence of the solvent included in the second composition. Therefore, variation of the thicknesses of the first area or optical defects is generated, and as a result, optical characteristics of the obtained laminate are deteriorated in some cases.

In contrast, for example, in a case where an absolute value of a difference between the SP value of the solvent included in the first composition and the SP value of the solvent included in the second composition is a predetermined value or greater, if the second composition is applied on the first area obtained by applying the first composition, dissolution of components included in the first area that becomes the underlayer to the second composition is suppressed due to the difference of the SP values, and as a result, the generation of the variation of the thicknesses of the respective areas is suppressed, and also the generation of the optical defects is further suppressed.

An absolute value of the difference of the SP value of the solvent included in the first composition and the SP value of the solvent included in the second composition is preferably 0.5 $(cal/cm^3)^{1/2}$ or greater. However, since the variation of the thicknesses of the respective areas in the laminate becomes smaller and/or the generation of the optical defects in the laminate is further suppressed, the absolute value is more preferably 1.0 $(cal/cm^3)^{1/2}$ or greater, even more preferably 2.0 $(cal/cm^3)^{1/2}$ or greater, particularly preferably 5.0 $(cal/cm^3)^{1/2}$ or greater, and most preferably 7.0 $(cal/cm^3)^{1/2}$ or greater. The upper limit is not particularly limited, but the upper limit is generally 15 $(cal/cm^3)^{1/2}$ or less in many cases.

As the calculation method of the SP value of the solvent included in the first composition and the second composition, in a case where only one solvent is used, the SP value refers to an SP value of this solvent, and in a case where plural solvents are used together, the SP value represents a weight average value according to a mass ratio of SP values of the respective solvents. For example, in a case where a solvent X having an SP value of A and a solvent Y having an SP value of B is included respectively by 20 mass% and 80 mass% with respect to the total mass of the solvent, the SP value of the solvent can be obtained by a calculation expression of $(A\times0.2)+(B\times0.8)$.

In this specification, an SP value is calculated from a molecular structure based on the Fedors method (Polymer Engineering and Science, 1974, Vol. 4, No. 2). In the Fedors method, an SP value is calculated according to Equation (I) below.

$$\text{SP value } (\delta)=(\sum\Delta E/\sum\Delta V)^{1/2}[(cal/cm^3)^{1/2}] \ldots \qquad (I)$$

However, $\Delta E$ represents an evaporation energy (cal/mol) of atoms or atom groups included in a material, and $\Delta V$ represents a molar volume ($cm^3$/mol) of atoms or atom groups.

A form in which water is included in one of the first composition and the second composition, and the organic solvent is included in the other of the first composition and the second composition is preferable.

In this case of this form, it is preferable that water and the organic solvent satisfies the relationship between SP values above.

An organic solvent may be included in the first composition, water may be included in the second composition, water may be included in the first composition, and an organic solvent may be included in the second composition.

Types of the organic solvent included in one of the first composition and the second composition are not particularly limited, and an optimum organic solvent is appropriately selected according to the resin used. For example, examples of the organic solvent described above are exemplified.

When water is included in one of the first composition and the second composition, an organic solvent may further included in addition to water. That is, water and an organic solvent may be used together.

In a case where water and an organic solvent are used together, the content of water with respect to the total mass of water and the organic solvent is preferably 0.5 to 95 mass%, more preferably 10 to 90 mass%, and even more preferably 50 to 90 mass%, since variation of the thicknesses of the respective areas in the laminate becomes smaller and/or the generation of optical defects in the laminate is further suppressed.

In a case where water and an organic solvent are used together, the organic solvent may be used singly or two or more types thereof may be used in combination.

As described above, in a case where an absolute value of a difference between an SP value of a solvent included in the first composition and an SP value of a solvent included in the second composition is a predetermined value or greater, variation of thicknesses of the respective areas in the obtained laminate is small. That is, the thickness in the respective areas becomes more homogeneous, and a laminate exhibiting desired optical characteristics is easily obtained.

More specifically, since the laminate exhibits more excellent optical characteristics, a suitable form of the laminate includes a laminate in which two or more first areas and two or more second areas are provided, variation of the thicknesses of the respective first areas is less than 5% (preferably, within 3%), and variation of the thicknesses of the respective second areas is less than 5% (preferably, within 3%).

First, two or more first areas and two or more second areas are included in this laminate. Subsequently, in the two or more first areas, variation of the thicknesses in the respective areas is less than 5%. Since the laminate exhibits more excellent optical characteristics, the variation of the thicknesses is preferably within 3.0%, the variation of the thicknesses is more preferably within 2.0%, and even more preferably within 1.0%.

In the two or more second areas included in the laminate, variation of the thicknesses of the respective areas is less than 5%. Since the laminate exhibits more excellent optical characteristics, the variation of the thicknesses is preferably within 3.0%, the variation of the thicknesses is more preferably within 2.0% and even more preferably within 1.0%.

The variation of the thicknesses refers to variation of the thicknesses in one area. As the calculation method of the variation, thicknesses at positions of arbitrary 20 or more points in one area is measured with ELLIPSOMETER (VUV-vase [Product name] manufactured by J. A. Woollam Co., Inc.) (wavelength: 633 nm, measurement temperature: 25°C), and an average thickness $T_A$ is calculated by arithmetically averaging these. Subsequently, among the thicknesses measured described above, a greatest value $T_L$ and a smallest value $T_S$ are calculated, variation values in Formulae (1) and (2) are calculated, among obtained variations L and S, a variation of which an absolute value of a numerical value is greater is calculated as a variation of the thicknesses.

$$\text{Equation (1): Variation } L=(T_L-T_A)\times 100/T_A$$

$$\text{Equation (2): Variation } S=(T_S-T_A)\times 100/T_A$$

In the laminate above, the generation of the optical defects is further suppressed.

More specifically, since the laminate exhibits more excellent optical characteristics, a suitable form of the laminate includes a laminate in which the number of defects having a long diameter of 1 μm or greater is less than 50 defects/mm$^2$, when the laminate is observed with an optical microscope in the direction in which the first area and the second area are laminated (a plan view of the laminate). Among these, since the laminate exhibits more excellent optical characteristics, the number of the defects having a long diameter of 1 μm or greater is preferably less than 30 defects/mm$^2$.

First, as the method for measuring the number of defects, the laminate is observed in the direction in which the first area and the second area are laminated, with an optical microscope. As areas to be observed, different arbitrary five points (observation size of each point: 1 mmx 1 mm) are observed at a magnification of 200 times, and defects having a long diameter of 1 μm or greater are counted.

<Use of laminate>

As illustrated in Figs. 3A and 3B, the laminate according to the invention can be used as a film that cuts transmission of light in a specific wavelength range or transmits only light in a specific wavelength range. Specifically,

the laminate according to the invention can be preferably used as an infrared ray absorption filter, a bandpass filter, or the like.

<<Bandpass filter>>

The bandpass filter according to the invention may be made only with the laminate according to the invention, but it is preferably use another film that cuts transmission of light in a specific wavelength range or transmits only light in a specific wavelength range. Fig. 4 is a conceptual diagram illustrating an example of a relationship between a wavelength and transmittance, when the laminate according to the invention is combined with a film that cuts light in a specific wavelength range or transmits only light in a specific wavelength range. That is, two sheets of films respectively transmit light in different wavelength ranges. Also, if two films are used together, only light that can be transmitted by both of the films can be transmitted, and thus the films can be used as a bandpass filter. The laminate according to the invention can be used in both of the two films.

Specifically, if a laminate of which transmittance in a wavelength range of 450 to 950 nm is 70% or greater, and transmittance in a wavelength range of 1,050 to 1,100 nm is 30% or less, and an infrared ray transmission film of which transmittance in a wavelength range of 450 to 800 nm is 30% or less, and transmittance in a wavelength range of 900 to 1,100 nm is 70% or greater are used together, it is possible to obtain a bandpass filter of a film of which transmittance in a wavelength range of 900 to 950 nm is 70% or greater and transmittance in a wavelength range of 450 to 800 nm and 1,050 to 1,100 nm is 30% or less.

If a laminate of which transmittance in the range wavelength of 450 to 850 nm is 70% or greater, and transmittance in the range wavelength of 950 to 1,100 nm is 30% or less, and an infrared ray transmission film of which transmittance in the range wavelength of 450 to 750 nm is 30% or less, and transmittance in the range wavelength of 850 to 1,100 nm is 70% or greater are used together, it is possible to obtain a bandpass filter of a film of which transmittance in the range wavelength of 840 to 870 nm is 70% or greater and transmittance in the range wavelength of 450 to 750 nm and 950 to 1,050 nm is 30% or less.

If a laminate of which transmittance in the range wavelength of 450 to 700 nm is 70% or greater, and transmittance in the range wavelength of 750 to 1,000 nm is 30% or less, and an infrared ray transmission film of which transmittance in the range wavelength of 450 to 600 nm is 30% or less, and transmittance in the range wavelength of 700 to 1,100 nm is 70% or greater are used together, it is possible to obtain a bandpass filter of a film of which transmittance in the range wavelength of 680 to 720 nm is 70% or greater, and transmittance in the range wavelength of 450 to 600 nm and 750 to 1,000 nm is 30% or less.

The bandpass filter according to the invention preferably has the laminate according to the invention and an infrared ray transmission film.

<<<Infrared ray transmission film>>>

The infrared ray transmission film is a film that has high transmittance of an infrared ray at a predetermined wavelength and low transmittance of visible light at a predetermined wavelength. Here, examples of the infrared ray at a predetermined wavelength include electromagnetic waves in areas at a wavelength of 700 nm or longer, at a wavelength of 800 nm or longer, and at a wavelength of 900 nm or longer. Examples of the visible light at a predetermined wavelength include electromagnetic waves in areas at a wavelength of 650 nm or shorter, at a wavelength of 700 nm or shorter, and at a wavelength of 750 nm or shorter, and in areas at a wavelength of 400 nm or longer and at a wavelength of 450 nm or longer as a lower limit value. If the transmittance is high, the transmittance may be 70% or greater, further 80% or greater, and particularly 90% or greater, and if the transmittance is low, transmittance is 30% or less, further 20% or less, and particularly 10% or less.

The infrared ray transmission film can be obtained by applying a predetermined infrared ray transmission composition on a substrate and curing the predetermined infrared ray transmission composition. Hereinafter, examples of the infrared ray transmission composition are provided. The invention is not limited thereto.

[First embodiment of infrared ray transmission composition]

An infrared ray transmission composition according to the first embodiment contains a dye represented by Formula (A1), a polymerizable compound, and a polymerization initiator. The infrared ray transmission composition generally includes other coloring agents other than the dye represented by Formula (A1). In a case where the infrared ray transmission composition includes a pigment, a pigment is dispersed together with a dispersing agent, a solvent, pigment derivative, or the like, a pigment dispersion liquid is prepared, and the obtained pigment dispersion liquid may be mixed with the dye represented by Formula (A1), a polymerization initiator, and a polymerizable compound. The infrared ray transmission composition may further include other components (an alkali-soluble resin, a surfactant, or the

like) other than the components above.

Formula (A1)

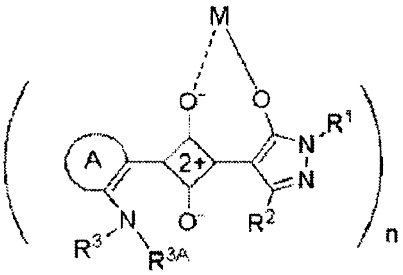

In Formula (A1), $R^1$ and $R^2$ each independently represent a hydrogen atom, a halogen atom, a cyano group, a nitro group, a carbonyl group having a substituent, an alkyl group, an aryl group, or a heterocyclic group. $R^3$ represents a hydrogen atom, a nitrogen atom, an alkyl group, an aryl group, or a heterocyclic group. $R^3$ may form a ring together with a substituent of A, and in a case where $R^3$ represents a nitrogen atom, $R^3$ may form a ring together with a substituent of A. $R^{3A}$ represents a hydrogen atom, an alkyl group, or an aryl group. A represents a heterocyclic 5-membered ring or a heterocyclic 6-membered ring. M represents a metal atom. n represents 2 or 3.

The total content of the dye represented by Formula (A1) in the infrared ray transmission composition is preferably 15 to 85 mass% and more preferably 20 to 80 mass%.

In the total coloring agents of the infrared ray transmission composition, the total content of the dye represented by Formula (A1) is preferably 4 to 50 mass% and more preferably 7 to 40 mass%.

Only one type of the dye represented by Formula (A1) may be included in the infrared ray transmission composition, or two or more types thereof may be included therein. In a case where two or more types thereof are included, the total content thereof is preferably in the range described above.

Examples of the other coloring agents other than the dye represented by Formula (A1) include pigments and dyes. The other coloring agent may be used singly or two or more types thereof may be used in combination. Examples of the other coloring agent include paragraphs 0019 to 0025 of JP2013-064999A, and the contents thereof are incorporated into this specification. Particularly, examples of the blue pigment include PB15:6. Examples of the yellow pigment include Pigment Yellow 139. Examples of the violet pigment include Pigment Violet 23.

The infrared ray transmission composition preferably includes a yellow pigment, a blue pigment, and a violet pigment, as the other coloring agents. In this case, in the infrared ray transmission composition, it is preferable that a mass ratio of a yellow pigment with respect to a total pigment is 0.1 to 0.2, a mass ratio of a blue pigment with respect to a total pigment is 0.25 to 0.55, and a mass ratio of a violet pigment with respect to a total pigment is 0.05 to 0.15. The mass ratio of the dye represented by Formula (A1) and the yellow pigment is preferably 85:15 to 50:50, and the mass ratio of the total mass of the dye represented by Formula (A1) and the yellow pigment and the total mass of the blue pigment and the violet pigment is more preferably 60:40 to 40:60.

For example, as the polymerizable compound, disclosure in paragraphs 0466 to 0494 of JP2012-208494A can be referred to, and the contents thereof are incorporated into this specification. The polymerizable compound may be used singly or two or more types thereof may be used in combination. In the case of formulation, the formulation amount of the polymerizable compound can be 0.1 to 90 mass% and preferably 2 to 50 mass% with respect to the solid content of the infrared ray transmission composition.

As the polymerization initiator, disclosure in paragraphs 0500 to 0547 of JP2012-208494A is referred to, and the contents thereof are incorporated into this specification. As the polymerization initiator, an oxime compound is preferable. As specific examples of the oxime compound, compounds disclosed in JP2001-233842A, compounds disclosed in JP2000-80068A, and compounds disclosed in JP2006-342166A can be used. Examples of the commercially available product include IRGACURE-OXE01 (manufactured by BASF SE), IRGACURE-OXE02 (manufactured by BASF SE), TR-PBG-304 (manufactured by Changzhou Tronly New Electronic Materials Co., Ltd.), ADEKA ARKLS NCI-831 and ADEKA ARKLS NCI-930 (manufactured by ADEKA Corporation). The polymerization initiator may be used singly or two or more types thereof may be used in combination. In the case of formulation, the formulation amount of the polymerization initiator can be 0.1 to 20 mass% and preferably 0.5 to 5 mass% with respect to the solid content of the infrared ray transmission composition. According to the invention, as the photopolymerization initiator, the oxime compound having a fluorine atom can be used. Specific examples of the oxime compound having a fluorine atom include compounds disclosed in JP2010-262028A, Compounds 24 and 36 to 40 of JP2014-500852A, and Compound (C-3) of JP2013-164471A. The contents thereof are incorporated into this specification.

For example, as the dispersing agent, disclosure in paragraphs 0404 to 0465 of JP2012-208494A is referred

to, and the contents thereof are incorporated into this specification. The dispersing agent may be used singly or two or more types thereof may be used in combination. In the case of formulation, the dispersing agent is preferably 1 to 80 parts by mass, more preferably 5 to 70 parts by mass, and even more preferably 10 to 60 parts by mass with respect to 100 parts by mass of the pigment.

For example, as the pigment derivative, disclosure in paragraphs 0124 to 0126 of JP2009-203462A is referred to, and the contents thereof are incorporated into this specification. The pigment derivative may be used singly or two or more types thereof may be used in combination. In the case of formulation, the pigment derivative is preferably 1 to 30 parts by mass, more preferably 3 to 20 parts by mass, and even more preferably 5 to 15 parts by mass with respect to 100 parts by mass of the pigment.

For example, as the solvent, paragraphs 0496 to 0499 disclosed in JP2012-208494A can be referred to, and the contents thereof are incorporated into this specification. The solvent may be used singly or two or more types thereof may be used in combination. As the formulation amount of the solvent, a concentration in which the concentration of the solid contents of the composition is 5 to 80 mass% is preferable.

For example, as the alkali-soluble resin, disclosure in paragraphs 0558 to 0572 of JP2012-208494A is referred to, and the contents thereof are incorporated into this specification.

The alkali-soluble resin preferably includes a polymer (a) obtained by polymerizing a monomer component necessarily including a compound represented by Formula (ED) below and/or a compound represented by Formula (ED2) (hereinafter, these compounds are referred to as "ether dimer").

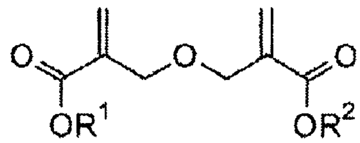

Formula (ED)

In Formula (ED), $R^1$ and $R^2$ each independently represent a hydrogen atom or a hydrocarbon group having 1 to 25 carbon atoms that may have a substituent.

Formula (ED2)

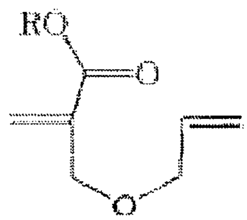

In Formula (ED2), R represents a hydrogen atom or an organic group having 1 to 30 carbon atoms. As specific examples of Formula (ED2), disclosure of JP2010-168539A can be referred to.

The alkali-soluble resin may be used singly and two or more types thereof may be used in combination. In the case of formulation, the formulation amount of the alkali-soluble resin is preferably 1 to 15 mass%, with respect to the solid content of the infrared ray transmission composition.

For example, as the surfactant, disclosure in paragraphs 0549 to 0557 of JP2012-208494A is referred to, and the contents thereof are incorporated into this specification. The surfactant may be used singly or two or more types thereof may be used in combination. In the case of formulation, the formulation amount of the surfactant is 0.001 to 2.0 mass% with respect to the solid content of the infrared ray transmission composition.

[Second embodiment of infrared ray transmission composition]

An infrared ray transmission composition according to the second embodiment includes a coloring agent and an alkali-soluble resin, at least a red pigment and at least one of a blue pigment represented by Formula (A2) or (A3) is included in the coloring agent, and a content of the red pigment is 20 to 50 mass%, and a content of the blue pigment

is 25 to 55 mass% with respect to the total coloring agent.

The infrared ray transmission composition preferably includes other coloring agents other than the blue pigment and the red pigment. The infrared ray transmission composition may further include a polymerizable compound, a polymerization initiator, a dispersing agent, a pigment derivative, and a solvent, as the other components other than the components.

The blue pigment is a compound represented by Formula (A2) or (A3).

Formula (A2)

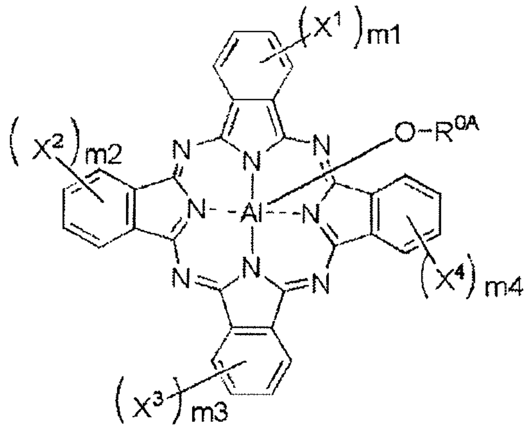

In Formula (A2), $X^1$ to $X^4$ each independently represent a substituent. $R^{0A}$ represents a hydrogen atom or a monovalent substituent. m1 to m4 each independently represent an integer of 0 to 4. When m1 to m4 are 2 or greater, $X^1$ to $X^4$ are respectively identical to or different from each other.

Formula (A3)

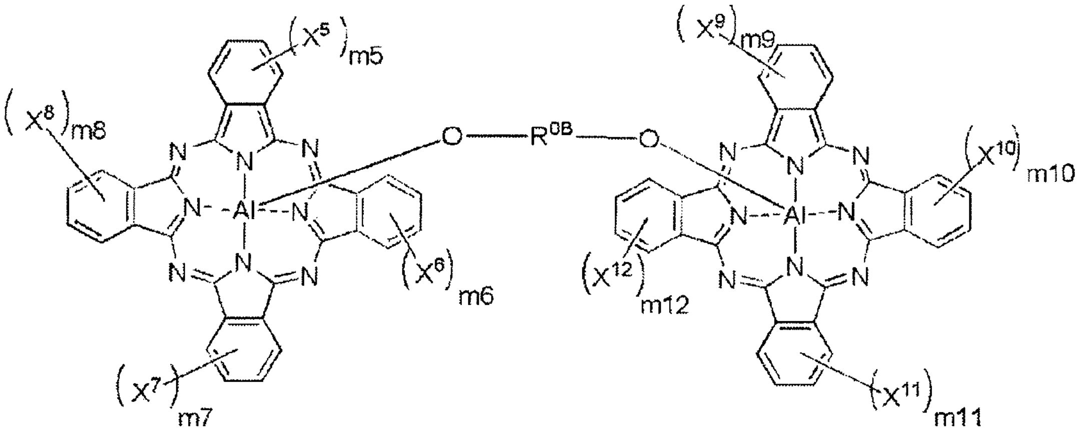

In Formula (A3), $X^5$ to $X^{12}$ each independently represent a substituent. $R^{0B}$ represents a divalent substituent. m5 to m12 each independently represent an integer of 0 to 4. When m5 to m12 are 2 or greater, $X^5$ to $X^{12}$ may be identical to or different from each other.

The red pigment preferably includes a red pigment in a symmetrical structure and a red pigment in an asymmetrical structure.

Particularly, it is preferable to include Color Index (C. I.) Pigment Red 254 and a compound that is a compound represented by Formula (A4) and that is not C. I. Pigment Red 254.

Formula (A4)

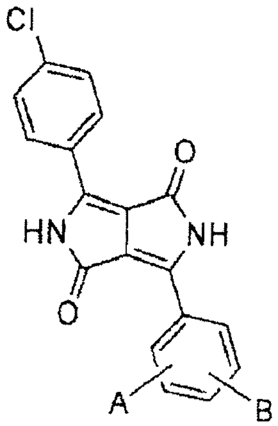

In Formula (A4), A and B each independently represent a hydrogen atom, a fluorine atom, a chlorine atom, a bromine atom, an alkyl group having 1 to 4 carbon atoms, an alkoxy group having 1 to 4 carbon atoms, a cyano group, $-CF_3$, or $-CON(R^1)R^2$. $R^1$ and $R^2$ each independently represent a hydrogen atom, an alkyl group having 1 to 20 carbon atoms, or a phenyl group.

In a case where a compound in a symmetrical structure and a compound in an asymmetrical structure are included in the red pigment, a mass ratio of the compound in the symmetrical structure and the compound in the asymmetrical structure is preferably 99:1 to 80:15 and more preferably 98:2 to 90:10.

As the other coloring agent, the other coloring agents according to the first embodiment described above can be used.

In the total coloring agents of the infrared ray transmission composition, the total content of the coloring agents other than the red pigment and the blue pigment is preferably 5 to 45 mass% and more preferably 15 to 35 mass%.

As the alkali-soluble resin, the alkali-soluble resins described in the first embodiment can be used, and preferable ranges thereof are also the same.

As the other component other than the above, the polymerizable compounds, the polymerization initiators, the dispersing agents, the pigment derivatives, the solvents, and the surfactants described in the first embodiment can be used. The preferable ranges thereof are the same as those according to the first embodiment.

[Third embodiment of infrared ray transmission composition]

An infrared ray transmission composition according to the third embodiment includes a coloring agent and a resin, and A/B that is a ratio of a minimum value A of absorbance in a wavelength range of 400 to 830 nm and a maximum value B of absorbance in a wavelength range of 1,000 to 1,300 nm is 4.5 or greater.

The condition of the absorbance may be achieved by any means. However, for example, the condition of the absorbance can be suitably achieved by causing the infrared ray transmission composition to contain one or more first coloring agents having absorption maximum in a wavelength range of 800 to 900 nm and two or more second coloring agents having absorption maximum in a wavelength range of 400 to 700 nm and by adjusting types and contents of the respective coloring agents.

The infrared ray transmission composition may contain the coloring agent (third coloring agent) other than the first coloring agent and the second coloring agent.

The infrared ray transmission composition may further include other component other than the coloring agent and the resin.

Examples of the first coloring agent include a pyrrolopyrrole coloring agent compound, a copper compound, a cyanine-based coloring agent compound, a phthalocyanine-based compounds, an immonium-based compound, a thiol-complex-based compound, a transition metal oxide-based compounds, a squarylium-based coloring agent compound, a naphthalocyanine-based coloring agent compound, a quaterrylene-based coloring agent compound, a dithiol metal complex-based coloring agent compound, and a croconium compound.

A pyrrolopyrrole coloring agent compound may be a pigment or a dye. However, for the reason of obtaining an infrared ray transmission composition that can form a film having excellent heat resistance, a pigment is preferable. The pyrrolopyrrole coloring agent compound is preferably a compound represented by Formula (A5) below.

Formula (A5)

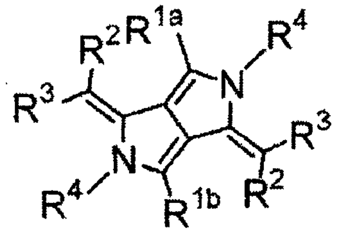

In Formula (A5), $R^{1a}$ and $R^{1b}$ each independently represent an alkyl group, an aryl group, or a heteroaryl group, $R^2$ and $R^3$ each independently represent a hydrogen atom or a substituent, at least one of $R^2$ or $R^3$ is an electron-withdrawing group, $R^2$ and $R^3$ may be bonded to each other to form a ring, $R^4$ represents a hydrogen atom, an alkyl group, an aryl group, a heteroaryl group, substituted boron, and a metal atom, and $R^4$ may form a covalent bond or a coordinate bond with one or more selected from $R^{1a}$, $R^{1b}$, and $R^3$.

For example, as the compound represented by Formula (A5), disclosure in paragraphs 0016 to 0058 of JP2009-263614A can be referred to, and the contents thereof are incorporated into this specification.

In the infrared ray transmission composition, the content of the first coloring agent is preferably 0.5 to 60 mass% and more preferably 10 to 40 mass%, with respect to the total solid content of the infrared ray transmission composition.

In the infrared ray transmission composition, the first coloring agent may be used singly or two or more types thereof may be used in combination. In a case where two or more types thereof may be used in combination, it is preferable that the total content thereof is in the range described above.

The second coloring agent may be a pigment or may be a dye, but it is preferable that the second coloring agent is the pigment. The second coloring agent preferably contains two or more types coloring agents selected from a red coloring agent, a yellow coloring agent, a blue coloring agent, and violet coloring agent. As the second coloring agent, the other coloring agents described in the first embodiment above can be used.

In a case where the second coloring agent is combined with a red coloring agent, a yellow coloring agent, a blue coloring agent, and a violet coloring agent, a mass ratio of the red coloring agent with respect to the total amount of the second coloring agent is 0.1 to 0.4, a mass ratio of the yellow coloring agent with respect to the second coloring agent is 0.1 to 0.4, a mass ratio of the blue coloring agent with respect to the total amount of the second coloring agent is 0.20 to 0.60, and a mass ratio of the violet coloring agent with respect to the total amount of the second coloring agent is preferably 0.01 to 0.30.

The content of the second coloring agent is preferably 0.5 to 60 mass%, more preferably 10 to 60 mass%, and even more preferably 30 to 50 mass% with respect to the total solid content of the infrared ray transmission composition.

In the infrared ray transmission composition, the total content of the first coloring agent and the second coloring agent is preferably 1 to 80 mass%, more preferably 20 to 70 mass%, and even more preferably 30 to 70 mass% with respect to the total solid content of the infrared ray transmission composition.

As the third coloring agent, a coloring agent having absorption maximum out of a wavelength range of 400 to 700 nm and a wavelength range of 800 to 900 nm can be used.

Examples of the resin that the infrared ray transmission composition includes include a dispersing agent and an alkali-soluble resin. As the dispersing agent and the alkali-soluble resin, the dispersing agents and the alkali-soluble resins described in the first embodiment can be used.

As the other component, the polymerizable compounds, the polymerization initiators, the pigment derivatives, the solvents, the surfactants, and the like described in the first embodiment can be used. Preferable ranges thereof are the same as those according to the first embodiment.

[Fourth embodiment of infrared ray transmission composition]

An infrared ray transmission composition according to the fourth embodiment includes the coloring agent and the polymerizable compound, the polymerizable compound contains a polymerizable compound having a chain (hereinafter, referred to as an alkyleneoxy alkyleneoxy chain) including two or more alkyleneoxy groups as repeating units, a ratio A/B of a minimum value A of absorbance of the infrared ray transmission composition in a wavelength range of 400 nm or longer and shorter than 580 nm and a minimum value B of absorbance in a wavelength range of 580 nm to 770 nm is 0.3 to 3, and a ratio C/D of a minimum value C of the absorbance in a wavelength range of 400 nm to 750 nm and a maximum value D of absorbance in a wavelength range of 850 nm to 1,300 nm is 5 or greater.

The infrared ray transmission composition may further include a coloring agent and other components other than the polymerizable compound.

The coloring agent has the same meaning as the other coloring agent according to the first embodiment above. With respect to the coloring agent, the content of the pigment is preferably 95 mass% or greater, more preferably 97 mass% or greater, and even more preferably 99 mass% or greater with respect to the total amount of the coloring agent.
The polymerizable compound contains a polymerizable compound that has an alkyleneoxy chain.
As the polymerizable compound that has an alkyleneoxy chain, the polymerizable compounds described in the first embodiment can be used.
As the other component, the polymerization initiator, the dispersing agent, the pigment derivative, the solvent, the alkali-soluble resin, and the surfactant that are described in the first embodiment can be used. Preferable ranges thereof are also the same as those according to the first embodiment.

[Fifth embodiment of infrared ray transmission composition]

An infrared ray transmission composition according to the fifth embodiment includes a coloring agent and a polymerizable compound, the polymerizable compound contains a polymerizable compound having a chain including two or more alkyleneoxy groups as repeating units, the coloring agent includes at least one or more coloring agents A selected from a red coloring agent and a violet coloring agent, a yellow coloring agent, and a blue coloring agent, the coloring agent A/total coloring agent that is a mass ratio of the coloring agent A selected from the red coloring agent and the violet coloring agent with respect to the total amount of the coloring agent is 0.01 to 0.7, and a yellow coloring agent/total coloring agent that is a mass ratio of a yellow coloring agent with respect to a total amount of the coloring agent is 0.05 to 0.5, and a blue coloring agent/total coloring agent that is a mass ratio of the blue coloring agent with respect to the total amount of the coloring agent is 0.05 to 0.6.
The infrared ray transmission composition may further include the other components other than the coloring agent and the polymerizable compound.
The coloring agent has the same meaning as the other coloring agent according to the first embodiment described above.
The polymerizable compound has the same meaning as the polymerizable compound having an alkyleneoxy chain described in the fourth embodiment.
As the other component, the polymerization initiators, the dispersing agents, the pigment derivatives, the solvents, the alkali-soluble resins, and the surfactant described in the first embodiment can be used. Preferable ranges thereof are the same as the first embodiment.

[Sixth embodiment of infrared ray transmission composition]

An infrared ray transmission composition according to a sixth embodiment includes a coloring agent and a polymerizable compound, a ratio P/M of a mass P of the coloring agent and a mass M of the polymerizable compound is 0.05 to 0.35, the content of the polymerizable compound in the total solid content of the infrared ray transmission composition is 25 to 65 mass%, a ratio A/B of a minimum value A of absorbance of the infrared ray transmission composition in a wavelength range of 400 nm or longer and shorter than 580 nm and a minimum value B of absorbance in a wavelength range of 580 nm to 770 nm is 0.3 to 3, and a ratio C/D of a minimum value C of absorbance in a wavelength range of 400 nm to 750 nm and a maximum value D of absorbance in a wavelength range of 850 nm to 1,300 nm is 5 or greater.
The infrared ray transmission composition may further include the other components other than the coloring agent and the polymerizable compound.
The coloring agent and the polymerizable compound have the same meaning as the other coloring agents and the other polymerizable compounds according to the first embodiment described above.
As the other components, the polymerization initiators, the dispersing agents, the pigment derivatives, the solvents, the alkali-soluble resins, and the surfactants described in the first embodiment can be used. Preferable ranges thereof are the same as those according to the first embodiment.

[Seventh embodiment of infrared ray transmission composition]

The infrared ray transmission composition according to the seventh embodiment includes a coloring agent and a polymerizable compound, a ratio P/M of a mass P of a coloring agent and a mass M of a polymerizable compound is 0.05 to 0.35, a content of a polymerizable compound in the total solid content of the infrared ray transmission composition is 25 to 65 mass%, a coloring agent includes at least one of a yellow coloring agent or a blue coloring agent, the yellow coloring agent/the total coloring agent that is a mass ratio of the yellow coloring agent with respect to the total amount of the coloring agent is 0.1 to 0.5, the blue coloring agent/the total coloring agents that is a mass ratio of the blue coloring agent with respect to the total amount of the coloring agent is 0.1 to 0.6.

The infrared ray transmission composition may further include the other components other than the coloring agent and the polymerizable compound.
The coloring agent and the polymerizable compound have the same meaning as the other coloring agents and the polymerizable compounds according to the first embodiment described above.
As the other components, the polymerization initiators, the dispersing agents, the pigment derivatives, the solvents, the alkali-soluble resins, and the surfactants described in the first embodiment can be used. Preferable ranges thereof are the same as those according to the first embodiment.

[Eighth embodiment of infrared ray transmission composition]

The infrared ray transmission composition according to the eighth embodiment is a composition in which, when a film having a film thickness of 1 μm is formed, a maximum value of transmittance of a film in the thickness direction in a wavelength range of 400 to 750 nm is 20% or less, and a minimum value of transmittance of the film in a thickness direction in a wavelength range of 900 to 1,300 nm is 90% or greater.
Methods for measuring spectral characteristics, a film thickness of the film, and the like are provided below.
A film is provided by applying the composition on a glass substrate by a method of spin coating or the like, such that a film thickness after drying becomes 1 μm, and the film is dried with a hot plate at 100°C for 120 seconds.
The film thickness of the substrate having the film after drying is measured with a stylus surface profiler (DEKTAK150 manufactured by ULVAC Inc.).
Transmittance of this substrate having the film after drying is measured in a wavelength range of 300 to 1,300 nm with an ultraviolet-visible near infrared spectrophotometer (U-4100 manufactured by manufactured by Hitachi High-Technologies Corporation) (ref. glass substrate).
The light transmittance can be adjusted by any means. However, for example, the light transmittance can be suitably adjusted by causing the composition to contain two or more pigments and adjusting types and contents of the respective pigments.
The infrared ray transmission composition may further include the other components other than the coloring agent and the coloring agent.
The coloring agent is the same as the other coloring agent according to the first embodiment described above.
As the other components, the polymerization initiators, the dispersing agents, the pigment derivatives, the solvents, the alkali-soluble resins, and the surfactants described in the first embodiment can be used. Preferable ranges thereof are also the same as those according to the first embodiment.

[Ninth embodiment of infrared ray transmission composition]

The infrared ray transmission composition according to the ninth embodiment is a composition in which, in a case where an infrared ray transmission film including a pigment, a photopolymerization initiator, and a polymerizable compound and having transmittance at a wavelength of 600 nm of 30% is formed, the infrared ray transmission film satisfy conditions (1) to (5) below.

(1) Transmittance at 400 nm is 20% or less.
(2) Transmittance at 550 nm is 10% or less.
(3) Transmittance at 700 nm is 70% or greater.
(4) A wavelength exhibiting transmittance of 50% is in a range of 650 nm to 680 nm.
(5) An infrared ray transmission film has a film thickness in a range of 0.55 μm to 1.8 μm.

For example, as details of the infrared ray transmission composition, disclosure in paragraphs 0020 to 0230 of JP2013-077009A can be referred to, and the contents thereof are incorporated into this specification.
Metal elements may be included in the infrared ray transmission composition depending on raw materials used. However, in view of defect generation suppression or the like, a content of second group elements (calcium, magnesium, or the like) in the infrared ray transmission composition is preferably 50 ppm or less and is preferably suppressed to 0.01 to 10 ppm. A total amount of inorganic metal salt in the infrared ray transmission composition is preferably 100 ppm or less, and is more preferably suppressed to 0.5 to 50 ppm.

<Infrared ray sensor>

The bandpass filter according to the invention can transmit only light in a specific wavelength range, and thus the bandpass filter can be preferably used in a sensor, particularly, in an infrared ray sensor.
The infrared ray sensor has the laminate according to the invention and an infrared ray transmission film. The

configuration of the infrared ray sensor is not particularly limited, as long as the infrared ray sensor has the laminate according to the invention and functions as a solid-state imaging device.

Examples thereof include a configuration having transfer electrodes consisting of plural polydiodes forming a light receiving area of a solid-state imaging device (a CCD sensor, a CMOS sensor, an organic CMOS sensor, or the like) on a substrate and polysilicon, having a light shielding film that is open at only a light receiving section of a polydiode on polydiode and a transfer electrode and that consists of tungsten, having a device protective film that is formed to cover the entire surface of the light shielding film and the polydiode light receiving section on the light shielding film and consists of silicon nitride, and having a bandpass filter having the laminate according to the invention on the device protective film.

Examples thereof may further include a configuration having condensing means (for example, microlens) on the device protective film and under the laminate according to the invention (on a side close to the substrate) or on the laminate according to the invention.

The organic CMOS sensor is formed to include a thin panchromatic photosensitive organic photoelectrical conversion film as a photoelectrical conversion film and a substrate reading out a CMOS signal and has a hybrid structure in a two-layered configuration in which an organic material takes a role of catching light and converting the light into an electric signal and an inorganic material takes a role of extracting the electric signal to the outside. In principle, an opening ratio of incidence rays can be caused to be 100%. The organic photoelectrical conversion film can read out CMOS signals with a continuous film in a free structure and can be laid on the substrate. Therefore, the organic photoelectrical conversion film does not need a fine processing process with a high cost and is suitable for fining pixels.

<Image pick-up device>

Subsequently, an image pick-up device is described as an example to which the infrared sensor is applied. Examples of the image pick-up device include a camera module.

Fig. 5 is a functional block diagram of an image pick-up device. The image pick-up device comprises a lens optical system 1, a solid-state imaging device 10, a signal processing unit 20, a signal switching unit 30, a controller 40, a signal accumulating unit 50, a light emitting controller 60, an infrared LED 70 of a light emitting element that emitting infrared light, and image output units 80 and 81. As the solid-state imaging device 10, the infrared sensor 100 described above can be used. All or a portion of the configurations except for those of the solid-state imaging device 10 and the lens optical system 1 may be formed on the same semiconductor substrate. With respect to the respect configurations of the image pick-up device, paragraphs 0032 to 0036 of JP2011-233983A are referred to, and the contents thereof are incorporated into this specification.

<Kit for forming bandpass filter >

A kit for forming a bandpass filter according to the invention includes a first composition including particles, a resin, and a solvent, and a second composition including particles, a resin, and a solvent, and a difference between a refractive index when the first composition is formed to be a layer shape and a refractive index when the second composition is formed to be a layer shape is 0.5 or greater.

As the first composition, the high refractive composition described above is exemplified, and preferable ranges thereof are the same.

As the second composition, the low refractive composition described above is exemplified, and preferable ranges thereof are the same.

<Image display device>

Examples of the other use of the laminate include an application to an image display device.

More specifically, examples thereof include an image display device that has a color filter and in which at least a portion of the color filter consists of the laminate described above. If a portion of the color filter is caused to be the laminate as described above, it is possible to cause desired light to be transmitted with an easy design. In the related art, at the time of manufacturing a color filter, a coloring agent such as a dye or a pigment can be used, but if the laminate according to the invention is used, such a use can be avoided. As a result, costs can be reduced, and restraints in processes such as a high temperature treatment can be reduced.

Examples of the image display device include a liquid crystal display device or an organic electroluminescence display device.

Examples

Hereinafter, the invention is more specifically described with reference to examples below, but the invention is not limited thereto without departing from the gist of the invention. Unless described otherwise, "%" and "parts" are based on mass.

<Preparation of low refractive dispersion liquid B-1>

According to the disclosure in paragraphs 0032 to 0034, and 0042 (Example 1-1) of JP2013-253145A, a low refractive dispersion liquid B-1 was obtained.
Moniliform colloidal silica particles were included in the obtained low refractive dispersion liquid B-1.

<Preparation of low refractive dispersion liquid B-2>

In the preparation of the low refractive dispersion liquid B-1, a low refractive dispersion liquid B-2 was prepared in the same manner except for changing colloidal silica included in the low refractive dispersion liquid to hollow particles. Specifically, the composition was obtained by stirring and mixing a hydrolysate of the silane compound and silica of the hollow particles in a ratio in which a content of the hollow particles becomes 200 parts by mass with respect to 100 parts by mass of an $SiO_2$ portion in the hydrolysate.

<Preparation of high refractive dispersion liquid B-3>

The mixture liquid of the composition below was mixed and dispersed for three hours with a beads mill (a high pressure dispersing machine with pressure reducing mechanism NANO-3000-10 (manufactured by Beryu corp.)) by using zirconia beads in a diameter of 0.3 mm, so as to prepare a high refractive dispersion liquid B-3.

- Titanium dioxide 28.9 parts
- Dispersing agent: a dispersing agent (C-5) disclosed in examples of JP2014-62221A (see Table 1 in paragraph 0254 and paragraph 0261 of JP2014-62221A) 6.4 parts
- Organic solvent: Propylene glycol methyl ether acetate (PGMEA) 64.7 parts

<Preparation of high refractive dispersion liquid B-4>

In the preparation of the high refractive dispersion liquid B-3, a high refractive dispersion liquid B-4 was prepared in the same manner as the preparation of the high refractive dispersion liquid B-3 except for changing titanium oxide into zirconium dioxide in the same amount.

<Preparation of low refractive composition 1>

- Low refractive dispersion liquid B-1 75.3 parts
- Surfactant 1 in PGMEA 10 mass% solution 0.1 parts

Surfactant 1 (fluorine-containing resin)

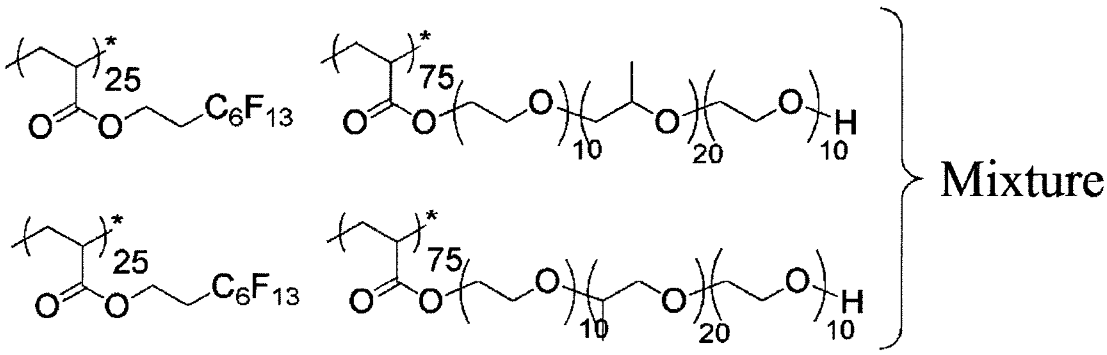


The weight-average molecular weight was 14,000.

- Organic solvent 1: ethyl lactate 24.6 parts

<Preparation of low refractive composition 2>

- Low refractive dispersion liquid B-2 75.3 parts
- Surfactant 1 in PGMEA 10 mass% solution 0.1 parts
- Organic solvent 1: ethyl lactate 24.6 parts

<Preparation of high refractive composition 1>

- High refractive dispersion liquid B-3 84.7 parts
- Alkali-soluble resin 1 below in PGMEA 45 mass% solution 0.9 parts
- Epoxy resin (EX211L Nagase Chemtex Corporation) 2.9 parts
- Epoxy resin (JER157S65 Mitsubishi Chemical Corporation) 0.7 parts
- Surfactant 1 in PGMEA 10 mass% solution 3.4 parts
- Polymerization inhibitor: p-methoxyphenol 0.002 parts
- Organic solvent 1: PGMEA 7.4 parts

Alkali-soluble resin 1

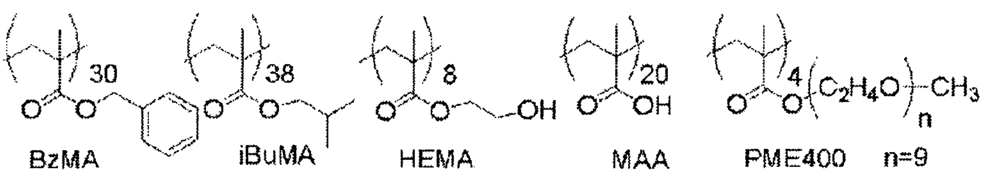

BzMA iBuMA HEMA MAA PME400 n=9

<Preparation of high refractive composition 2>

In the preparation of the high refractive composition 1, a high refractive composition 2 was prepared in the same manner as the preparation of the high refractive composition 1 except for changing the high refractive dispersion liquid B-3 to the high refractive dispersion liquid B-4.

<<Measurement of refractive index of composition>>

Refractive indexes of the low refractive composition and the high refractive composition were measured as below.

The composition was applied on an 8-inch glass wafer by a spin coating method, the glass wafer was heated on a hot plate under the condition of 100°C and for two minutes, so as to form a coated film. Further, this coated film

was heated on a hot plate at 200°C for five minutes, so as to obtain a cured film (film thickness: 1.0 μm).

With respect to a glass wafer with the cured film obtained as above, an refractive index of the transparent film with respect to light at a wavelength of 635 nm was measured with ELLIPSOMETER manufactured by J. A. Woollam Co., Inc.

<<Measurement of refractive index of vapor deposition film>>

A vapor deposition film having a composition shown in Table 1 below was prepared on a surface of an 8-inch glass wafer. The vapor deposition film having a thickness of 1.0 μm was prepared in reference to disclosure in JP2012-225993A. Refractive indexes were measured in the same method as the measurement of the refractive index of the composition above.

Results are shown in the table below.

[Table 1]

| Composition | Refractive index |
|---|---|
| Low refractive composition 1 | 1.2 |
| Low refractive composition 2 | 1.3 |
| High refractive composition 1 | 1.9 |
| High refractive composition 2 | 1.67 |
| $SiO_2$ vapor deposition film | 1.45 |
| $Al_2O_3$ vapor deposition film | 1.76 |
| $TiO_2$ vapor deposition film | 2.71 |
| $TiO_2$ vapor deposition film | 2.71 |

<Example 1>

A low refractive area and a high refractive area were respectively and alternately laminated on a surface of an 8-inch glass wafer by using the low refractive composition 1 and the high refractive composition 1, such that the laminate have a configuration shown in a laminate 1 of Table 2. The low refractive composition was applied with a spin coater, and the low refractive composition was dried with a hot plate in conditions of 100°C /120 sec. The high refractive composition was applied with a spin coater, and the high refractive composition was dried with a hot plate in conditions of 200°C/3 min.

Application amounts and the number of times of the application (number of laminate) were adjusted, such that the respective thicknesses of the high refractive areas and the low refractive areas become desired thicknesses shown in Table 2. Actual film thicknesses shown in Table 2 correspond to film thicknesses of this example. In Table 2, the expression "Low n" represents a low refractive area and the expression "High n" represents a high refractive area.

<Examples 2 to 6>

In Example 1, laminates of Examples 2 to 6 were obtained in the same manner as Example 1, except for respectively changing a layer configuration of the laminate 1 to layer configurations of laminates 2 to 6 of Table 2. The actual film thicknesses shown in Table 2 correspond to a film thickness of this example.

Transmittance of the laminates obtained in Examples 1 to 6 in a wavelength range of 400 to 1,100 nm was measured with an ultraviolet-visible near infrared spectrophotometer (manufactured by Hitachi High-Technologies Corporation U-4100) (ref. glass substrate). Results of the laminate 1 are illustrated in Fig. 6, results of the laminate 2 are illustrated in Fig. 9, results of the laminate 3 are illustrated in Fig. 12, results of the laminate 4 are illustrated in Fig. 15, results of the laminate 5 are illustrated in Fig. 16, and results of the laminate 6 are illustrated in Fig. 17. In the drawings, "Transmittance" in vertical axis represents transmittance (Unit: %), and Wavelength of a lateral axis represents wavelengths (Unit: nm). The same are applied to drawings showing transmittance in examples below.

In Fig. 6, absorbance at a wavelength of 1,040 nm/absorbance at a wavelength of 940 nm was 83.7. In Fig. 9, absorbance at a wavelength of 950 nm/absorbance at a wavelength of 850 nm was 390. In Fig. 12, absorbance at a wavelength of 800 nm/absorbance at a wavelength of 700 nm was 359. In Fig. 15, absorbance at a wavelength of 1,040 nm/absorbance at a wavelength of 940 nm was 55.2. In Fig. 16, absorbance at a wavelength of 950 nm/absorbance at

a wavelength of 850 nm was 56.2. In Fig. 17, absorbance at a wavelength of 800 nm/absorbance at a wavelength of 700 nm was 57.0.

[Table 2]

| | 1 | 2 | 3 | 4 | 5 | 6 | 7 | 8 | 9 | 10 | 11 |
|---|---|---|---|---|---|---|---|---|---|---|---|
| Laminate 1 | Low n | High n | Low n | High n | Low n | High n | Low n | High n | Low n | High n | Low n |
| Optical film thickness | 292.5 nm | 292.5 nm | 292.5 nm | 292.5 nm | 292.5 nm | 292.5 nm | 292.5 nm | 292.5 nm | 292.5 nm | 292.5 nm | 292.5 nm |
| Actual film thickness | 237 nm | 156 nm | 237 nm | 156 nm | 237 nm | 156 nm | 237 nm | 156 nm | 237 nm | 156 nm | 237 nm |
| | | | | | | | | | | | |
| Laminate 2 | Low n | High n | Low n | High n | Low n | High n | Low n | High n | Low n | High n | Low n |
| Optical film thickness | 262.5 nm | 262.5 nm | 262.5 nm | 262.5 nm | 262.5 nm | 262.5 nm | 262.5 nm | 262.5 nm | 262.5 nm | 262.5 nm | 262.5 nm |
| Actual film thickness | 212 nm | 140 nm | 212 nm | 140 nm | 212 nm | 140 nm | 212 nm | 140 nm | 212 nm | 140 nm | 212 nm |
| | | | | | | | | | | | |
| Laminate 3 | Low n | High n | Low n | High n | Low n | High n | Low n | High n | Low n | High n | Low n |
| Optical film thickness | 216.25 nm | 216.25 nm | 216.25 nm | 216.25 nm | 216.25 nm | 216.25 nm | 216.25 nm | 216.25 nm | 216.25 nm | 216.25 nm | 216.25 nm |
| Actual film thickness | 175 nm | 115 nm | 175 nm | 115 nm | 175 nm | 115 nm | 175 nm | 115 nm | 175 nm | 115 nm | 175 nm |
| | | | | | | | | | | | |
| Laminate 4 | High n | Low n | High n | Low n | High n | Low n | High n | Low n | High n | | |
| Optical film thickness | 235 nm | 235 nm | 235 nm | 235 nm | 940 nm | 235 nm | 235 nm | 235 nm | 235 nm | | |
| Actual film thickness | 125 nm | 190 nm | 125 nm | 190 nm | 500 nm | 190 nm | 125 nm | 190 nm | 125 nm | | |
| | | | | | | | | | | | |
| Laminate 5 | High n | Low n | High n | Low n | High n | Low n | High n | Low n | High n | | |
| Optical film thickness | 212.5 nm | 212.5 nm | 212.5 nm | 212.5 nm | 850 nm | 212.5 nm | 212.5 nm | 212.5 nm | 212.5 nm | | |
| Actual film thickness | 113 nm | 172 nm | 113 nm | 172 nm | 452 nm | 172 nm | 113 nm | 172 nm | 113 nm | | |
| | | | | | | | | | | | |
| Laminate 6 | High n | Low n | High n | Low n | High n | Low n | High n | Low n | High n | | |
| Optical film thickness | 175 nm | 175 nm | 175 nm | 175 nm | 700 nm | 175 nm | 175 nm | 175 nm | 175 nm | | |
| Actual film thickness | 92 nm | 141 nm | 92 nm | 141 nm | 368 nm | 141 nm | 92 nm | 141 nm | 92 nm | | |

<Example A>

<<Preparation of pigment dispersion liquid 1-1>>

Respective components of the pigment dispersion liquid 1-1 shown in Table 3 were mixed and dispersed in a bead mill (a high pressure dispersion device with a pressure reducing mechanism NANO-3000-10 (manufactured by Beryu corp.), by using zirconia beads having a diameter of 0.3 mm until the first coloring agent have an average particle diameter shown in Table 3, so as to prepare the pigment dispersion liquid 1-1. Use amounts of the corresponding components (Unit: parts by mass) are shown in Table 3.
The average particle diameter of the pigment in the pigment dispersion liquid is measured in terms of volumes, with MICROTRACUPA 150 manufactured by Nikkiso Co., Ltd. The measurement results are shown in Table 3.

<<Preparation of pigment dispersion liquids 2-1 to 2-4>>

Respective components of the pigment dispersion liquid 2-1 shown in Table 3 were mixed and dispersed for three hours with a bead mill (a high pressure dispersion device with a pressure reducing mechanism NANO-3000-10 (manufactured by Beryu corp.)) by using zirconia beads having a diameter of 0.3 mm, so as to prepare a pigment dispersion liquid 2-1. In the preparation of the pigment dispersion liquid 2-1, pigment dispersion liquids 2-2 to 2-4 were obtained in the same manner as the preparation of the pigment dispersion liquid 2-1, except for changing respective components used to respective components shown in Table 3. Use amounts of the corresponding components (Unit: parts by mass) are shown in Table 3.

[Table 3]

| | Coloring agent | | | Resin | Organic solvent |
|---|---|---|---|---|---|
| | First coloring agent | | Second coloring agent | | |
| | Types | Average diameter (nm) | | | |
| Pigment dispersion liquid 1-1 | Diketopyrrolopyrrole pigment 1 (13.5) | 75 | | Dispersed resin 1 (4.0) | PGMEA (82.5) |
| Pigment dispersion liquid 2-1 | | - | PR254 (13.5) | Dispersed resin 2 (2.0) Alkali-soluble resin 1 (2.0) | PGMEA (82.5) |
| Pigment dispersion liquid 2-2 | | - | PB15:6 (13.5) | Dispersed resin 3 (4.0) | PGMEA (82.5) |
| Pigment dispersion liquid 2-3 | | - | PY139 (14.8) | Dispersed resin 1 (3.0) Alkali-soluble resin 1 (2.2) | PGMEA (80.0) |
| Pigment dispersion liquid 2-4 | | - | PV23 (14.8) | Dispersed resin 1 (3.0) Alkali-soluble resin 1 (2.2) | PGMEA (80.0) |

Abbreviation of respective components in the table is as below.
[First coloring agent (IR coloring agent)]

- Diketopyrrolopyrrole pigment 1: Structure below (synthesized in a method disclosed in JP2009-263614A) (coloring agent having absorption maximum in a wavelength range of 800 to 900 nm)

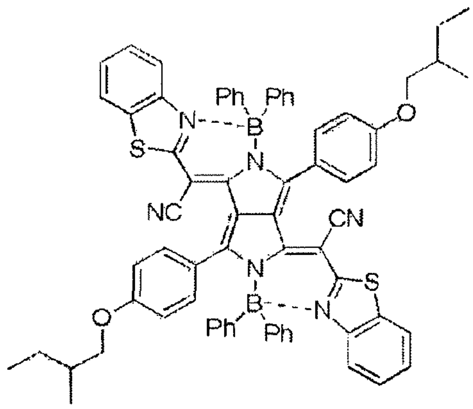

[Second coloring agent (coloring agent having absorption maximum in a wavelength range of 400 to 700 nm)]

- PR254: C. I. Pigment Red 254
- PB15:6: C. I. Pigment Blue 15:6
- PY139: Pigment Yellow 139
- PV23: Pigment Violet 23

[Resin]

- Dispersed resin 1: BYK-111 (manufactured by BYK-Chemie GmbH)
- Dispersed resin 2: Structure below (Mw: 7,950)

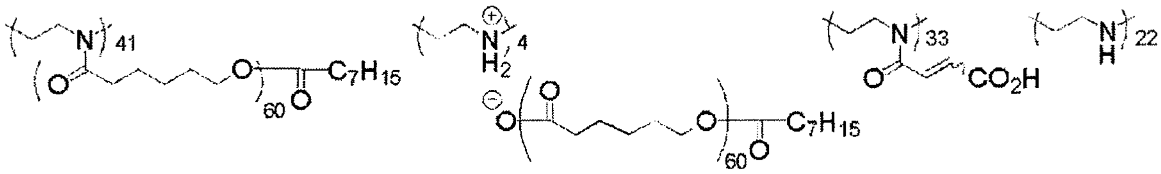

- Dispersed resin 3: Structure below (Mw: 30,000)

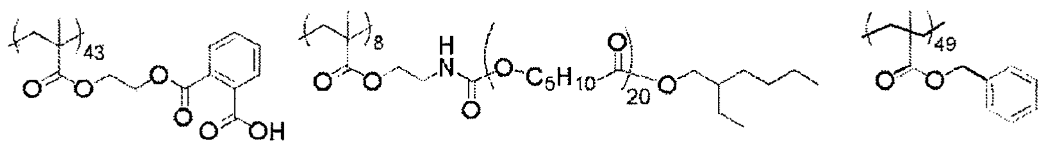

- Alkali-soluble resin 1: Structure below

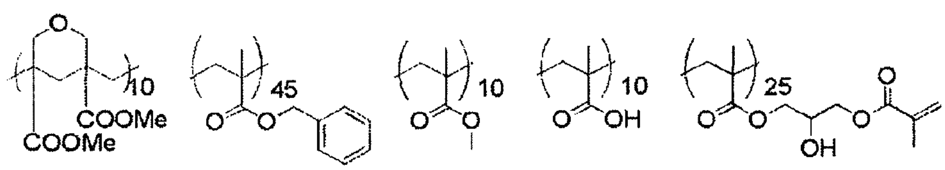

<<Preparation of infrared ray transmission composition A (Coloring composition A)>>

Components shown in Table 4 below were mixed in proportions shown in Table 4 (units are parts by mass) so as to prepare an infrared ray transmission composition A.

[Table 4]

| | Coloring composition A |
|---|---|
| Pigment dispersion liquid 1-1 | 22.67 |
| Pigment dispersion liquid 2-1 | 11.33 |
| Pigment dispersion liquid 2-2 | 22.67 |
| Pigment dispersion liquid 2-3 | 10.34 |
| Pigment dispersion liquid 2-4 | 6.89 |
| Polymerizable compound 1 | 1.37 |
| Alkali-soluble resin 1 | 3.52 |
| Polymerizable initiator 1 | 0.86 |
| Surfactant 1 | 0.42 |
| Polymerization inhibitor 1 | 0.001 |
| Organic solvent 1 | 19.93 |

- Polymerizable compound 1: M-305 (55 to 63 mass% of triacrylate) (manufactured by Toagosei Co., Ltd.) Structure below

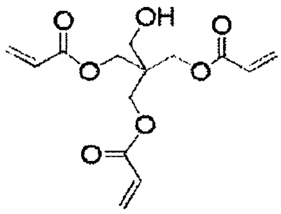

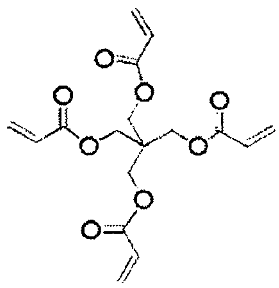

- Photopolymerization initiator 1: IRGACURE-OXE01 (manufactured by BASF SE) Structure below

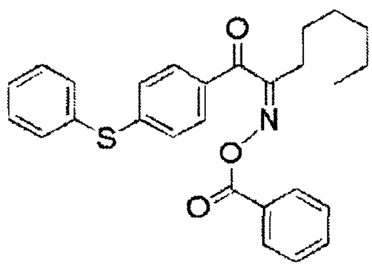

- Surfactant 1 above
- Polymerization inhibitor 1: p-methoxyphenol
- Organic solvent 1: Propylene glycol methyl ether acetate

<<Manufacturing of infrared ray transmission film A>>

The infrared ray transmission composition A was applied to a glass substrate by spin coating such that a film thickness after post baking became 1.0 μm, the infrared ray transmission composition A was dried on a hot plate at 100°C for 120 seconds, so as to form a film. Subsequently, a heating treatment (post baking) was performed on the obtained film for 300 seconds with a hot plate of 200°C and also entire surface exposure was performed using an i-ray stepper exposure device FPA-3000i5+ (manufactured by Canon Inc.), so as to form an infrared ray transmission film A on a glass substrate.

Transmittance in a wavelength range of 400 to 1,100 nm of the obtained infrared ray transmission film A was measured with an ultraviolet-visible near infrared spectrophotometer (manufactured by Hitachi High-Technologies Corporation U-4100) (ref. glass substrate). Results thereof are illustrated in Fig. 7.

<<Manufacturing of bandpass filter A>>

A bandpass filter A was manufactured by combining the laminate 1 obtained in Example 1 above and the infrared ray transmission film A obtained above. The transmittance of the obtained bandpass filter A is illustrated in Fig. 8.

<Example B>

<<Preparation of pigment dispersion liquid B-1>>

Respective components of the composition below were mixed and dispersed for three hours by using zirconia beads having a diameter of 0.3 mm, in a bead mill (a high pressure dispersion device with a pressure reducing mechanism NANO-3000-10 (manufactured by Beryu corp.)), so as to prepare a pigment dispersion liquid B-1.

- Mixed pigment consisting of red pigment (C. I. Pigment Red 254) and yellow pigment (C. I. Pigment Yellow 139) 11.8 parts
- Dispersing agent: BYK-111 manufactured by BYK-Chemie GmbH 9.1 parts
- Organic solvent: Propylene glycol methyl ether acetate 79.1 parts

<<Preparation of pigment dispersion liquid B-2>>

Respective components of the composition were mixed and dispersed for three hours by using zirconia beads having a diameter of 0.3 mm, in a bead mill (a high pressure dispersion device with a pressure reducing mechanism NANO-3000-10 (manufactured by Beryu corp.)), so as to prepare a pigment dispersion liquid B-2.

- Mixed pigment consisting of blue pigment (C. I. Pigment Blue 15:6) and violet pigment (C. I. Pigment Violet 23) 12.6 parts
- Dispersing agent: BYK-111 manufactured by BYK-Chemie GmbH 2.0 parts
- Dispersed resin 4 3.3 parts
- Organic solvent: cyclohexanone 31.2 parts
- Organic solvent: Propylene glycol methyl ether acetate (PGMEA) 50.9 parts

• Dispersed resin 4

As a dispersed resin 4, a compound (a ratio in a repeating unit is a molar ratio) was used.

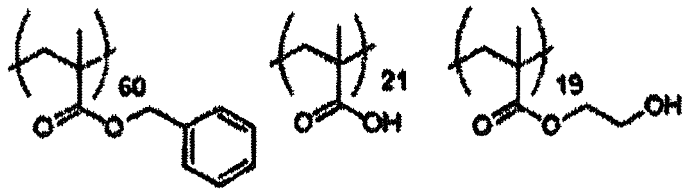

(Mw : 14000)

<<Preparation of infrared ray transmission composition B>>

An infrared ray transmission composition B was prepared by mixing components below.

- Pigment dispersion liquid B-1 46.5 parts
- Pigment dispersion liquid B-2 37.1 parts
- Alkali-soluble resin 1 above 1.1 parts
- Polymerizable compound 2 1.8 parts
- Polymerizable compound 3 0.6 parts
- Photopolymerization initiator: Polymerization initiator 2 0.9 parts

- Surfactant 1 in PGMEA 1.00 mass% solution 4.2 parts
- Polymerization inhibitor: p-methoxyphenol 0.001 parts
- Organic solvent 1: PGMEA 7.8 parts

- A mixture of which a molar ratio between compounds of Polymerizable compound 2 on the left side and the right side was 7:3.

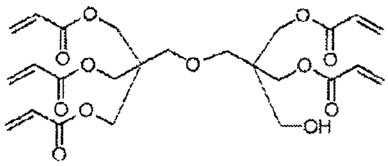
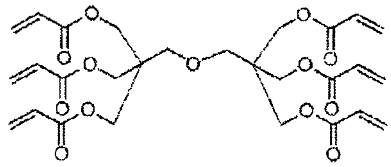

- Polymerizable compound 3

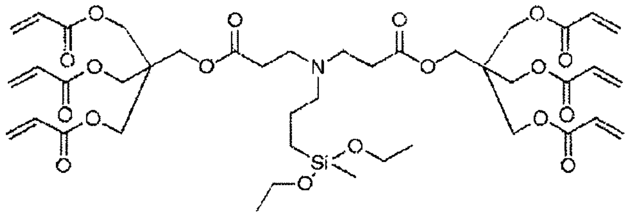

- Polymerization initiator 2

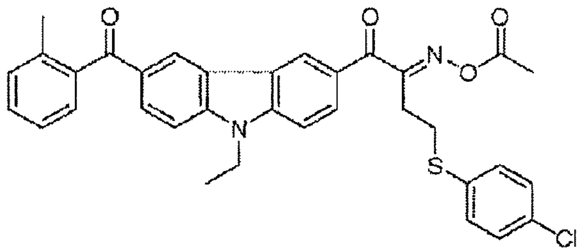

<<Manufacturing of infrared ray transmission film B>>

The infrared ray transmission composition B was applied to a glass substrate by spin coating such that a film thickness after post baking became 1.0 μm, the infrared ray transmission composition B was dried on a hot plate at 100°C for 120 seconds, so as to form a film. Subsequently, a heating treatment (post baking) was performed on the obtained film for 300 seconds with a hot plate of 200°C and also entire surface exposure was performed using an i-ray stepper exposure device FPA-3000i5+ (manufactured by Canon Inc.), so as to form an infrared ray transmission film B on a glass substrate.

Transmittance in a wavelength range of 400 to 1,100 nm of the obtained infrared ray transmission film B was measured with an ultraviolet-visible near infrared spectrophotometer (manufactured by Hitachi High-Technologies Corporation U-4100) (ref. glass substrate). Results thereof are illustrated in Fig. 10.

<<Manufacturing of bandpass filter B>>

A bandpass filter B was manufactured by combining the laminate 2 obtained in Example 2 above and the infrared ray transmission film B obtained above. The transmittance of the obtained bandpass filter B is illustrated in Fig. 11.

<Example C>

<<Manufacturing of infrared ray transmission film C>>

A color filter (infrared ray transmission film C) was manufactured according to the disclosure (Example 1) of paragraphs 0255 to 0259 of JP2013-077009A. Transmittance of the obtained infrared ray transmission film C in a

wavelength range of 400 to 1,100 nm was measured with an ultraviolet-visible near infrared spectrophotometer (manufactured by Hitachi High-Technologies Corporation U-4100) (ref. glass substrate). Results thereof are illustrated in Fig. 13.

<<Manufacturing of bandpass filter C>>

A bandpass filter C was manufactured by combining Laminate 3 obtained in Example 3 above and the infrared ray transmission film C obtained above. Transmittance of the obtained bandpass filter C was illustrated in Fig. 14.

In the manufacturing of the laminate of Examples 1 to 6, laminates of Examples 1 to 6 were manufactured in the same manner, except for changing the compositions of the low refractive area and the high refractive area of the respective laminates (the laminates 1 to 6) shown in Table 2 to five compositions of the low refractive area and the high refractive area shown in Table 5 and adjusting film thicknesses satisfying the optical film thicknesses of the laminates 1 to 6 shown in Table 2, so as to obtain respective laminates (total 30 laminates). The laminates of Examples 7, 8, and 9 were manufactured in the same manner as the manufacturing of the laminates of Examples 1 to 6, and laminates of Comparative Examples 3 and 4 were obtained according to the well-known vapor deposition methods. At this point, the film thicknesses of the respective layers were calculated based on the optical film thickness shown in Table 2. That is, the laminates were manufactured by calculating an actual film thickness to be manufactured, from a desired optical film thickness and a refractive index of a material, so as to satisfy an optical film thickness=an actual film thickness×a refractive index of a material.

Transmittance of the obtained laminate was measured in the same manner as above, and the same waveforms as those of Examples 1 to 6 were able to be obtained.

<Noise evaluation>

In the manufacturing of the bandpass filter B, the respective bandpass filters were manufactured in the same manner as the manufacturing of the bandpass filter B, except for changing compositions of the low refractive areas and the high refractive areas that form the laminate 2 to those as shown in Table 5 below. The results are shown in Table 5 below.

A ratio (t2/t1=x) between transmittance t1 [%] of the bandpass filter in 850 nm and average light transmittance t2 [%] of the bandpass filter in 1,000 nm in the thickness direction was obtained with an ultraviolet-visible near infrared spectrophotometer U-4100 (manufactured by Hitachi High-Technologies Corporation) (ref. glass substrate) and was evaluated based on evaluation standards below. As the scores were higher, noises caused by visible light components become smaller, and performance become more excellent.

<Evaluation standard>

3: $x \leq 0.1$
2: $0.1 < x \leq 0.5$
1: $0.5 < x$

[Table 5]

| | Low refractive layer | | High refractive layer | | |
|---|---|---|---|---|---|
| | Composition | Refractive index | Composition | Refractive index | Noise |
| Example 7 | Low refractive composition 1 | 1.2 | High refractive composition 1 | 1.9 | 3 |
| Example 8 | Low refractive composition 2 | 1.3 | High refractive composition 1 | 1.9 | 2 |
| Example 9 | Low refractive composition 1 | 1.2 | High refractive composition 2 | 1.67 | 2 |
| Comparative Example 3 | $SiO_2$ vapor deposition film | 1.45 | $TiO_2$ vapor deposition film | 2.71 | 3 |

(continued)

| | Low refractive layer | | High refractive layer | | |
|---|---|---|---|---|---|
| | Composition | Refractive index | Composition | Refractive index | Noise |
| Comparative Example 4 | $Al_2O_3$ vapor deposition film | 1.76 | $TiO_2$ vapor deposition film | 2.71 | 3 |

<Preparation of low refractive dispersion liquids B-5 to B-10>

The solvent of the low refractive dispersion liquid B-1 was distilled and the resultant was re-diluted to the solvent shown in Table 6, so as to obtain the low refractive dispersion liquids B-5 to B-10. The numerical values in Table 6 refer to values in terms of parts by mass.

PGME represents propylene glycol monomethyl ether and PGMEA represents propylene glycol monomethyl ether acetate.

In the table below, the expression "solid content" refers to a solid content obtained by distilling the solvent of the low refractive dispersion liquid B-1.

[Table 6]

| | Solid content | PGME | PGMEA | Dipropylene glycol monomethyl ether | Ethyl lactate | Water |
|---|---|---|---|---|---|---|
| B-5 | 5 | | 95 | | | |
| B-6 | 5 | | 80 | | 14 | 1 |
| B-7 | 5 | | 27 | 67 | | 1 |
| B-8 | 5 | 5 | 26 | | 63 | 1 |
| B-9 | 5 | | 6 | | 63 | 20 |
| B-10 | 5 | | 12 | | | 83 |

<Preparation of low refractive compositions 3 to 8>

The low refractive dispersion liquids B-5 to B-10 and the surfactant 1 were mixed by the same amount, so as to obtain low refractive compositions 3 to 8. For example, the low refractive composition 3 was prepared by using the low refractive dispersion liquid B-5.

- Low refractive dispersion liquid 99.9 parts
- Surfactant 1 in PGMEA 10 mass% solution 0.1 parts

<Examples>

The low refractive areas and the high refractive areas were respectively and alternately laminated so as to have the laminate configuration shown in the laminate 1 of Table 2, by using respective low refractive compositions shown in Table 7 and the high refractive composition 1 on the surface of the 8-inch glass wafer, so as to obtain laminates of respective examples. The low refractive composition and the high refractive composition were applied by a spin coater, and the low refractive composition and the high refractive composition were dried with a hot plate at 130°C for 120 seconds.

With respect to the respective thicknesses of the high refractive areas and the low refractive areas, an application amount and the number of times of the application (number of laminates) were adjusted so as to have a desired optical film thickness shown in Table 2 above.

The method for measuring the refractive index of the composition used in the respective laminates was as described above.

The "weight average of SP values of a solvent" shown in Table 7 refers to a value that is a weight average of SP values of solvents included in respective compositions. The calculation method is as described above, and the calculation was performed by using a mass ratio in the total solvent with respect to the respective solvents.

[Table 7]

| | Low refractive laver | | | High refractive layer | | |
|---|---|---|---|---|---|---|
| | Composition | Weight average of SP values of solvent ($(cal/cm^3)^{1/2}$) | Refractive index | Composition | Weight average of SP values of solvent ($(cal/cm^3)^{1/2}$) | Refractive index |
| Example 10 | Low refractive composition 3 | 8.7 | 1.2 | High refractive composition 1 | 8.7 | 1.9 |
| Example 11 | Low refractive composition 4 | 9.4 | 1.2 | High refractive composition 1 | 8.7 | 1.9 |
| Example 12 | Low refractive composition 5 | 10.1 | 1.2 | High refractive composition 1 | 8.7 | 1.9 |
| Example 13 | Low refractive composition 6 | 11.1 | 1.2 | High refractive composition 1 | 8.7 | 1.9 |
| Example 14 | Low refractive composition 7 | 14.3 | 1.2 | High refractive composition 1 | 8.7 | 1.9 |
| Example 15 | Low refractive composition 8 | 21.5 | 1.2 | High refractive composition 1 | 8.7 | 1.9 |

<Film thickness in-plane distribution (variation) measurement>

In Examples 10 to 15, the film thickness in-plane distribution (variation) thereof was measured for each time of applying one layer with ELLIPSOMETER (VUV-vase [Product name] manufactured by J. A. Woollam Co., Inc.) (wavelength: 633 nm, measurement temperature: 25°C). The film thickness in-plane distribution was measured at 20 points in an interval of 10 mm in a diameter direction of a substrate (glass wafer). The film thickness in-plane distribution of each of the formed low refractive layer and the formed high refractive layer was the same, and variation of the respective layers is shown in Table 8. The measurement method of the variation is as described above.

<Defect measurement >

Arbitrary different five points (observation size of each point: 1 mm×1 mm) on a laminate surface of each of the laminates obtained in Examples 10 to 15 were photographed with an optical microscope with a digital camera by ×200 times from the laminate surface (laminate direction of respective layers). According to the order described above, the obtained image was binarized (grayscaled), and the observed black parts were regarded as defects. The number of observed defects having a long diameter of 1 μm or greater was calculated as the number of defects, the number of defects in the five observation positions was arithmetically averaged, and the obtained value (average number of defects) was evaluated according to the standards below. A case where the number of defects (an average number of defects) was less than 30 was considered as A, a case where the number of defects was 30 or more and less than 50 was considered as B, and a case where the number of defects was 50 or more was considered as C.

<Spectrometry>

Transmittance in of the laminates obtained in Example 10 to 15 in a wavelength range of 400 to 1,100 nm was measured with an ultraviolet-visible near infrared spectrophotometer (manufactured by Hitachi High-Technologies Corporation U-4100) (ref. glass substrate). Maximum values and minimum values of transmittance in a wavelength range of 450 to 750 nm are shown in Table 8.

An SP value difference of solvent in Table 8 represents an absolute value of difference of an SP value of a solvent included in the low refractive composition and an SP value of a solvent included in the high refractive composition that is used in the manufacturing of the laminate.

[Table 8]

| | SP value difference of solvent $((cal/cm^3)^{1/2})$ | Film thickness in-plane distribution (%) | Number of defects | Transmittance minimum value (%) | Transmittance maximum value (%) |
|---|---|---|---|---|---|
| Example 10 | 0.0 | 5 | C | 48 | 80 |
| Example 11 | 0.6 | 4.1 | B | 75 | 87 |
| Example 12 | 1.3 | 3.4 | B | 79 | 90 |
| Example 13 | 2.4 | 2.8 | B | 80 | 93 |
| Example 14 | 5.6 | 1.2 | B | 82 | 95 |
| Example 15 | 12.8 | 0.6 | A | 85 | 98 |

As clearly understood from Table 8, it was found that if the SP value difference of the solvent was great, the variation of the film thickness was suppressed, and thus it was possible to obtain a laminate having a great transmittance minimum value, having no coloration, and high transparency. It was found that if the SP value difference of the solvent was great, defects were also suppressed, and thus it was possible to obtain a laminate having high transmittance maximum value, no cloudiness, and high transparency.

Explanation of References

1: lens optical system
10: solid-state imaging device
20: signal processing unit
30: signal switching unit
40: controller
50: signal accumulating unit
60: light emitting controller
70: infrared LED
80, 81: image output unit

## Claims

**1.** A laminate comprising:

a first area formed by applying a first composition; and
a second area formed by applying a second composition on a surface of the first area,

wherein a difference between refractive indexes of the first area and the second area is 0.5 or greater, and the first areas and the second areas are alternately laminated.

**2.** The laminate according to claim 1,

wherein an absolute value of a difference between an SP value that is a solubility parameter of a solvent included in the first composition and an SP value that is a solubility parameter of a solvent included in the second composition is 0.5 $(cal/cm^3)^{1/2}$ or greater.

**3.** The laminate according to claim 1 or 2,

wherein one of the first composition and the second composition includes water, and the other of the first composition and the second composition includes an organic solvent.

**4.** The laminate according to any one of claims 1 to 3,

wherein, when observation with an optical microscope is performed in a direction in which the first area and the second area are laminated, the number of defects having a long diameter of 1 μm or greater is less than 50 defects/$mm^2$.

**5.** The laminate according to any one of claims 1 to 4,

wherein two or more of the first areas and two or more of the second areas are included, a variation of thicknesses of the respective first areas is within 3%, and a variation of thicknesses of the respective second areas is within 3%.

**6.** The laminate according to any one of claims 1 to 5,

wherein at least one of the first area or the second area includes a resin.

**7.** The laminate according to any one of claims 1 to 6,

wherein both of the first area and the second area include a resin.

**8.** The laminate according to any one of claims 1 to 7,

wherein a total number of the first area and the second area is 5 or more areas.

**9.** The laminate according to any one of claims 1 to 8,

wherein absorbance at a wavelength of 800 nm/absorbance at a wavelength of 700 nm, which is a ratio between absorbance at a wavelength of 700 nm and absorbance at a wavelength of 800 nm, is 5 or greater.

**10.** The laminate according to any one of claims 1 to 9,

wherein absorbance at a wavelength of 950 nm/absorbance at a wavelength of 850 nm, which is a ratio between absorbance at a wavelength of 850 nm and absorbance at a wavelength of 950 nm, is 5 or greater.

**11.** The laminate according to any one of claims 1 to 10,

wherein absorbance at a wavelength of 1,040 nm/absorbance at a wavelength of 940 nm, which is a ratio between absorbance at a wavelength of 940 nm and absorbance at a wavelength of 1,040 nm, is 5 or greater.

**12.** The laminate according to any one of claims 1 to 11,

wherein a refractive index of the first area is 1.5 to 3.0, and a refractive index of the second area is 1.0 to 1.3.

**13.** The laminate according to any one of claims 1 to 12,

wherein the first area includes a resin including a group selected from an acid group, a group having a basic nitrogen atom, a urea group, a urethane group, a group having a coordinating oxygen atom, a phenol group, an alkyl group, an aryl group, a group having an alkyleneoxy chain, an imide group, a heterocyclic group, an alkyloxycarbonyl group, an alkylaminocarbonyl group, a carboxylic acid salt group, a sulfonamide group, an alkoxysilyl group, an epoxy group, an isocyanate group, and a hydroxyl group; and metal oxide particles.

**14.** The laminate according to any one of claims 1 to 13,

wherein the second area includes at least one of a siloxane resin or a fluorine-containing resin.

**15.** The laminate according to any one of claims 1 to 14,

wherein the second area includes rosary-shaped silica.

**16.** A laminate comprising:

a first area; and
a second area,
wherein the first areas and the second areas are alternately laminated,
a difference between refractive indexes of the first area and the second area is 0.5 or greater, and
at least one of the first area or the second area includes a resin.

**17.** The laminate according to claim 16,

wherein, when observation with an optical microscope is performed in a direction in which the first area and the second area are laminated, the number of defects having a long diameter of 1 μm or greater is less than 50 defects/$mm^2$.

**18.** The laminate according to claim 16 or 17,

wherein two or more of the first areas and two or more of the second areas are included,
a variation of thicknesses of the respective first areas is within 3%, and
a variation of thicknesses of the respective second areas is within 3%.

**19.** The laminate according to any one of claims 1 to 18 that is used for forming a bandpass filter.

**20.** An infrared ray absorption filter comprising:

the laminate according to any one of claims 1 to 19.

**21.** A bandpass filter comprising:

the laminate according to any one of claims 1 to 19.

**22.** The bandpass filter according to claim 21, further comprising:

an infrared ray transmission film.

**23.** A method for manufacturing a laminate, comprising:

forming a first area by applying a first composition including particles, a resin, and a solvent; and
forming a second area by applying a second composition including particles, a resin, and a solvent on a surface of the first area,
wherein a difference between refractive indexes of the first area and the second area is 0.5 or greater.

**24.** A method for manufacturing a laminate, comprising:

forming a first area by applying a first composition including particles, a resin, and a solvent; and
forming a second area by applying a second composition including particles, a resin, and a solvent on a surface of the first area,
wherein a difference between refractive indexes of the first area and the second area is 0.5 or greater, and one of the first composition and the second composition includes water, and the other of the first composition and the second composition includes an organic solvent.

**25.** The method for manufacturing a laminate according to claim 23,

wherein the laminate is the laminate according to any one of claims 1 to 19.

**26.** A kit for forming a bandpass filter, comprising:

a first composition including particles, a resin, and a solvent; and
a second composition including particles, a resin, and a solvent,
wherein a difference between a refractive index of a layer obtained with the first composition and a refractive index of a layer obtained with the second composition is 0.5 or greater.

**27.** The kit for forming the bandpass filter according to claim 26,

wherein the first composition includes metal oxide particles; a resin including a group selected from an acid group, a group having a basic nitrogen atom, a urea group, a urethane group, a group having a coordinating oxygen atom, a phenol group, an alkyl group, an aryl group, a group having an alkyleneoxy chain, an imide group, a heterocyclic group, an alkyloxycarbonyl group, an alkylaminocarbonyl group, a carboxylic acid salt group, a sulfonamide group, an alkoxysilyl group, an epoxy group, an isocyanate group, and a hydroxyl group; and a solvent, and
the second composition includes metal oxide particles, at least one of a siloxane resin or a fluorine-based resin, and a solvent.

**28.** An image display device comprising:

a color filter,
wherein at least a portion of the color filter includes the laminate according to any one of claims 1 to 19.

**29.** The image display device according to claim 28,

wherein the image display device is a liquid crystal display device or an organic electroluminescence display device.

FIG. 1

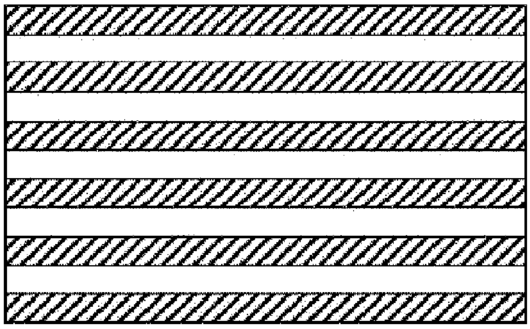

FIG. 2

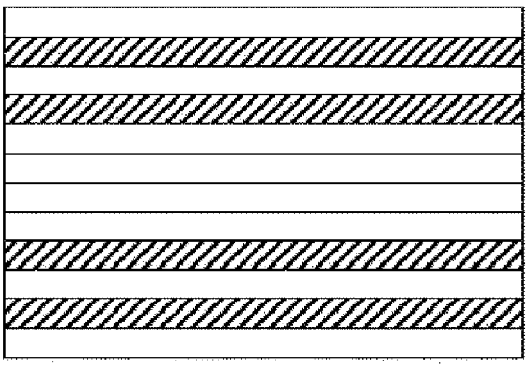

FIG. 3A

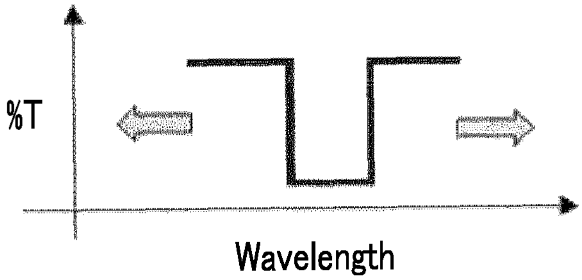


FIG. 3B

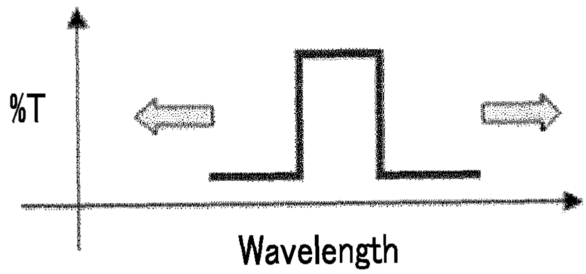


FIG. 4

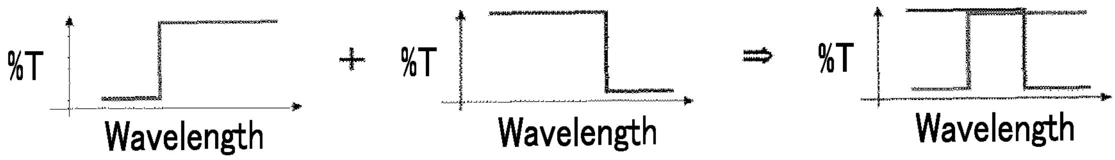


FIG. 5

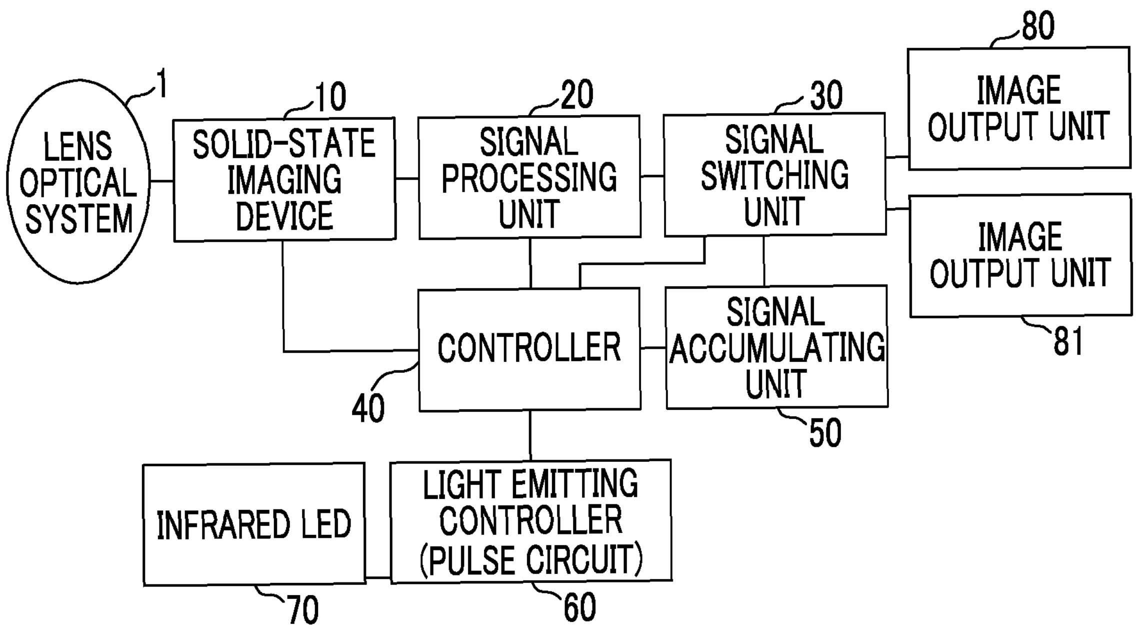

FIG. 6

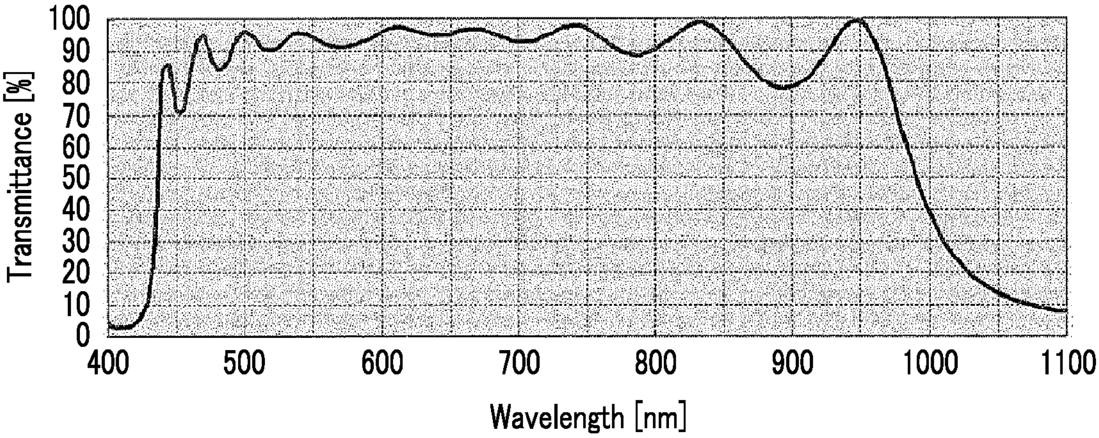


FIG. 7

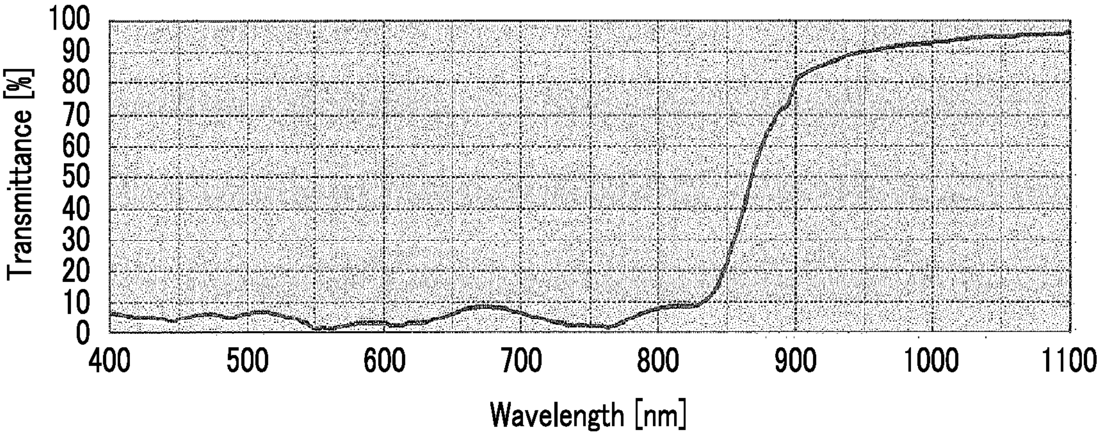


FIG. 8

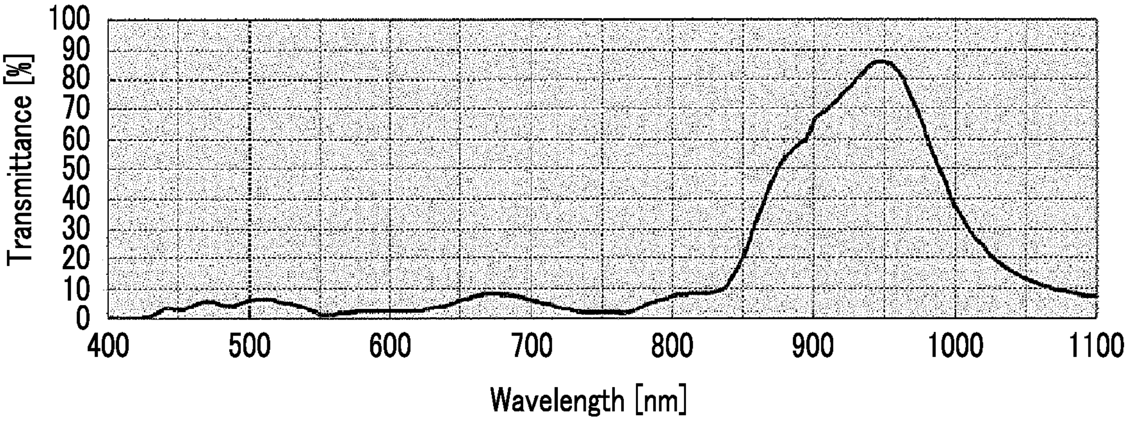

FIG. 9

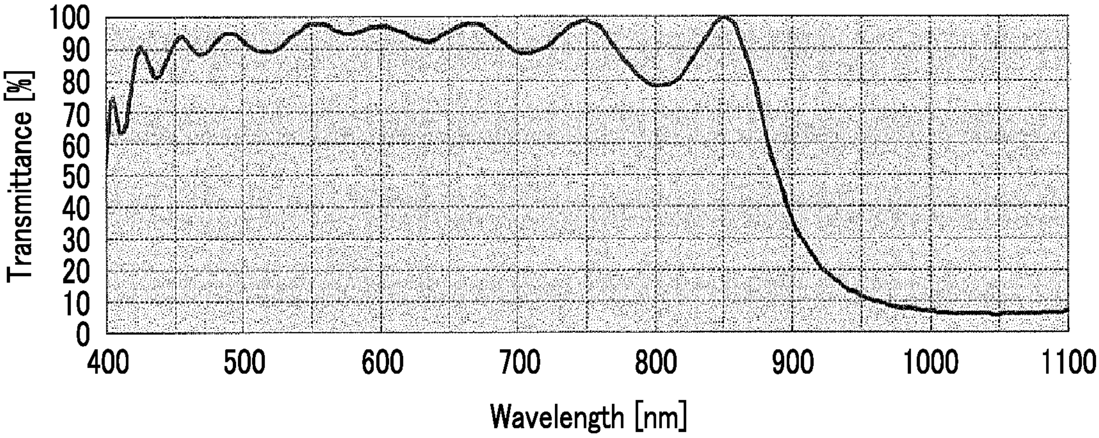


FIG. 10

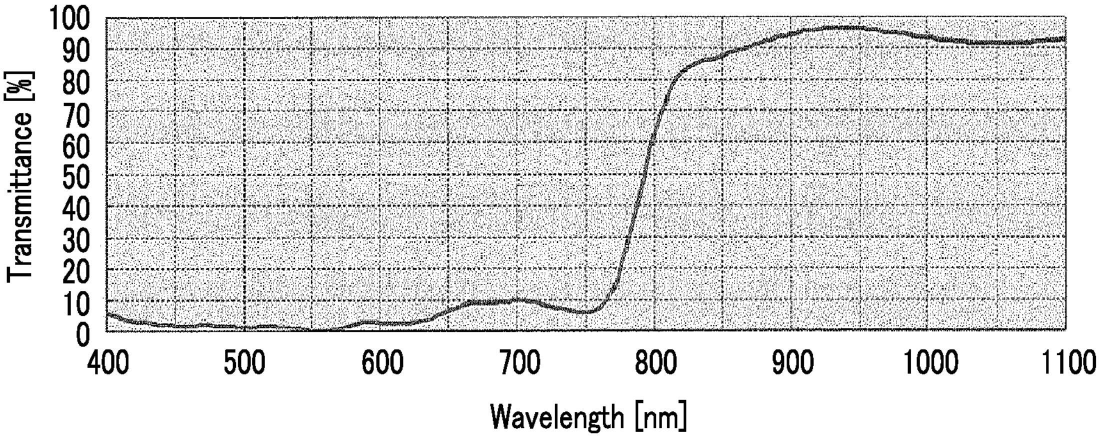


FIG. 11

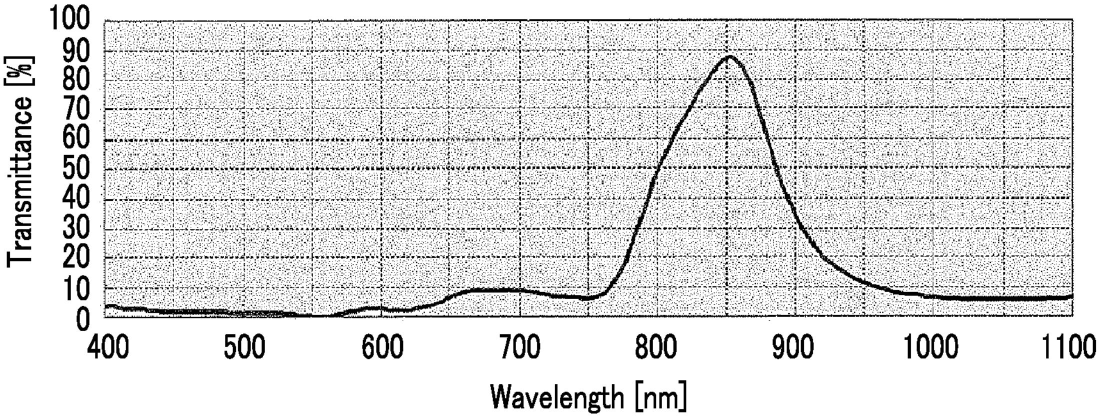

FIG. 12

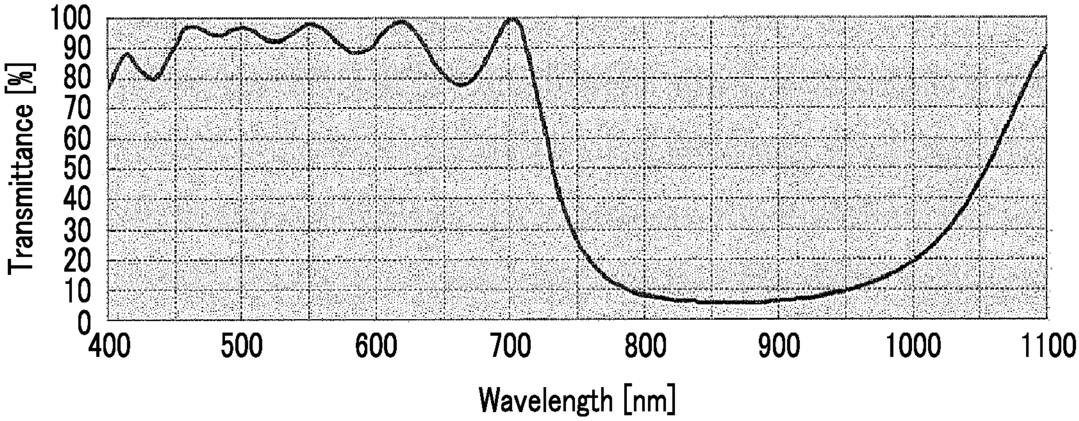


FIG. 13

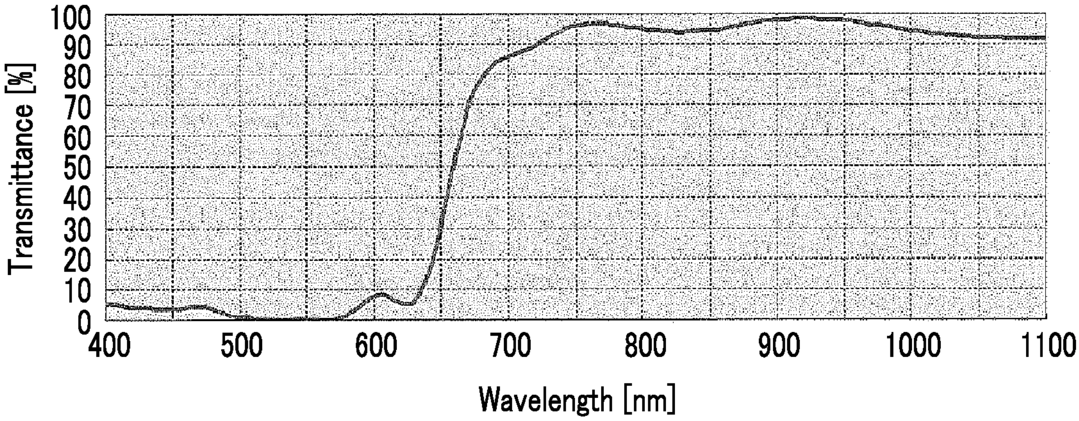


FIG. 14

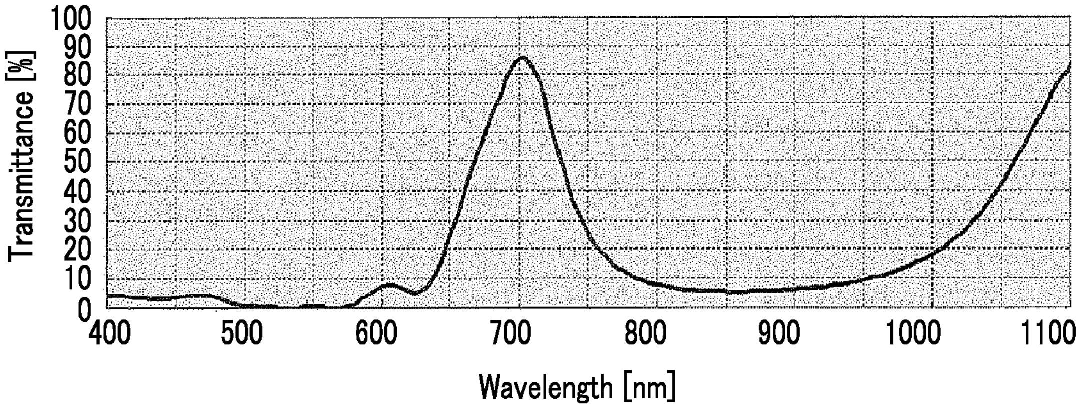

FIG. 15

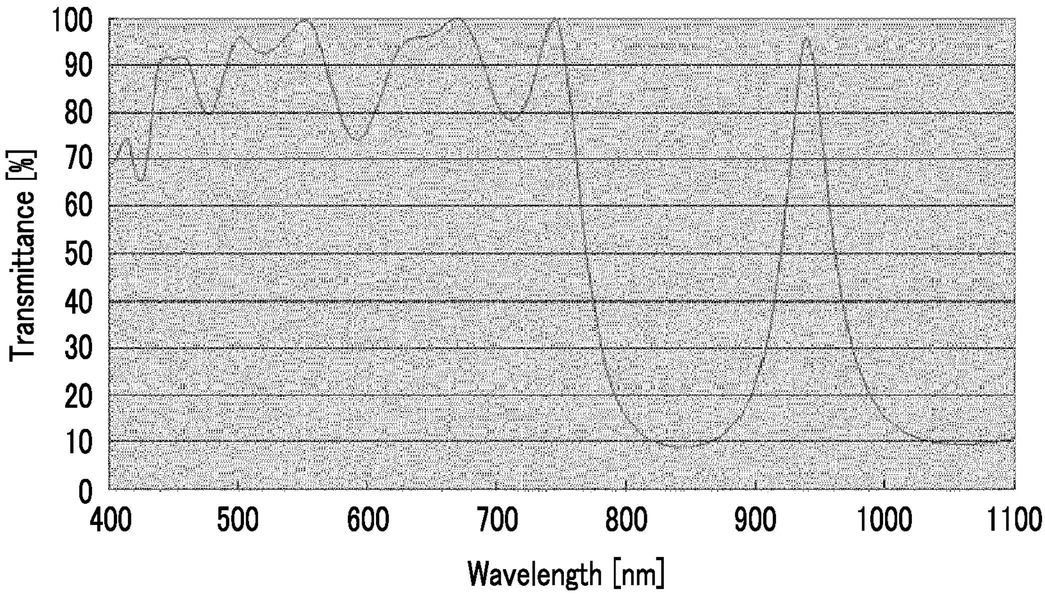
100
90
80
70
60
50
40
30
20
10
0
Transmittance [%]
400
500
600
700
800
900
1000
1100
Wavelength [nm]

FIG. 16

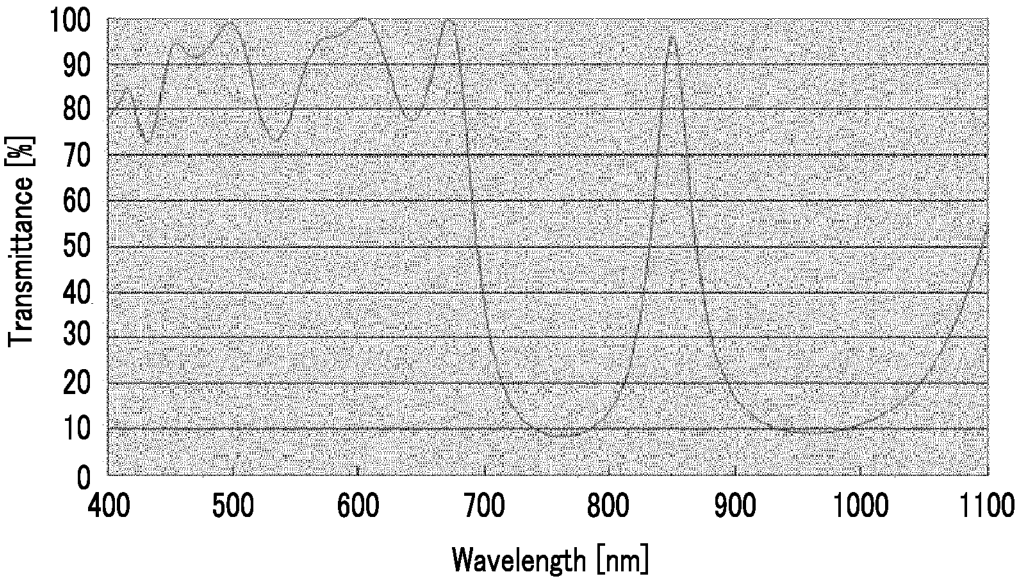
100
90
80
70
60
50
40
30
20
10
0
Transmittance [%]
400
500
600
700
800
900
1000
1100
Wavelength [nm]

FIG. 17

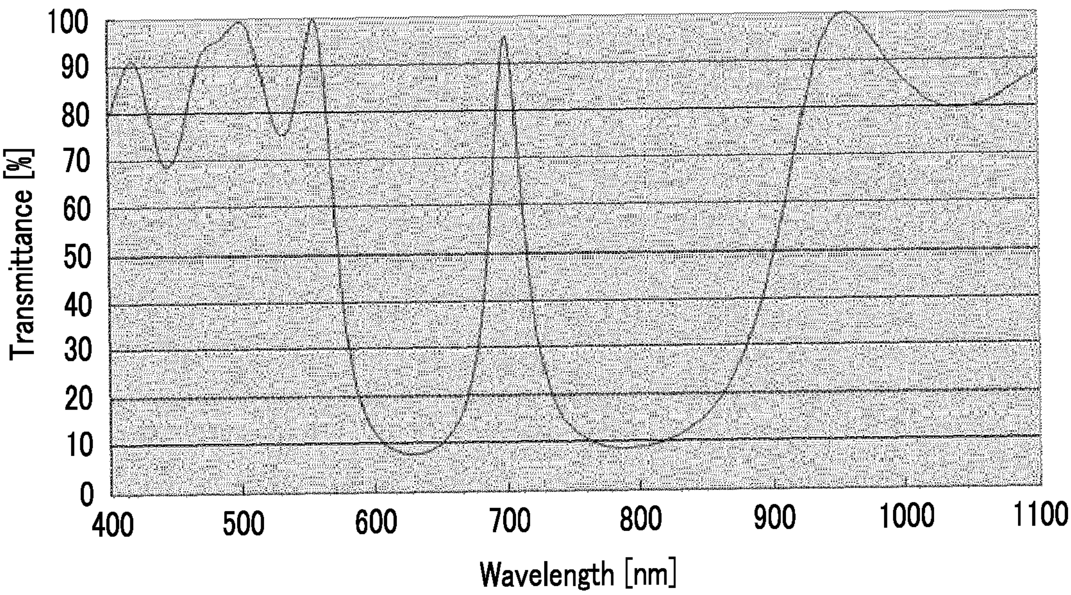

100
90
80
70
60
50
40
30
20
10
0
Transmittance [%]
400
500
600
700
800
900
1000
1100
Wavelength [nm]

**INTERNATIONAL SEARCH REPORT**

International application No. PCT/JP2015/065364

A. CLASSIFICATION OF SUBJECT MATTER
*B32B7/02*(2006.01)i, *B05D5/06*(2006.01)i, *B05D7/24*(2006.01)i, *G02B5/20*(2006.01)i, *G02B5/22*(2006.01)i, *G02B5/28*(2006.01)i, *H01L51/50*(2006.01)i, *H05B33/12*(2006.01)i

According to International Patent Classification (IPC) or to both national classification and IPC

B. FIELDS SEARCHED

Minimum documentation searched (classification system followed by classification symbols)
B32B1/00-43/00, B05D1/00-7/26, G02B5/20-5/28, H01L51/50, H05B33/00-33/28

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2014/069506 A1 (Konica Minolta, Inc.), 08 May 2014 (08.05.2014), claims; paragraphs [0002] to [0004], [0017], [0022], [0023], [0030] to [0032], [0049], [0062], [0094], [0098], [0099]; examples (Family: none) | 1-14,16-25<br>14,15,19-22, 26-29 |
| X<br><br>Y | JP 2012-027288 A (Konica Minolta Holdings, Inc.), 09 February 2012 (09.02.2012), claim 1; paragraphs [0001], [0020] to [0027], [0083]; examples (Family: none) | 1-13,16-18, 23-25<br>14,15,19-22, 26-29 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 21 August 2015 (21.08.15) | 01 September 2015 (01.09.15) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (July 2009)

**INTERNATIONAL SEARCH REPORT**

International application No.
PCT/JP2015/065364

C (Continuation). DOCUMENTS CONSIDERED TO BE RELEVANT

| Category* | Citation of document, with indication, where appropriate, of the relevant passages | Relevant to claim No. |
|---|---|---|
| X<br><br>Y<br><br>A | JP 2012-139948 A (Konica Minolta Holdings, Inc.),<br>26 July 2012 (26.07.2012),<br>claims; paragraphs [0005], [0008], [0083] to [0091], [0156]; examples<br>(Family: none) | 1,4-13, 16-18,23,25<br>14,15,19-22, 26-29<br>2,3,24 |
| Y | JP 2013-003293 A (Konica Minolta Holdings, Inc.),<br>07 January 2013 (07.01.2013),<br>paragraphs [0104], [0105], [0107], [0108]<br>(Family: none) | 15 |
| Y | JP 2013-007831 A (Hitachi Chemical Co., Ltd.),<br>10 January 2013 (10.01.2013),<br>claim 12<br>(Family: none) | 26,27 |
| Y | JP 02-039107 A (Toshiba Glass Co., Ltd.),<br>08 February 1990 (08.02.1990),<br>claims; page 2, upper left column<br>(Family: none) | 28,29 |
| P,X | WO 2014/104136 A1 (Fujifilm Corp.),<br>03 July 2014 (03.07.2014),<br>entire text<br>& TW 201431682 A | 1-18,20, 23-25,28,29 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2012225993 A
- JP 2008015234 A
- JP 2004354705 A
- JP 2007277514 A
- US 2010233595 A
- JP 2014063125 A
- JP 2010007057 A
- JP 2014062221 A
- JP 2011089090 A
- JP 7140654 A
- JP H07140654 A
- JP 2010222431 A
- JP 2009263507 A
- JP 2008202033 A
- JP 2012087316 A
- JP 2007246877 A
- WO 2010125949 A
- WO 2010128661 A
- WO 2011018990 A
- WO 2012026451 A
- WO 2012026452 A
- WO 2012060286 A
- WO 2012111682 A
- JP 2013253145 A
- JP 2012214772 A
- JP 4328935 B
- WO 2013099948 A
- US 2014285695 A
- WO 2013099945 A
- US 2014284747 A
- JP 2013064999 A
- JP 2012208494 A
- JP 2001233842 A
- JP 2000080068 A
- JP 2006342166 A
- JP 2010262028 A
- JP 2014500852 A
- JP 2013164471 A
- JP 2009203462 A
- JP 2010168539 A
- JP 2009263614 A
- JP 2013077009 A
- JP 2011233983 A

### Non-patent literature cited in the description

- Chemical Manual (II). Maruzen Co., Ltd, 1993
- *Polymer Engineering and Science,* 1974, vol. 4 (2